# EUROPÄISCHE PATENTSCHRIFT

(11) **EP 3 294 835 B1**
(45) Veröffentlichungstag und Bekanntmachung des Hinweises auf die Patenterteilung: **18.03.2020**
(21) Anmeldenummer: 16719207.9
(22) Anmeldetag: 19.04.2016
(51) Int. Cl.: H01L 51/00, C09K 11/06, C07F 9/94

(54) **METALLKOMPLEXE MIT BISMUT ALS METALLATOM SOWIE ELEKTROLUMINESZENZVORRICHTUNGEN ENTHALTEND DIESE METALLKOMPLEXE**
METAL COMPLEXES OF BISMUTH AND ELECTROLUMINESCENT DEVICES COMPRISING THESE METAL COMPLEXES
COMPLEXES MÉTALLIQUES DE BISMUTH, ET DISPOSITIFS ÉLECTROLUMINESCENTS CONTENANT CES COMPLEXES MÉTALLIQUES

(30) Priorität: 13.05.2015 EP 15001434
(43) Veröffentlichungstag der Anmeldung: 21.03.2018
(73) Patentinhaber: Merck Patent GmbH, 64293 Darmstadt (DE)
(72) Erfinder: STOESSEL, Philipp, 60389 Frankfurt am Main (DE); JOOSTEN, Dominik, 60487 Frankfurt am Main (DE); BURKHART, Beate, 64293 Darmstadt (DE); STEGMAIER, Katja, 64287 Darmstadt (DE)
(86) Internationale Anmeldenummer: PCT/EP2016/000633
(87) Internationale Veröffentlichungsnummer: WO 2016/180511

(56) Entgegenhaltungen:
- KR-A- 20130 076 375
- HE, Y. TAN, Y., ZHANG, J.: "Stable Mg-Metal-Organic Framework (MOF) and Unstable Zn-MOF Based on Nanosized Tris((4-carboxyl)phenylduryl)amine Ligand", CRYSTAL GROWTH AND DESIGN, Bd. 13, 3. Dezember 2012 (2012-12-03), Seiten 6-9, XP002759612,
- GISLASON, J., LLOYD, M.H., TUCK, D.G.: "Coordination Compounds of Indium X. Anionic Indium(III)Halide Complexes", INORGANIC CHEMISTRY, Bd. 10, Nr. 9, 31. Januar 1971 (1971-01-31), Seiten 1907-1910, XP002759613,
- M. D. Allendorf ET AL: "Luminescent metal-organic frameworks", Chemical Society Reviews, vol. 38, no. 5, 1 January 2009 (2009-01-01), page 1330, XP055577666, UK ISSN: 0306-0012, DOI: 10.1039/b802352m
- Yuanjing Cui ET AL: "Luminescent Functional Metal-Organic Frameworks", Chemical Reviews, vol. 112, no. 2, 8 February 2012 (2012-02-08), pages 1126-1162, XP055052696, ISSN: 0009-2665, DOI: 10.1021/cr200101d
- SATOH N ET AL: "Novel Triarylamine dendrimers as a Hole-transport Material with a Controlled Metal-Assembling Function", JOURNAL OF THE AMERICAN CHEMICAL SOCIETY, AMERICAN CHEMICAL SOCIETY, vol. 125, 17 June 2003 (2003-06-17), pages 8104-8105, XP002397899, ISSN: 0002-7863, DOI: 10.1021/JA034811P
- Qinglan Huang ET AL: "Covalently Bound Hole-Injecting Nanostructures. Systematics of Molecular Architecture, Thickness, Saturation, and Electron-Blocking Characteristics on Organic Light-Emitting Diode Luminance, Turn-on Voltage, and Quantum Efficiency", Journal of the American Chemical Society, vol. 127, no. 29, 1 July 2005 (2005-07-01) , pages 10227-10242, XP55090540, ISSN: 0002-7863, DOI: 10.1021/ja051077w
- PLINT TREVOR ET AL: "Assessing the potential of group 13 and 14 metal/metalloid phthalocyanines as hole transport layers in organic light emitting diodes", JOURNAL OF APPLIED PHYSICS, AMERICAN INSTITUTE OF PHYSICS, US, vol. 119, no. 14, 14 April 2016 (2016-04-14), XP012206799, ISSN: 0021-8979, DOI: 10.1063/1.4945377 [retrieved on 1901-01-01]

## Beschreibung

Die vorliegende Erfindung betrifft Metallkomplexe, Verfahren zu deren Herstellung sowie deren Verwendung in elektronischen bzw. optoelektronischen Vorrichtungen, insbesondere in organischen Elektrolumineszenz-vorrichtungen, sogenannten OLEDs (OLED = Organic Light Emitting Diodes). Darüber hinaus betrifft die vorliegende Erfindung auch organische Elektrolumineszenzvorrichtungen enthaltend diese Zusammensetzungen.

In elektronischen bzw. optoelektronischen Vorrichtungen, insbesondere in organischen Elektrolumineszenzvorrichtungen (OLED) werden Komponenten verschiedener Funktionalität benötigt. In OLEDs liegen die verschiedenen Funktionalitäten dabei normalerweise in verschiedenen Schichten vor. Man spricht in diesem Fall von mehrschichtigen OLED-Systemen. Diese mehrschichtigen OLED-Systeme weisen dabei unter anderem ladungsinjizierende Schichten, wie z.B. elektronen- und lochinjizierende Schichten, ladungstransportierende Schichten, wie z.B. elektronen- und lochleitende Schichten, sowie Schichten auf, die lichtemittierende Komponenten enthalten (siehe z.B. KR 20130076375). Diese mehrschichtigen OLED-Systeme werden in der Regel durch das aufeinanderfolgende schichtweise Aufbringen hergestellt.

Werden dabei mehrere Schichten aus Lösung aufgebracht, ist darauf zu achten, dass eine bereits aufgebrachte Schicht nach deren Trocknung nicht durch das nachfolgende Aufbringen der Lösung zur Herstellung der nächsten Schicht zerstört wird. Dies kann beispielsweise dadurch erreicht werden, dass eine Schicht unlöslich gemacht wird, beispielsweise durch Vernetzung. Solche Verfahren werden z.B. in der EP 0 637 899 und der WO 96/20253 offenbart.

Darüber hinaus ist es aber auch notwendig, die Funktionalitäten der einzelnen Schichten von der Materialseite her so aufeinander abzustimmen, dass möglichst gute Ergebnisse, z.B. hinsichtlich Lebensdauer, Effizienz, etc. erreicht werden. So haben insbesondere die Schichten, die direkt an eine emittierende Schicht angrenzen, insbesondere die lochtransportierende Schicht (HTL = Hole Transport Layer), einen signifikanten Einfluss auf die Eigenschaften der angrenzenden emittierenden Schicht.

Bekannte elektronische Vorrichtungen sowie die Verfahren zur Herstellung derselben weisen ein brauchbares Eigenschaftsprofil auf. Allerdings besteht die dauerhafte Notwendigkeit, die Eigenschaften dieser Vorrichtungen und der Verfahren zur Herstellung dieser Vorrichtungen zu verbessern.

Zu diesen Eigenschaften der Vorrichtungen gehört insbesondere die Energieeffizienz, mit der eine elektronische Vorrichtung die vorgegebene Aufgabe löst. Bei organischen Leuchtdioden sollte insbesondere die Lichtausbeute hoch sein, so dass zum Erreichen eines bestimmten Lichtflusses möglichst wenig elektrische Leistung aufgebracht werden muss. Weiterhin sollte auch zum Erzielen einer vorgegebenen Leuchtdichte eine möglichst geringe Spannung notwendig sein. Ein weiteres Problem stellt insbesondere die Lebensdauer der elektronischen Vorrichtungen dar.

Eine der Aufgaben der vorliegenden Erfindung lag deshalb in der Bereitstellung von Zusammensetzungen, die einerseits als Lösung verarbeitet werden können und die andererseits bei der Verwendung in elektronischen bzw. opto-elektronischen Vorrichtungen, vorzugsweise in OLEDs, und hier insbesondere in deren Lochinjektions- und/oder Lochtransportschicht, zu einer Verbesserung der Eigenschaften der Vorrichtung, d.h. insbesondere der OLED, führen. Ferner sollte die Zusammensetzungmöglichst einfach und kostengünstig verarbeitet werden können.

Überraschenderweise wurde gefunden, dass Metallkomplexe mit Bismut als Metallatom und mindestens einem Liganden, wobei der Ligand mindestens eine anionische Koordinierungsgruppe mit mindestens einem Sauerstoff- und/oder Stickstoffatom umfasst, über die das Metallatom koordiniert ist, und der Ligand mindestens eine Triarylamingruppe umfasst, insbesondere bei Verwendung zur Herstellung der lochinjizierenden und/oder lochtransportierenden Schicht von OLEDs zu einer deutlichen Absenkung der Spannung zum Erzielen einer vorgegebenen Leuchtdichte, eine Verringerung der zum Erreichen eines bestimmten Lichtflusses notwendigen elektrische Leistung und einer Erhöhung der Lebensdauer dieser OLEDs führen. Hierbei wurde überraschend festgestellt, dass die Komponenten der Metallkomplexe, d. h. die Liganden und die Metallatome in synergistischer Weise zusammenwirken, ohne dass andere Eigenschaften nachteilig beeinflusst werden. Besondere Vorteile können insbesondere dadurch erzielt werden, dass ein erfindungsgemäße Metallkomplex in einer Lochinjektionsschicht eingesetzt wird. Vorzugsweise können die erfindungsgemäßen Metallkomplexe besonders einfach und kostengünstig zu Schichten überführt werden, die nachfolgend mit weiteren Schichten versehen werden können, ohne dass besondere Maßnahmen getroffen werden müssten, die eine Veränderung der Metallkomplex-haltigen Schicht verhindern.

Gegenstand der vorliegenden Anmeldung ist somit ein Metallkomplex mit Bismut als Metallatom und mindestens einem Liganden, wobei der Ligand mindestens eine anionische Koordinierungsgruppe mit mindestens einem Sauerstoff- und/oder Stickstoffatom umfasst, über die das Metallatom koordiniert ist, und der Ligand mindestens eine Triarylamingruppe umfasst.

Der Begriff "Ligand" bezeichnet hierin eine niedermolekulare, oligomere oder polymere Verbindung, über welche ein oder mehrere Metallatome koordiniert werden. Erfindungsgemäß einsetzbare Liganden umfassen mindestens eine Triarylgruppe. Triarylamingruppen sind Gruppen, die mindestens ein Stickstoffatom aufweisen, welches mit mindestens drei aromatischen und/oder heteroaromatischen Ringsystemen verbunden ist, wobei das Stickstoffatom jeweils direkt mit einer aromatischen und/oder heteroaromatischen Gruppe verbunden ist.

Bevorzugte Triarylamingruppen umfassen mindestens ein Strukturelement der folgenden Formel (I): 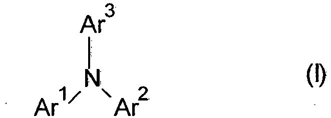 dabei ist Ar¹
, Ar² und Ar³ bei jedem Auftreten, jeweils gleich oder verschieden, ein mono- oder polycyclisches, aromatisches oder heteroaromatisches Ringsystem ist, das mit einem oder mehreren Resten R substituiert sein kann;
R bei jedem Auftreten gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)R¹, SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ist; wobei zwei oder mehrere Reste R auch miteinander ein mono- oder polycyclisches, aliphatisches, aromatisches und/oder benzoannelliertes Ringsystem bilden können;
R¹ bei jedem Auftreten gleich oder verschieden H, D, F oder ein aliphatischer, aromatischer und/oder heteroaromatischer Kohlenwasserstoffrest mit 1 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches oder aromatisches Ringsystem bilden können.

Hierbei kann das Strukturelement gemäß Formel (I) über die Reste Ar¹, Ar², Ar³ und/oder einem Substituenten dieser Reste, beispielsweise dem Rest R mit einer oder mehreren anionischen Koordinierungsgruppen verbunden sein.

Unter dem Begriff "mono- oder polycyclisches, aromatisches Ringsystem" wird in der vorliegenden Anmeldung ein aromatisches Ringsystem mit 6 bis 60, vorzugsweise 6 bis 30 und besonders bevorzugt 6 bis 24 aromatischen Ringatomen verstanden, das nicht notwendigerweise nur aromatische Gruppen enthält, sondern in dem auch mehrere aromatische Einheiten durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein können. So sollen beispielsweise auch Systeme wie z.B. 9,9'-Spirobifluoren, 9,9-Diarylfluoren und 9,9-Dialkylfluoren, als aromatische Ringsysteme verstanden werden. Die aromatischen Ringsysteme können mono- oder polycyclisch sein, d.h. sie können einen Ring (z.B. Phenyl) oder mehrere Ringe aufweisen, welche auch kondensiert (z.B. Naphthyl) oder kovalent verknüpft sein können (z.B. Biphenyl), oder eine Kombination von kondensierten und verknüpften Ringen enthalten.

Bevorzugte aromatische Ringsysteme sind z.B. Phenyl, Biphenyl, Terphenyl, [1,1':3',1"]Terphenyl-2'-yl, Quarterphenyl, Naphthyl, Anthracen, Binaphthyl, Phenanthren, Dihydrophenanthren, Pyren, Dihydropyren, Chrysen, Perylen, Tetracen, Pentacen, Benzpyren, Fluoren, Inden, Indenofluoren und Spirobifluoren.

Unter dem Begriff "mono- oder polycyclisches, heteroaromatisches Ringsystem" wird in der vorliegenden Anmeldung ein aromatisches Ringsystem mit 5 bis 60, vorzugsweise 5 bis 30 und besonders bevorzugt 5 bis 24 aromatischen Ringatomen verstanden, wobei ein oder mehrere dieser Atome ein Heteroatom ist/sind. Das "mono- oder polycyclische, heteroaromatische Ringsystem" enthält nicht notwendigerweise nur aromatische Gruppen, sondern kann auch durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein.

Die heteroaromatischen Ringsysteme können mono- oder polycyclisch sein, d.h. sie können einen Ring oder mehrere Ringe aufweisen, welche auch kondensiert oder kovalent verknüpft sein können (z.B. Pyridylphenyl), oder eine Kombination von kondensierten und verknüpften Ringen enthalten. Bevorzugt sind vollständig konjugierte Heteroarylgruppen.

Bevorzugte heteroaromatische Ringsysteme sind z.B. 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder Gruppen mit mehreren Ringen, wie Carbazol, Indenocarbazol, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen.

Das mono- oder polycyclische, aromatische oder heteroaromatische Ringsystem kann unsubstituiert oder substituiert sein. Substituiert heißt in der vorliegenden Anmeldung, dass das mono- oder polycyclische, aromatische oder heteroaromatische Ringsystem einen oder mehrere Substituenten R aufweist.

R ist bei jedem Auftreten vorzugsweise gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)R¹, SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

R ist bei jedem Auftreten besonders bevorzugt gleich oder verschieden H, D, F, Cl, Br, I, N(R¹)₂, Si(R¹)₃, B(OR¹)₂, C(=O)R¹, P(=O)(R¹)₂, eine geradkettige Alkyl- oder Alkoxygruppe mit 1 bis 20 C-Atomen oder eine Alkenyl- oder Alkinylgruppe mit 2 bis 20 C-Atomen oder eine verzweigte oder cyclische Alkyl- oder Alkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=NR¹, P(=O)R¹, NR¹, O oder CONR¹ ersetzt sein können und wobei ein oder mehrere H-Atome durch F, Cl, Br oder I ersetzt sein können, oder ein aromatisches oder heteroaromatisches Ringsystem mit 5 bis 30 aromatischen Ringatomen, das jeweils durch einen oder mehrere Reste R¹ substituiert sein kann, oder eine Aryloxy- oder Heteroaryloxygruppe mit 5 bis 30 aromatischen Ringatomen, die durch einen oder mehrere Reste R¹ substituiert sein kann, oder eine Aralkyl- oder Heteroaralkylgruppe mit 5 bis 30 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

R ist bei jedem Auftreten ganz besonders bevorzugt gleich oder verschieden H, eine geradkettige Alkyl- oder Alkoxygruppe mit 1 bis 10 C-Atomen oder eine Alkenyl- oder Alkinylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, wobei eine oder mehrere nicht benachbarte CH₂-Gruppen durch R¹C=CR¹, C≡C, C=O, C=NR¹, NR¹, O oder CONR¹ ersetzt sein können, oder ein aromatisches oder heteroaromatisches Ringsystem mit 5 bis 20 aromatischen Ringatomen, das jeweils durch einen oder mehrere Reste R¹ substituiert sein kann, oder eine Aryloxy- oder Heteroaryloxygruppe mit 5 bis 20 aromatischen Ringatomen, die durch einen oder mehrere Reste R¹ substituiert sein kann, oder eine Aralkyl- oder Heteroaralkylgruppe mit 5 bis 20 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

Bevorzugte Alkylgruppen mit 1 bis 10 C-Atomen sind in der folgenden Tabelle abgebildet:

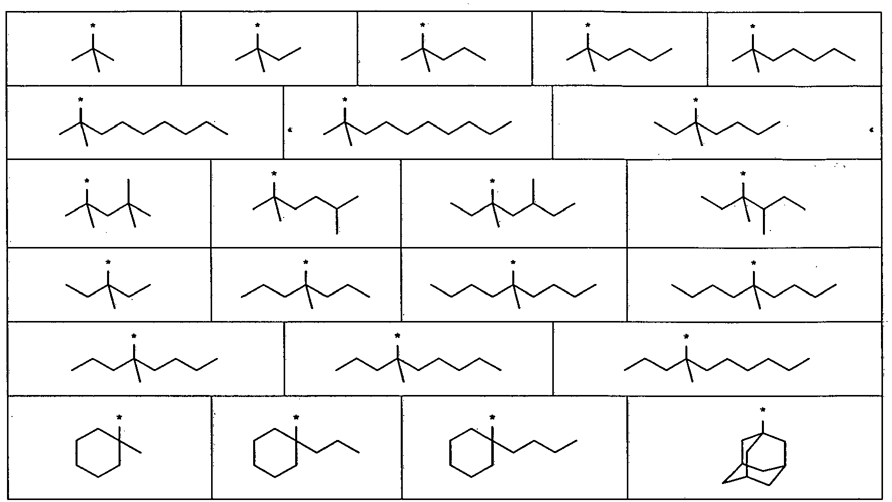

R¹ ist bei jedem Auftreten vorzugsweise gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen, in dem auch ein oder mehrere H-Atome durch F ersetzt sein können; dabei können zwei oder mehrere Substituenten R¹ auch miteinander ein mono- oder polycyclisches, aliphatisches oder aromatisches Ringsystem bilden.

R¹ ist bei jedem Auftreten besonders bevorzugt gleich oder verschieden H, D oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen; dabei können zwei oder mehrere Substituenten R¹ auch miteinander ein mono- oder polycyclisches, aliphatisches oder aromatisches Ringsystem bilden.

R¹ ist bei jedem Auftreten ganz besonders bevorzugt gleich oder verschieden H oder ein aliphatischer Kohlenwasserstoffrest mit 1 bis 10 C-Atomen, ein aromatischer und/oder ein heteroaromatischer Kohlenwasserstoffrest mit 5 bis 10 C-Atomen.

Der Ligand umfasst mindestens eine anionische Koordinierungsgruppe mit mindestens einem Sauerstoff- und/oder Stickstoffatom, über die mindestens ein Metallatom koordiniert wird, so dass mindestens einer der Reste Ar¹, Ar² und Ar³ kovalent mit mindestens einer anionischen Koordinierungsgruppe verbunden ist.

Der Begriff Koordinierungsgruppe bezeichnet die Atome, die an der Koordinierung des Metallatoms beteiligt sind. Diese Atome treten daher in Wechselwirkung mit dem Metallatom oder sind durch Delokalisation der anionischen Ladung, die der Koordinierungsgruppe zumindest formal zugeordnet werden kann, an dieser Wechselwirkung beteiligt. Hierbei weist die anionische Koordinierungsgruppe vorzugsweise genau eine Ladung auf, die über die Koordinierungsgruppe delokalisiert sein kann, so dass die Koordinierungsgruppe bevorzugt monoanionisch ist.

Vorzugsweise kann vorgesehen sein, dass der Ligand mindestens zwei räumlich entfernte anionische Koordinierungsgruppen umfasst, über die zwei Metallatome komplexiert werden können. Räumlich entfernt bedeutet vorzugsweise, dass die anionischen Koordinierungsgruppen über mindestens 4, vorzugsweise mindestens 6 und besonders bevorzugt mindestens 10 Bindungen getrennt sind. Durch diese Ausgestaltung kann eine Vernetzung der Liganden über Koordination von Metallatomen erzielt werden. Diese Vernetzung bewirkt, dass sich Vorrichtungen, die diese Metallkomplexe umfassen, besonders einfach und kostengünstig herstellen lassen. Durch eine ausreichende Vernetzung kann die ein unlöslicher Metallkomplex erhalten werden. "Unlöslich" im Sinne der vorliegenden Erfindung bedeutet vorzugsweise, dass der erfindungsgemäße Metallkomplex nach der Vernetzungsreaktion, also nach der Reaktion des Liganden mit dem Metallatom, bei Raumtemperatur in einem organischen Lösungsmittel eine Löslichkeit aufweist, die mindestens einen Faktor 3, vorzugsweise mindestens einen Faktor 10, geringer ist als die des entsprechenden, nicht-vernetzten, erfindungsgemäßen Liganden in demselben organischen Lösungsmittel.

Ferner kann vorgesehen sein, dass der Ligand mindestens eine anionische Koordinierungsgruppe umfasst, über die eine mindestens zweizähnige Koordinierung des Metallatoms möglich ist, wobei die Koordinierung über mindestens ein Sauerstoff- und/oder ein Stickstoffatom erfolgen kann.

Vorzugsweise kann mindestens eine anionische Koordinierungsgruppe des Liganden eine Struktur gemäß Formel (K-I) umfassen: 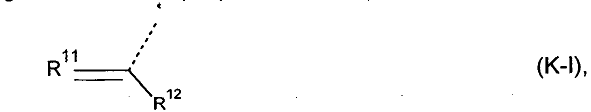 worin R¹¹ und R¹² unabhängig voneinander Sauerstoff, Schwefel, Selen, NH oder NR¹³ sein können, wobei R¹³ ausgewählt ist aus der Gruppe enthaltend Alkyl oder Aryl und mit anderen Gruppen des Liganden verbunden sein kann und die gestrichelte Linie die Bindung der Koordinierungsgruppe an den Liganden darstellt. Die anionische Ladung ist in der Formel (I) nicht dargelegt, da diese teilweise delokalisiert sein kann. Bevorzugte anionische Koordinierungsgruppen sind Carboxylatgruppen (-CO₂⁻), Thiocarboxylatgruppen (-CSO⁻), Amidatgruppen (-CNR¹³O⁻), (-CNHO⁻), und Thioamidatgruppen (-CNR¹³S⁻), (-CNHS⁻). Hiervon Carboxylatgruppen (-CO₂⁻) und Thiocarboxylatgruppen (-CSO⁻) bevorzugt und Carboxylatgruppen (-CO₂⁻) besonders bevorzugt.

Bevorzugt ist mindestens eine anionische Koordinierungsgruppe mit einer Verbindungsgruppe an die Triarylgruppe des Liganden gebunden, so dass die mit einer Verbindungsgruppe versehene anionische Koordinierungsgruppe durch eine Struktur gemäß Formel (K-II) darstellbar ist: 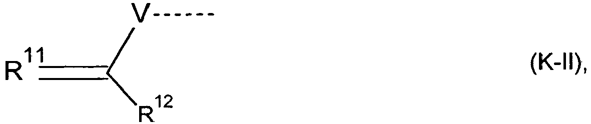 worin R¹¹ und R¹² unabhängig voneinander Sauerstoff, Schwefel, Selen, NH oder NR¹³ sein können, wobei R¹³ ausgewählt ist aus der Gruppe enthaltend Alkyl oder Aryl und mit anderen Gruppen des Liganden verbunden sein kann, V eine Bindung oder eine verbindende Gruppe ist, ausgewählt aus einem aromatischen oder heteroaromatischen Ringsystem mit 5 bis 40 aromatischen Ringatomen, das jeweils durch einen oder mehrere Reste R substituiert sein kann, einer Alkylengruppe mit 1 bis 40 C-Atomen, die jeweils mit einem oder mehreren Resten R substituiert sein kann, wobei eine oder mehrere nicht benachbarte CH₂-Gruppen durch RC=CR, C≡C, Si(R)₂, C=O, C=S, C=NR, P(=O)R, SO, SO₂, NR, O, S oder CONR ersetzt sein können und wobei ein oder mehrere H-Atome durch D, F, Cl, Br, I oder CN ersetzt sein können, wobei der Rest R die für Formel (I) zuvor genannte Bedeutung aufweist, und die gestrichelte Linie die Bindung der Koordinierungsgruppe an die Triarylamingruppe darstellt.

Der Rest V in Formel (K-II) kann bevorzugt eine geradkettige Alkylen-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen darstellen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, C=S, C=NR¹, P(=O)R¹, SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ist; wobei der Rest V auch mit einem oder beiden der Reste R¹² und R¹² ein Ringsystem bilden kann, wobei R¹ die zuvor dargelegte Bedeutung annehmen kann.

Vorzugsweise kann vorgesehen sein, dass der Rest V in Formel (K-II) ausgewählt ist aus der Gruppe enthaltend Alkylen, langkettiges Alkylen, Alkoxy, langkettiges Alkoxy, Cycloalkylen, Halogenalkylen, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, die vorzugsweise 1 bis 40, besonders bevorzugt 1 bis 20 Kohlenstoffatome aufweisen, wobei bei geeigneten Resten eine oder mehrere nicht-benachbarte CH₂-Gruppen unabhängig voneinander durch -O-, -S-, -NH-, -NR-, -SiR₂-, -CO-, -COO-,-OCO-, -OCO-O-, -SO₂-, -S-CO-, -CO-S-, -CR=CR- oder -C≡C- ersetzt sein können und zwar derart, dass O und/oder S Atome nicht direkt miteinander verbunden sind, ebenfalls optional mit Aryl- oder Heteroaryl bevorzugt enthaltend 1 bis 30 C Atome ersetzt sind (endständige CH₃-Gruppen werden wie CH₂-Gruppen im Sinne von CH₂-H verstanden), wobei R die zuvor, insbesondere für Formel (I) dargelegte Bedeutung annehmen kann.

Langkettige Alkylgruppen weisen insbesondere im Hinblick zur Beschreibung der Reste R¹¹, R¹², R¹³ und V gemäß Formeln (K-I) und (K-II) vorzugsweise 5 bis 20 Kohlenstoffatome auf. Alkylgruppen, die nicht mit dem Attribut "langkettig" versehen sind, können insbesondere im Hinblick zur Beschreibung der Reste R¹¹, R¹², R¹³ und V gemäß Formeln (K-I) und (K-II) vorzugsweise 1 bis 10, besonders bevorzugt 1 bis 4 Kohlenstoffatome aufweisen. Die Beschreibung und Definition insbesondere der im Rahmen der Formeln (K-I) und (K-II) dargelegten bevorzugten Gruppen findet sich unter anderem in WO 2013/182389 A2 eingereicht am 14.05.2013 beim Europäischen Patentamt mit der Anmeldenummer PCT/EP2013/059911.

Bevorzugt kann der Rest V in Formel (K-II) eine Bindung oder eine verbindende Gruppe darstellen, ausgewählt aus einer Arylengruppe mit 6 bis 24 C-Atomen oder einer Heteroarylengruppe mit 3 bis 24 C-Atomen, welche jeweils durch einen oder mehrere Reste R¹ substituiert sein kann, einer Alkylengruppe mit 1, 2, 3, 4, 5, 6, 7, 8, 9, 10, 11 oder 12 C-Atomen, welche mit einem oder mehreren Resten R¹ substituiert sein kann, wobei der Rest R¹ die für Formel (I) genannte Bedeutung aufweisen kann.

In einer weiteren Ausgestaltung der vorliegenden Erfindung kann ein Metallkomplex eingesetzt werden, in welchem der in Formel (K-II) dargelegte Rest V mindestens einen Substituenten aufweist, der ausgewählt ist aus Halogen, Pseudohalogen, -CN, -NO₂.

Vorteilhaft kann ein Metallkomplex eingesetzt werden, in welchem der in Formel (K-II) dargelegte Rest V einer der Formeln einer der Formeln (V-I), (V-II) oder (V-III) entspricht

| | |
|---|---|
| 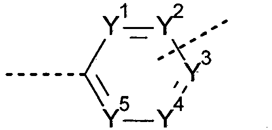 | (V-I) |
| 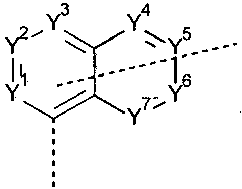 | (V-II) |
| 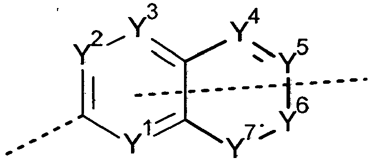 | (V-III) |

worin die Gruppen Y¹ bis Y⁷ jeweils unabhängig voneinander ausgewählt sind aus der Gruppe enthaltend C-H, C-R², C-F, C-CF₃, C-NO₂, C-CN, C-Halogen, C-Pseudohalogen oder N, wobei die Gruppe aus gewählt Y¹ bis Y⁷ die an die Triarylamingruppe bindet für C steht, und eine gestrichelte Linie die Bindung zum C-Atom darstellt, an welchen die Reste R¹¹ und/oder R¹² binden, der Rest R² für eine Alkylgruppe mit 1 bis 20, vorzugsweise 1 bis 10 Kohlenstoffatome, in der auch ein oder mehrere H-Atome durch F ersetzt sein können, oder ein aromatisches oder heteroaromatisches Ringsystem mit 5 bis 40 Kohlenstoffatomen, vorzugsweise 5 bis 30 und besonders bevorzugt 5 bis 24, das durch die zuvor dargelegten Reste R substitiert sein kann, steht und eine gestrichelte Linie die Bindung an die Triarylamingruppe darstellt. Vorzugsweise kann vorgesehen sein, dass mindestens eine, besonders bevorzugt mindestens zwei der Gruppen Y¹ bis Y⁷ jeweils unabhängig voneinander ausgewählt sind aus der Gruppe enthaltend C-F, C-CF₃, C-NO₂, C-CN, C- Halogen, C-Pseudohalogen oder N. Vorzugsweise steht das Symbol R² für einen Arylrest, so dass eine aromatische Gruppe eines aromatischen Ringsystems an das C-Atom der Gruppe C-R² gebunden ist.

Gemäß einer bevorzugten Ausführungsform ist der in Formel (K-II) dargelegte Rest V ausgewählt aus der Gruppe enthaltend halogenierte, bevorzugt perhalogenierte und/oder pseudohalogenierte Pteridine, Isopteridine, Naphtyridine, Chinoxaline, Azachinoxaline.

Ferner kann vorgesehen sein, dass der in Formel (K-II) dargelegte Rest V eine oder mehrere der folgenden Strukturen aufweist oder aus diesen besteht:

| | | |
|---|---|---|
| 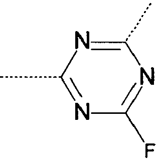 | 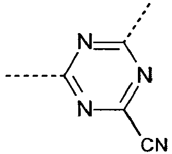 | 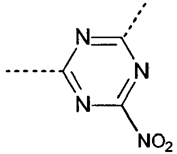 |
| (V-Ia) | (V-Ib) | (V-Ic) |
| 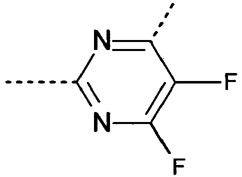 | 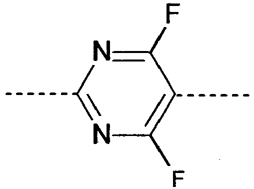 | 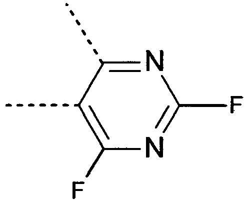 |
| (V-Id) | (V-Ie) | (V-If) |
| 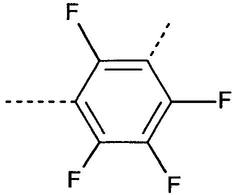 | 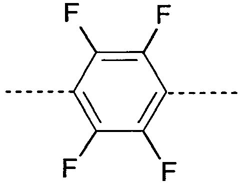 | 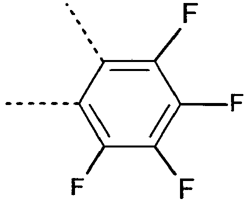 |
| (V-Ig) | (V-Ih) | (V-Ii) |
| 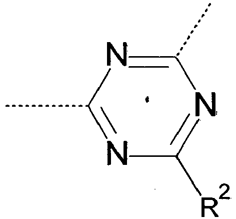 | 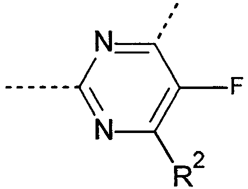 | |
| (V-Ij) | (V-Ik) | |

, wobei die gestrichelte Linie die Anbindungsstelle darstellt und R² die zuvor dargelegte Bedeutung aufweist.

Vorzugsweise kann vorgesehen sein, dass der Rest V gemäß Formel (K-II) mit Fluor substituiert ist, wobei vorzugsweise mindestens 10 % der H-Atome, besonderes bevorzugt mindestens 50 % der H-Atome durch Fluor ersetzt sind und besonders bevorzugt V eine perfluorierte Gruppe darstellt.

Gemäß einer bevorzugten Ausführungsform ist der Rest V gemäß Formel (K-II) Halogenalkenyl, besonders bevorzugt Perfluoralkenyl mit 1 bis 8 Kohlenstoffen, noch bevorzugt 1 bis 4, Halogenaryl, besonders bevorzugt Perfluoraryl, Halogenalkylaryl, besonders bevorzugt (Per)fluoralkylaryl und Halogenheteroaryl, besonders bevorzugt Perfluorheteroaryl, wobei diese Gruppen vorzugsweise 6 bis 20 Kohlenstoffatome aufweisen können.

Gemäß einer Ausführungsform kann der Ligand des Metallkomplexes eine niedermolekulare Verbindung darstellen, wobei der Ligand vorzugsweise ein Molekulargewicht von kleiner oder gleich 10000 g/mol, bevorzugt kleiner oder gleich 5000 g/mol, besonders bevorzugt kleiner oder gleich 4000 g/mol, insbesondere bevorzugt kleiner oder gleich 3000 g/mol, speziell bevorzugt kleiner oder gleich 2000 g/mol und ganz besonders bevorzugt kleiner oder gleich 1000 g/mol aufweisen kann.

Der Ligand kann eine Verbindung darstellen, umfassend Strukturen der folgenden Formel (L-I): 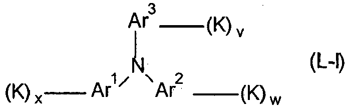 , wobei
Ar¹, Ar² und Ar³ bei jedem Auftreten, jeweils gleich oder verschieden, die zuvor, insbesondere für Formel (I) dargelegte Bedeutung aufweist, K eine anionische Koordinierungsgruppe darstellt, vorzugsweise eine Gruppe gemäß Formel (K-I) und/oder (K-II),
v = 0, 1, 2, 3, 4, 5, 6 oder 7, bevorzugt 0, 1, 2, 3 oder 4, besonders bevorzugt 0, 1 oder 2;
w = 0, 1, 2, 3, 4, 5, 6 oder 7, bevorzugt 0, 1, 2, 3 oder 4, besonders bevorzugt 0, 1 oder 2; und
x = 0, 1, 2, 3, 4, 5, 6 oder 7, bevorzugt 0, 1, 2, 3 oder 4, besonders bevorzugt 0, 1 oder 2 ist,
wobei die Summe von v, w und x größer oder gleich 1, vorzugsweise größer oder gleich 2 ist. Die Summe von v, w und x kann vorzugsweise im Bereich von 1 bis 10, bevorzugt 2 bis 7 und besonders bevorzugt 3 bis 5 liegen.

Vorzugsweise kann der Ligand durch eine Struktur der Formel (I) und/oder (L-I) dargestellt werden.

Ferner kann vorgesehen sein, dass der Ligand ein Polymer darstellt. Vorzugsweise kann der Ligand ein Polymer sein, umfassend mindestens eine Struktureinheit der folgenden Formel (P-I): 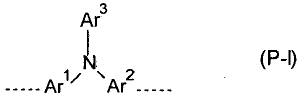 , wobei
Ar¹, Ar² und Ar³ bei jedem Auftreten, jeweils gleich oder verschieden, die zuvor, insbesondere für Formel (I) dargelegte Bedeutung aufweist und die gestrichelten Linien Bindungen zu benachbarten Struktureinheiten im Polymer darstellen, wobei die Gruppen Ar¹, Ar² und Ar³ in der Struktureinheit (P-I) mit mindestens einer anionischen Koordinierungsgruppe, vorzugsweise einer Gruppe gemäß Formel (K-I) und/oder (K-II), substituiert sein können.

Hierbei können alle Struktureinheiten gemäß Formel (P-I) oder lediglich ein Teil der Struktureinheiten gemäß Formel (P-I) mit mindestens einer anionischen Koordinierungsgruppe, vorzugsweise einer Gruppe gemäß Formel (K-I) und/oder (K-II), substituiert sein. Vorzugsweise umfasst ein polymerer Ligand gemäß Formel (P-I) Struktureinheiten, bei denen die Gruppen Ar¹, Ar² und Ar³ nicht mit einer anionischen Koordinierungsgruppe substituiert sind, so dass diese Struktureinheiten keine anionische Koordinierungsgruppe umfassen.

Vorzugsweise kann ein polymerer Ligand mindestens eine Struktureinheit der folgenden Formel (L-P-I) umfassen: 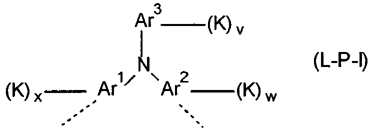 , wobei
Ar¹, Ar² und Ar³ bei jedem Auftreten, jeweils gleich oder verschieden, die zuvor, insbesondere für Formel (I) dargelegte Bedeutung aufweist jeweils gleich oder verschieden, die zuvor für Formel (I) dargelegte Bedeutung aufweist, K eine anionische Koordinierungsgruppe darstellt, vorzugsweise eine Gruppe gemäß Formel (K-I) und/oder (K-II),
v = 0, 1, 2, 3, 4, 5, 6 oder 7,
w = 0, 1, 2, 3, 4, 5, 6 oder 7, und
x = 0, 1, 2, 3, 4, 5, 6 oder 7 ist,
wobei die Summe von v, w und x größer oder gleich 1, vorzugsweise größer oder gleich 2 ist und
die gestrichelten Linien Bindungen zu benachbarten Struktureinheiten im Polymer darstellen.

In der vorliegenden Anmeldung sind unter dem Begriff Polymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 10 bis 5000 und ganz besonders bevorzugt 10 bis 2000 Struktureinheiten (d.h. Wiederholungseinheiten) auf. Die erfindungsgemäßen oligomeren Verbindungen weisen vorzugsweise 3 bis 9 Struktureinheiten auf. Der Verzweigungs-Faktor der Polymere liegt dabei zwischen 0 (lineares Polymer, ohne Verzweigungsstellen) und 1 (vollständig verzweigtes Dendrimer).

Die erfindungsgemäß einsetzbaren Polymere weisen vorzugsweise ein Molekulargewicht M_{w} im Bereich von 1.000 bis 2.000.000 g/mol, besonders bevorzugt ein Molekulargewicht M_{w} im Bereich von 10.000 bis 1.500.000 g/mol und ganz besonders bevorzugt ein Molekulargewicht M_{w} im Bereich von 50.000 bis 1.000.000 g/mol auf. Die Bestimmung des Molekulargewichts M_{w} erfolgt mittels GPC (= Gelpermeationschromatographie) gegen einen internen Polystyrolstandard. M_{w} stellt das Gewichtsmittel des Molekulargewichts dar.

Bei den erfindungsgemäßen Polymeren handelt es sich entweder um konjugierte, teilkonjugierte oder nicht-konjugierte Polymere. Bevorzugt sind konjugierte oder teilkonjugierte Polymere.

Die Struktureinheiten der Formel (P-I) können erfindungsgemäß in die Haupt- oder in die Seitenkette des Polymeren eingebaut werden. Vorzugsweise werden die Struktureinheiten der Formel (P-I) jedoch in die Hauptkette des Polymers eingebaut. Bei Einbau in die Seitenkette des Polymeren können die Struktureinheiten der Formel (P-I) entweder mono- oder bivalent sein, d.h. sie weisen entweder eine oder zwei Bindungen zu benachbarten Struktureinheiten im Polymer auf.

"Konjugierte Polymere" im Sinne der vorliegenden Anmeldung sind Polymere, die in der Hauptkette hauptsächlich sp²-hybridisierte (bzw. gegebenenfalls auch sp-hybridisierte) Kohlenstoffatome enthalten, die auch durch entsprechend hybridisierte Heteroatome ersetzt sein können. Dies bedeutet im einfachsten Fall abwechselndes Vorliegen von Doppel- und Einfachbindungen in der Hauptkette, aber auch Polymere mit Einheiten wie beispielsweise einem meta-verknüpften Phenylen sollen im Sinne dieser Anmeldung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Als konjugierte Polymere gelten ebenfalls Polymere mit einer konjugierten Hauptkette und nicht-konjugierten Seitenketten. Des Weiteren wird in der vorliegenden Anmeldung ebenfalls als konjugiert bezeichnet, wenn sich in der Hauptkette beispielsweise Arylamineinheiten, Arylphosphineinheiten, bestimmte Heterocyclen (d.h. Konjugation über N-, O- oder S-Atome) und/oder metallorganische Komplexe (d.h. Konjugation über das Metallatom) befinden. Analoges gilt für konjugierte Dendrimere. Hingegen werden Einheiten wie beispielsweise einfache Alkylbrücken, (Thio)Ether-, Ester-, Amid- oder Imidverknüpfungen eindeutig als nicht-konjugierte Segmente definiert.

Unter einem teilkonjugierten Polymer soll in der vorliegenden Anmeldung ein Polymer verstanden werden, das konjugierte Regionen enthält, die durch nicht-konjugierte Abschnitte, gezielte Konjugationsunterbrecher (z.B. Abstandsgruppen) oder Verzweigungen voneinander getrennt sind, z.B. in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält. Konjugierte und teilkonjugierte Polymere können auch konjugierte, teilkonjugierte oder nicht-konjugierte Dendrimere enthalten.

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

Unter dem Begriff "Struktureinheit" wird in der vorliegenden Anmeldung eine Einheit verstanden, die, ausgehend von einer Monomereinheit, die mindestens zwei, vorzugsweise zwei, reaktive Gruppen aufweist, durch Reaktion unter Verbindungsknüpfung als ein Teil des Polymergrundgerüstes in dieses eingebaut wird, und damit verknüpft im hergestellten Polymer als Wiederholungseinheit vorliegt.

Vorzugsweise kann mindestens einer der Reste Ar¹, Ar² und Ar³ in Formel (I), Formel (L-I), Formel (P-I) und/oder Formel (L-P-I) mindestens einen Substituenten R mit mindestens 2 Kohlenstoffatomen umfassen, vorzugsweise mindestens 4 und besonders bevorzugt mindestens 6 Kohlenstoffatomen. Mit besonderem Vorteil weist dieser Substituent mit 2 Kohlenstoffatomen eine C-C-Doppelbindung zwischen diesen 2 Kohlenstoffatomen aus oder dieser Substituent mit 2 Kohlenstoffatomen ist Teil eines mono- oder polycyclisches, aromatisches oder heteroaromatisches Ringsystems mit 5 bis 60 aromatischen Ringatomen.

Gemäß einer ersten bevorzugten Ausgestaltung kann vorgesehen sein, dass der Rest Ar³ gemäß Formel (I), (L-I), (P-I) und/oder (L-P-I) in mindestens einer, vorzugsweise in genau einer der beiden ortho-Positionen, bezogen auf die Position des in Formel (I), (L-I), (P-I) und/oder (L-P-I) dargestellten Stickstoffatoms, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die zuvor, insbesondere für Formel (I) dargelegte Bedeutung annehmen kann, wobei der Rest Ar⁴ mit einer oder mehreren anionischen Koordinierungsgruppe, vorzugsweise einer Gruppe gemäß Formel (K-I) und/oder (K-II), substituiert sein kann.

Ar⁴ kann dabei entweder direkt, das heißt über eine Einfachbindung, mit Ar³ verknüpft sein oder aber über eine Verknüpfungsgruppe X. Vorzugsweise kann eine aromatische Gruppe des Rests Ar⁴ direkt mit einer aromatischen Gruppe des Rests Ar³ verbunden sein.

Die Triarylamingruppe der Formel (I) kann mindestens ein Strukturelement umfassen, das ausgewählt ist aus einem Strukturelement der folgenden Formel (la) oder das Polymer kann mindestens eine Struktureinheit der Formel (P-I) umfassen, die ausgewählt ist aus einer Struktureinheit der folgenden Formel (P-Ia), vorzugsweise ausgewählt ist aus einer Struktureinheit der folgenden Formel (L-P-Ia): 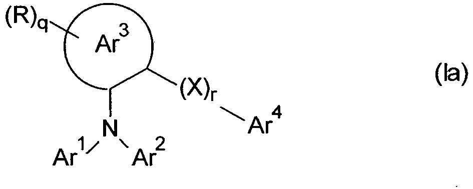 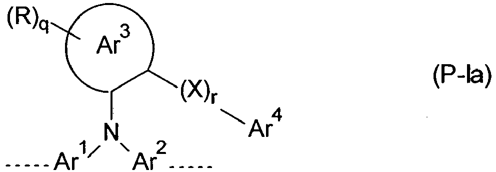 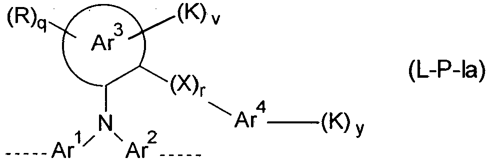
wobei Ar¹, Ar², Ar³ und R die zuvor, insbesondere für Formel (I) angegebenen Bedeutungen annehmen können, Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die zuvor, insbesondere für Formel (I) dargelegte Bedeutung annehmen kann, K eine anionische Koordinierungsgruppe darstellt, vorzugsweise eine Gruppe gemäß Formel (K-I) und/oder (K-II), die gestrichelten Linien Bindungen zu benachbarten Struktureinheiten im Polymer darstellen,
q = 0, 1, 2, 3, 4, 5 oder 6, vorzugsweise 0, 1, 2, 3 oder 4, ist,
X = CR₂, NR, SiR₂, NR, CK₂, NK, SiK₂, CRK, SiRK, O, S, C=O oder (P=O)R, vorzugsweise CR₂, SiR₂, NR, CK₂, NK, SiK₂, CRK, SiRK, O oder S ist, wobei R die zuvor, insbesondere für Formel (I) dargelegte Bedeutung annehmen kann und K eine anionische Koordinierungsgruppe darstellt, vorzugsweise eine Gruppe gemäß Formel (K-I) und/oder (K-II), und
r = 0 oder 1, vorzugsweise 0 ist,
v = 0, 1, 2, oder 3, vorzugsweise 0, 1 oder 2, besonders bevorzugt 0 oder 1 ist,
y = 0, 1, 2, oder 3, vorzugsweise 0, 1 oder 2, besonders bevorzugt 0 oder 1 ist,
wobei die Summe von v und y größer oder gleich 1 ist.

Vorzugsweise kann vorgesehen sein, dass Ar³ gemäß Formel (I), (L-I), (P-I) und/oder (L-P-I) in einer der beiden ortho-Positionen mit Ar⁴ substituiert ist, und Ar³ mit Ar⁴ zusätzlich noch in der zur substituierten ortho-Position benachbarten meta-Position verknüpft ist.

Die Triarylamingruppe der Formel (I) kann mindestens ein Strukturelement umfassen, das ausgewählt ist aus einem Strukturelement der folgenden Formel (Ib) oder das Polymer kann mindestens eine Struktureinheit der Formel (P-I) umfassen, die ausgewählt ist aus einer Struktureinheit der folgenden Formel (P-Ib), vorzugsweise ausgewählt ist aus einer Struktureinheit der folgenden Formel (L-P-Ib): 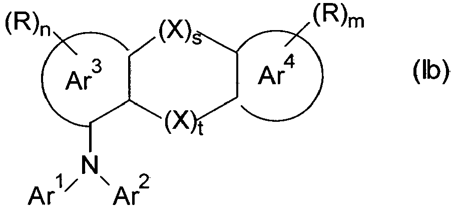 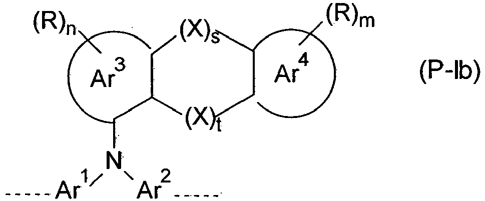 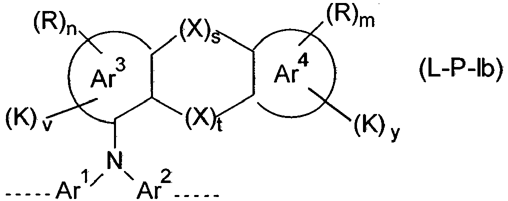
wobei Ar¹, Ar², Ar³, Ar⁴, R, und X die zuvor, insbesondere für die Formeln (I) und (Ia) angegebenen Bedeutungen annehmen können, K eine anionische Koordinierungsgruppe darstellt, vorzugsweise eine Gruppe gemäß Formel (K-I) und/oder (K-II), die gestrichelten Linien Bindungen zu benachbarten Struktureinheiten im Polymer darstellen;
m = 0, 1, 2, 3 oder 4, vorzugsweise 0, 1 oder 2, besonders bevorzugt 0 oder 1 ist;
n = 0, 1, 2 oder 3, vorzugsweise 0, 1 oder 2, besonders bevorzugt 0 oder 1 ist;
s und t jeweils 0 oder 1 sind, wobei die Summe (s + t) = 1 oder 2 ist;
v = 0, 1, 2, oder 3, vorzugsweise 0, 1 oder 2, besonders bevorzugt 0 ist,
y = 0, 1, 2, oder 3, vorzugsweise 0, 1 oder 2, besonders bevorzugt 1 ist, wobei die Summe von v und y größer oder gleich 1 ist.

Ferner kann vorgesehen sein, dass die Summe der Ringatome des Rests Ar⁴ zusammen mit den Ringatomen der an diesen Rest gebundenen Gruppe Ar³ gemäß Formeln (Ia), (P-Ia), (Ib) und/oder (P-Ib) mindestens 12 beträgt. Vorzugsweise bildet der Rest Ar⁴ zusammen mit den Ringatomen der an diesen Rest gebundenen Gruppe Ar³ gemäß Formeln (la), (P-Ia), (Ib) und/oder (P-Ib) kein kondensiertes Ringsystem.

Weiterhin sind als Rest Ar⁴ Gruppen bevorzugt, die einen geringen Kondensationsgrad aufweisen, so dass monocyclische, aromatische oder heteroaromatische Ringsysteme bevorzugt sind oder polycyclische, aromatische oder heteroaromatische Ringsysteme, deren aromatische oder heteroaromatische Ringe über Gruppen verbunden sind, die eine Konjugation der Ringe minimieren oder aufheben.

In einer bevorzugten Ausführungsform ist das mindestens eine Strukturelement der Formel (I) ausgewählt aus den Strukturelementen der folgenden Formeln (II), (III) und (IV) oder die mindestens eine Struktureinheit der Formel (P-I) ausgewählt aus den Struktureinheiten der folgenden Formeln ((P-II), (P-III) und (P-IV): 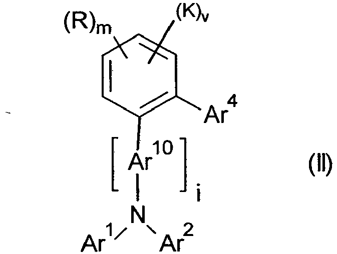 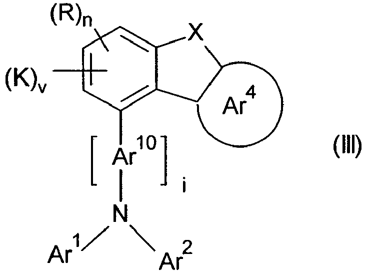 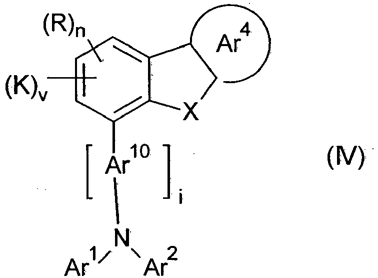 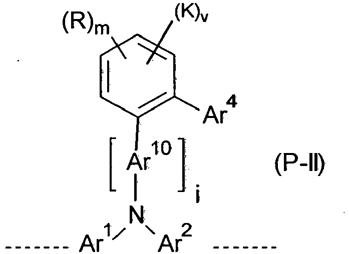 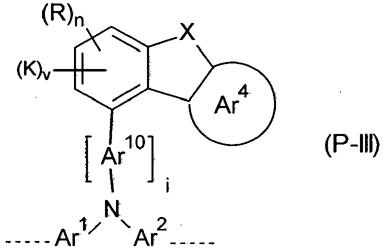 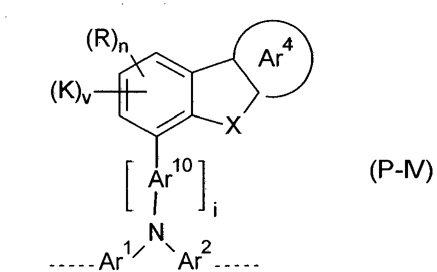 wobei Ar¹, Ar², Ar⁴, R, K, v, m, n und X die zuvor, insbesondere für die Formeln (I), (Ia) und (Ib) angegebenen Bedeutungen annehmen können, Ar¹⁰ ein mono- oder polycyclisches, aromatisches oder heteroaromatisches Ringsystem mit 5 bis 60, vorzugsweise 5 bis 30 und besonders bevorzugt 5 bis 24 aromatischen Ringatomen ist, das mit einem oder mehreren Resten R substituiert sein kann, wobei R die zuvor, insbesondere für Formel (I) dargelegte Bedeutung annehmen kann, der Index i 0, 1 oder 2, vorzugsweise 0 oder 1 und speziell bevorzugt 0 ist und die gestrichelten Linien Bindungen zu benachbarten Struktureinheiten im Polymer darstellen, wobei die Gruppen Ar¹, Ar², Ar⁴ und R mit mindestens einer anionischen Koordinierungsgruppe, vorzugsweise einer Gruppe gemäß Formel (K-I) und/oder (K-II), substituiert sein können. Vorzugsweise steht das Symbol Ar¹⁰ für einen Arylrest, so dass eine aromatische Gruppe des Rests Ar¹⁰ mit dem Phenylrest, welcher mit dem Rest Ar⁴ verbunden ist, und/oder dem Stickstoffatom verbunden ist.

In einer besonders bevorzugten Ausführungsform kann vorgesehen sein, dass mindestens ein Strukturelement der Formel (II) ausgewählt ist aus der Struktureinheit der folgenden Formel (V) oder eine Struktureinheit der Formel (P-II) ausgewählt ist aus einer Struktureinheit der folgenden Formel (P-V): 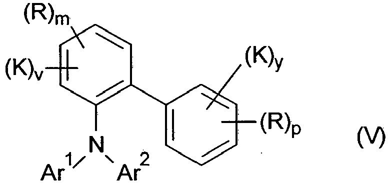 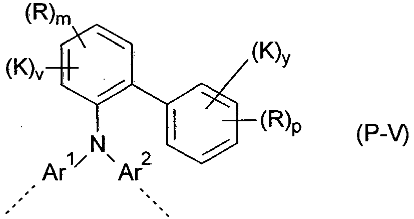
wobei Ar¹, Ar², K, R, m, v und y die zuvor, insbesondere für die Formeln (I), (Ia) und (Ib) angegebenen Bedeutungen annehmen können, die gestrichelten Linien Bindungen zu benachbarten Struktureinheiten im Polymer darstellen und
p = 0, 1, 2, 3, 4 oder 5 ist.

Beispiele für bevorzugte Strukturelemente der Formel (V) sind in der folgenden Tabelle abgebildet:

| | | |
|---|---|---|
| 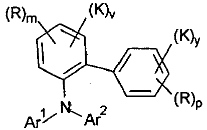 | 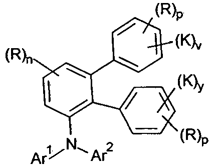 | 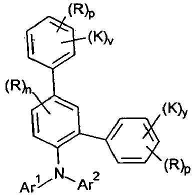 |
| (Va) | (Vb) | (Vc) |
| 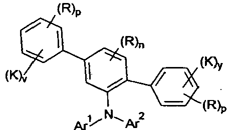 | 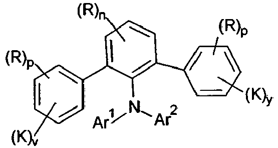 | 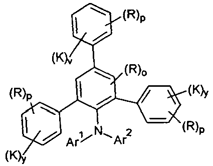 |
| (Vd) | (Ve) | (Vf) |
| 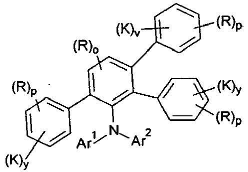 | 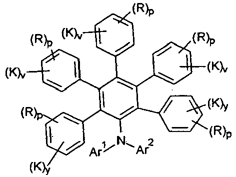 | |
| (Vg) | (Vh) | |

wobei Ar¹, Ar², R, m, n, p, v und y die zuvor, insbesondere für Formeln (I), (Ib) und/oder (V) angegebenen Bedeutungen annehmen können, und o = 0, 1 oder 2 ist.

Beispiele für bevorzugte Struktureinheiten der Formel (P-V) sind in der folgenden Tabelle abgebildet:

| | | |
|---|---|---|
| 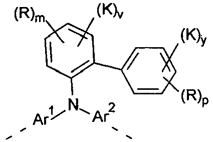 | 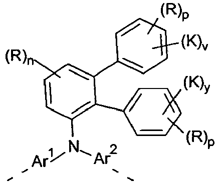 | 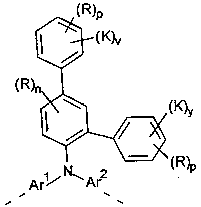 |
| (P-Va) | (P-Vb) | (P-Vc) |
| 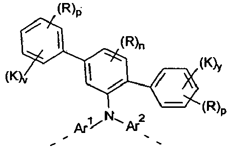 | 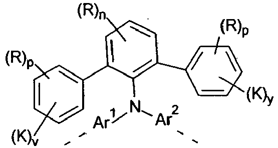 | 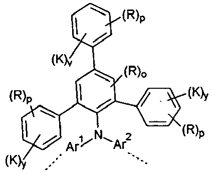 |
| (P-Vd) | (P-Ve) | (P-Vf) |
| 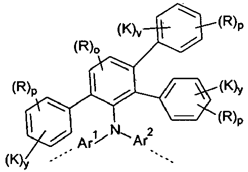 | 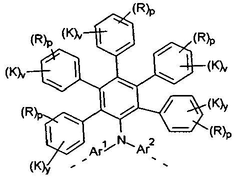 | |
| (P-Vg) | (P-Vh) | |

wobei Ar¹, Ar², R, m, n, p, v, y und die gestrichelten Linien die oben für Formeln (P-I), (P-Ib) und/oder (P-V) angegebenen Bedeutungen annehmen können, und
o = 0, 1 oder 2 ist.

In einer weiteren besonders bevorzugten Ausführungsform kann vorgesehen sein, dass mindestens ein Strukturelement der Formel (III) ausgewählt ist aus der Struktureinheit der folgenden Formel (VI) oder eine Struktureinheit der Formel (P-III) ausgewählt ist aus einer Struktureinheit der folgenden Formel (P-VI): 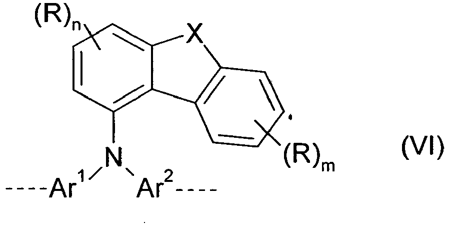 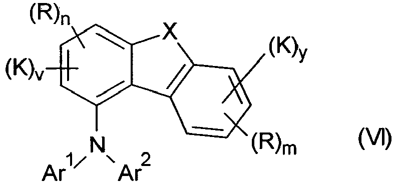 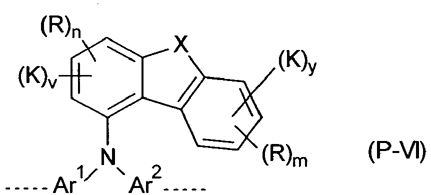 wobei Ar¹, Ar², R, K, v, y, m, n und X die zuvor, insbesondere für Formeln (I), (Ib) und/oder (V) angegebenen Bedeutungen annehmen können und die gestrichelten Linien Bindungen zu benachbarten Struktureinheiten im Polymer darstellen.

Beispiele für bevorzugte Strukturelemente der Formel (VI) sind in der folgenden Tabelle abgebildet:

| | | |
|---|---|---|
| 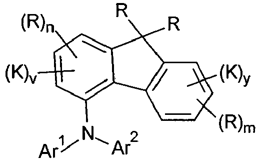 | 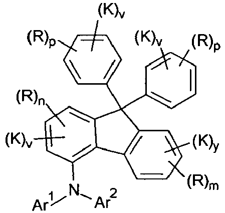 | 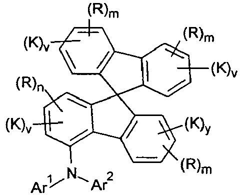 |
| (VIa) | (VIb) | (VIc) |
| 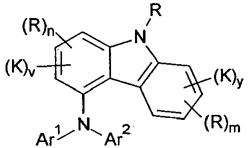 | 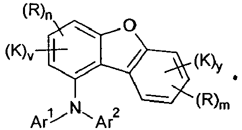 | 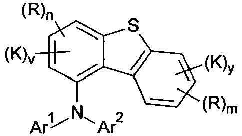 |
| (VId) | (VIe) | (VIf) |

wobei Ar¹, Ar², R, K, v, y, m, n und X die zuvor, insbesondere für Formeln (I), (Ib) und/oder (V) angegebenen Bedeutungen annehmen können.

Beispiele für bevorzugte Struktureinheiten der Formel (P-VI) sind in der folgenden Tabelle abgebildet:

| | | |
|---|---|---|
| 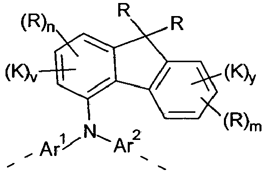 | 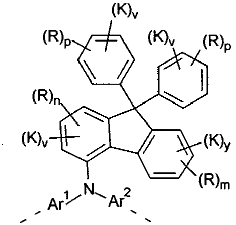 | 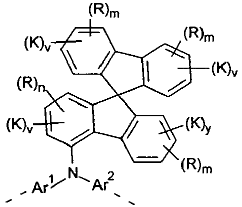 |
| (P-Vla) | (P-Vlb) | (P-VIc) |
| 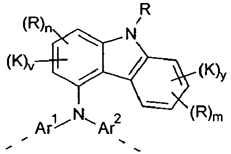 | 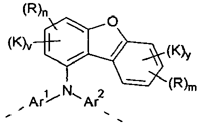 | 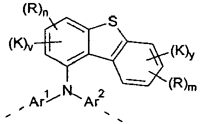 |
| (P-VId) | (P-VIe) | (P-VIf) |

wobei Ar¹, Ar², R, K, v, y, m, n und X die zuvor, insbesondere für Formeln (I), (Ib) und/oder (V) angegebenen Bedeutungen annehmen können und die gestrichelten Linien Bindungen zu benachbarten Struktureinheiten im Polymer darstellen.

In noch einer weiteren besonders bevorzugten Ausführungsform kann vorgesehen sein, dass mindestens ein Strukturelement der Formel (IV) ausgewählt ist aus der Struktureinheit der folgenden Formel (VII) oder eine Struktureinheit der Formel (P-IV) ausgewählt ist aus einer Struktureinheit der folgenden Formel (P-VII): 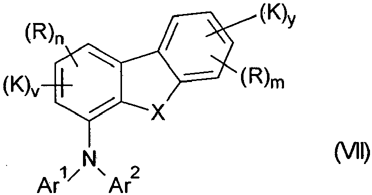 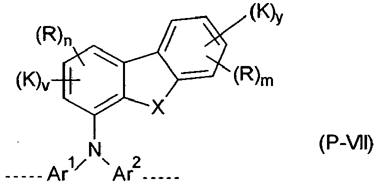 wobei Ar¹, Ar², R, K, v, y, m, n und X die zuvor, insbesondere für Formeln (I), (Ib) und/oder (V) angegebenen Bedeutungen annehmen können und die gestrichelten Linien Bindungen zu benachbarten Struktureinheiten im Polymer darstellen.

Beispiele für bevorzugte Strukturelemente der Formel (VII) sind in der folgenden Tabelle abgebildet:

| | | |
|---|---|---|
| 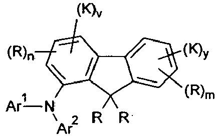 | 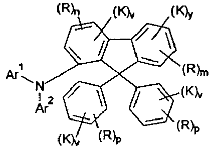 | 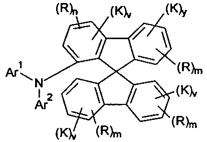 |
| (VIIa) | (VIIb) | (VIIc) |
| 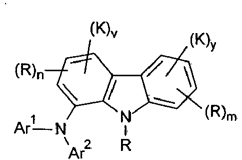 | 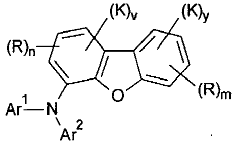 | 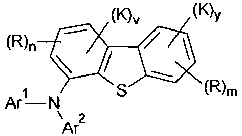 |
| (VIId) | (VIIe) | (VIIf) |

wobei Ar¹, Ar², R, K, v, y, m und n die zuvor, insbesondere für Formeln (I), (Ib) und/oder (V) angegebenen Bedeutungen annehmen können.

Beispiele für bevorzugte Struktureinheiten der Formel (P-VII) sind in der folgenden Tabelle abgebildet:

| | | |
|---|---|---|
| 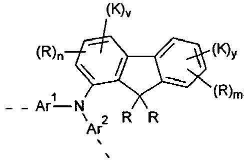 | 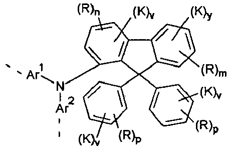 | 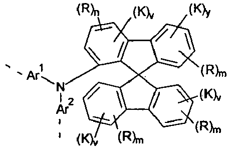 |
| (P-VIIa) | (P-VIIb) | (P-VIIc) |
| 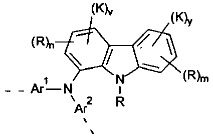 | 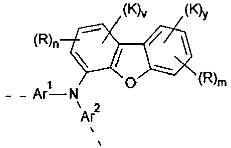 | 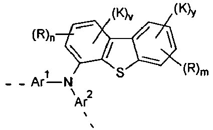 |
| (P-VIId) | (P-VIIe) | (P-VIIf) |

wobei Ar¹, Ar², R, K, v, y, m und n die zuvor, insbesondere für Formeln (I), (Ib) und/oder (V) angegebenen Bedeutungen annehmen können und die gestrichelten Linien Bindungen zu benachbarten Struktureinheiten im Polymer darstellen.

In einer ganz besonders bevorzugten Ausführungsform kann vorgesehen sein, dass mindestens ein Strukturelement der Formel (V) ausgewählt ist aus der Strukturelement der folgenden Formel (Vi) oder eine Struktureinheit der Formel (P-V) ausgewählt ist aus einer Struktureinheit der folgenden Formel (P-Vi): 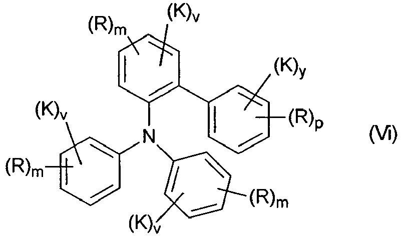 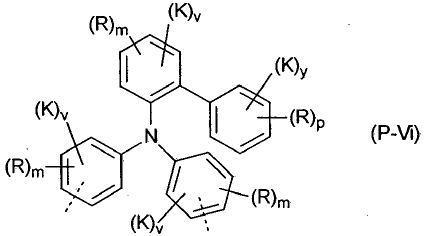 wobei R, m, p, v, y und die gestrichelten Linien die zuvor, insbesondere für Formeln (I), (Ib) und/oder (V) angegebenen Bedeutungen annehmen können.

Beispiele für bevorzugte Strukturelemente der Formel (Vi) sind in der folgenden Tabelle abgebildet:

| | |
|---|---|
| 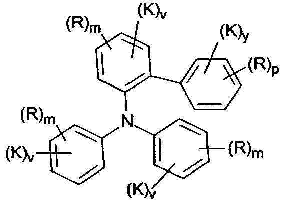 | 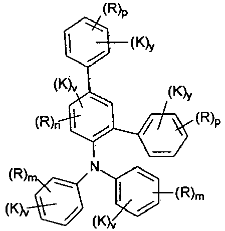 |
| (Vi-1) | (Vi-2) |
| 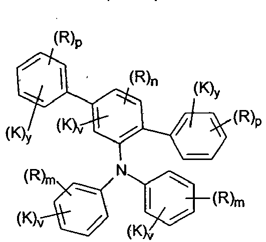 | 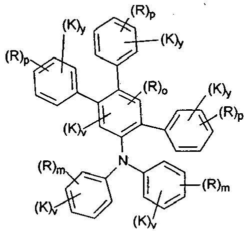 |
| (Vi-3) | (Vi-4) |
| 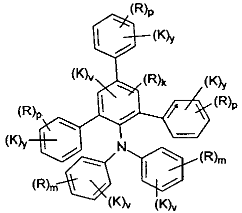 | 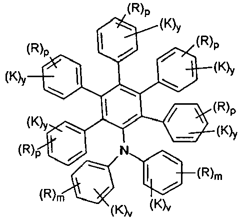 |
| (Vi-5) | (Vi-6) |
| 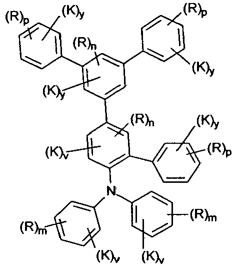 | 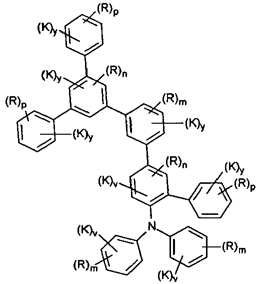 |
| (Vi-7) | (Vi-8) |

wobei R, m, n, p, v und y die zuvor, insbesondere für Formeln (I), (Ib) und/oder (V) angegebenen Bedeutungen annehmen können und o 0, 1 oder 2 ist.

Beispiele für bevorzugte Struktureinheiten der Formel (P-Vi) sind in der folgenden Tabelle abgebildet:

| | |
|---|---|
| 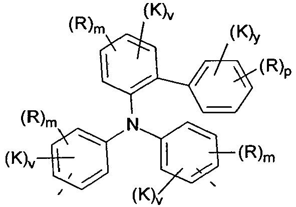 | 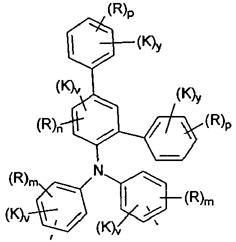 |
| (P-Vi-1) | (P-Vi-2) |
| 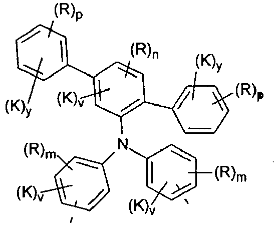 | 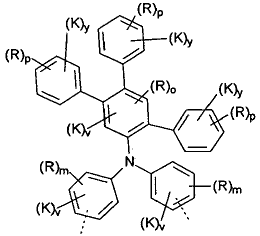 |
| (P-Vi-3) | (P-Vi-4) |
| 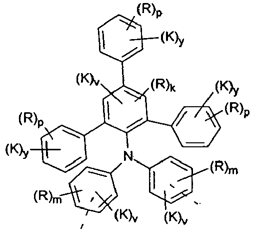 | 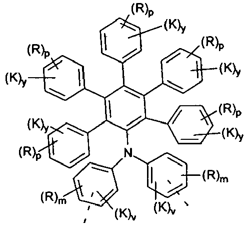 |
| (P-Vi-5) | (P-Vi-6) |
| 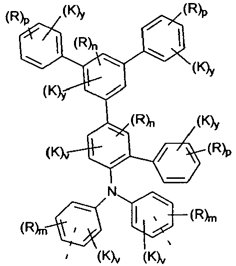 | 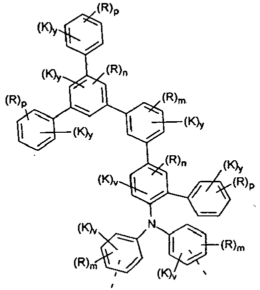 |
| (P-Vi-7) | (P-Vi-8) |

wobei R, m, n, p, v, y und die gestrichelten Linien die zuvor, insbesondere für Formeln (I), (Ib) und/oder (V) angegebenen Bedeutungen annehmen können und o 0, 1 oder 2 ist.

In einer weiteren ganz besonders bevorzugten Ausführungsform kann vorgesehen sein, dass mindestens ein Strukturelement der Formel (VI) ausgewählt ist aus der Strukturelement der folgenden Formel (VIg) oder eine Struktureinheit der Formel (P-VI) ausgewählt ist aus einer Struktureinheit der folgenden Formel (P-VIg): 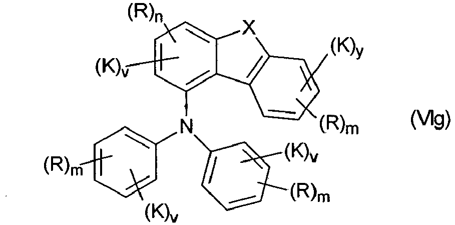 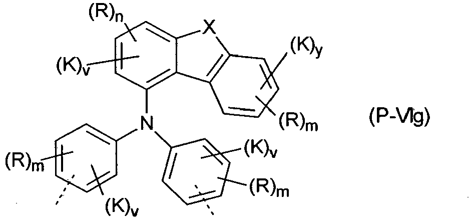 wobei R, m, n, v, y und die gestrichelten Linien die zuvor, insbesondere für Formeln (I), (Ib) und/oder (VI) angegebenen Bedeutungen annehmen können.

Beispiele für bevorzugte Strukturelemente der Formel (VIg) sind in der folgenden Tabelle abgebildet:

| | | |
|---|---|---|
| 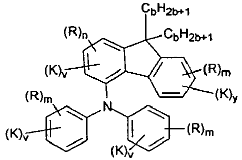 | 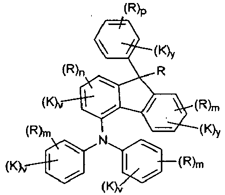 | |
| (VIg-1) | (VIg-2) | |
| 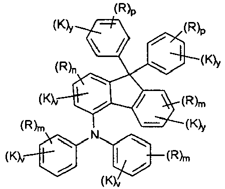 | 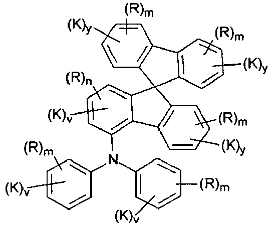 | |
| (VIg-3) | (VIg-4) | |
| 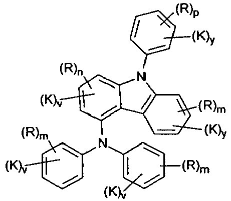 | 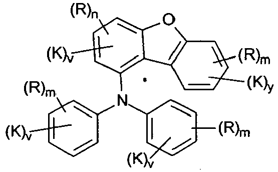 | 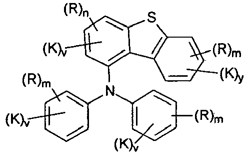 |
| (VIg-5) | (VIg-6) | (VIg-7) |

wobei R, m, n, p, v und y die zuvor, insbesondere für Formeln (I), (Ib) und/oder (VI) angegebenen Bedeutungen annehmen können, und
b = 1 bis 20, vorzugsweise 1 bis 10, ist.

Beispiele für bevorzugte Struktureinheiten der Formel (P-VIg) sind in der folgenden Tabelle abgebildet:

| | | |
|---|---|---|
| 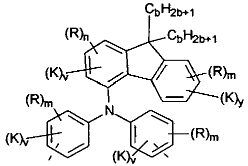 | 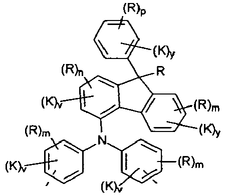 | |
| (P-VIg-1) | (P-VIg-2) | |
| 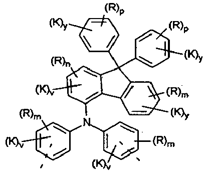 | 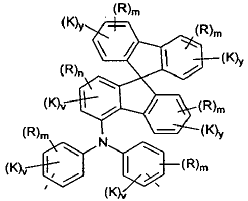 | |
| (P-VIg-3) | (P-VIg-4) | |
| 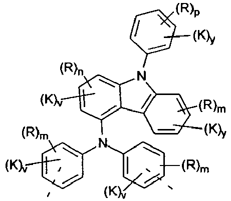 | 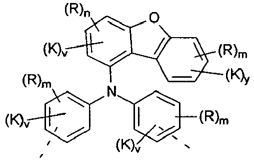 | 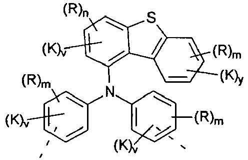 |
| (P-VIg-5) | (P-VIg-6) | (P-VIg-7) |

wobei R, m, n, p, v, y und die gestrichelten Linien die zuvor, insbesondere für Formeln (I), (Ib) und/oder (VI) angegebenen Bedeutungen annehmen können, und
b = 1 bis 20, vorzugsweise 1 bis 10, ist.

In noch einer weiteren ganz besonders bevorzugten Ausführungsform kann vorgesehen sein, dass mindestens ein Strukturelement der Formel (VII) ausgewählt ist aus der Strukturelement der folgenden Formel (VIIg) oder eine Struktureinheit der Formel (P-VII) ausgewählt ist aus einer Struktureinheit der folgenden Formel (P-Vllg): 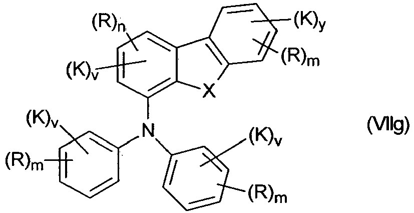 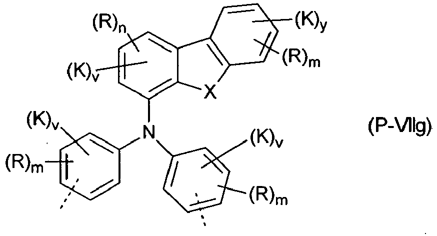 wobei R, m, n, v, y, X und die gestrichelten Linien die zuvor, insbesondere für Formeln (I), (Ib) und/oder (VII) angegebenen Bedeutungen annehmen können.

Beispiele für bevorzugte Strukturelemente der Formel (VIIg) sind in der folgenden Tabelle abgebildet:

| | | |
|---|---|---|
| 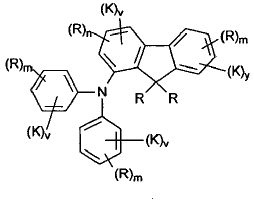 | 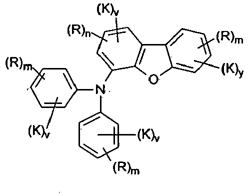 | 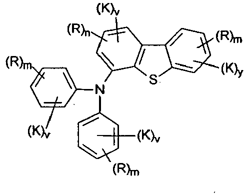 |
| (VIIg-1) | (VIIg-2) | (VIIg-3) |

wobei R, m, n, v und y die zuvor, insbesondere für Formeln (I), (Ib) und/oder (VII) angegebenen Bedeutungen annehmen können.

Beispiele für bevorzugte Struktureinheiten der Formel (P-VIIg) sind in der folgenden Tabelle abgebildet:

| | | |
|---|---|---|
| 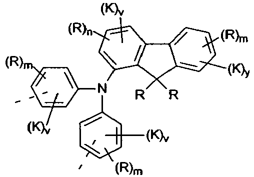 | 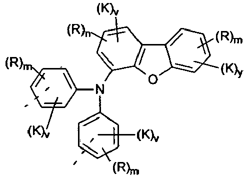 | 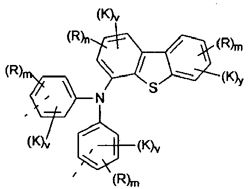 |
| (P-VIIg-1) | (P-VIIg-2) | (P-VIIg-3) |

wobei R, m, n, v, y und die gestrichelten Linien die zuvor, insbesondere für Formeln (I), (Ib) und/oder (VII) angegebenen Bedeutungen annehmen können.

In den Formeln (P-Vi), (P-VIg) und (P-VIIg), sowie deren bevorzugten Ausführungsformen der Formeln (P-Vi-1) bis (P-Vi-7), (P-VIg-1) bis (P-VIg-7) und (P-VIIg-1) bis (P-VIIg-3), stellen die gestrichelten Linien die Bindungen zu den benachbarten Struktureinheiten im Polymer dar. Sie können dabei unabhängig voneinander, gleich oder verschieden, in ortho-, meta- oder para-Position angeordnet sein, vorzugsweise gleich in ortho-, meta- oder para-Position, besonders bevorzugt in meta- oder para-Position und ganz besonders bevorzugt in para-Position.

Vorzugsweise kann der Ligand durch eine Struktur der Formel (II) bis (VII) oder bevorzugten Ausführungsformen dieser Strukturen dargestellt werden. Gemäß einer weiteren bevorzugten Ausgestaltung der vorliegenden Erfindung kann vorgesehen sein, dass der Ligand ein Polymer darstellt, das mindestens eine Struktureinheit der Formel (P-I) umfasst, die ausgewählt ist aus einer Struktureinheit der folgenden Formel (P-Vllla): 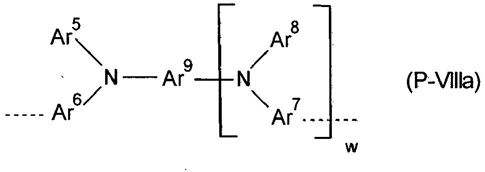 und/oder einer Struktureinheit der folgenden Formel (P-Vlllb): 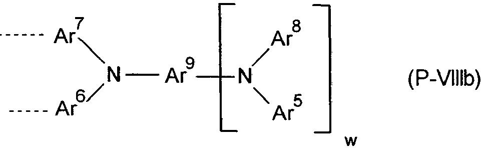
wobei z 1, 2 oder 3 ist, Ar⁵ bis Ar⁹ bei jedem Auftreten, jeweils gleich oder verschieden, ein mono- oder polycyclisches, aromatisches oder heteroaromatisches Ringsystem ist, das mit einem oder mehreren Resten R substituiert sein kann, wobei R die zuvor, insbesondere für Formel (I) dargelegte Bedeutung annehmen kann;
die gestrichelten Linien Bindungen zu benachbarten Struktureinheiten im Polymer darstellen;
wobei die Gruppen Ar¹, Ar², Ar³, Ar⁴, Ar⁵, Ar⁶, Ar⁶, Ar⁷, Ar⁸ und Ar⁹ in den Struktureinheiten (P-VIIIa) und/oder (P-VIIIb) mit einer oder mehreren anionischen Koordinierungsgruppen, vorzugsweise mindestens einer Gruppe gemäß Formel (K-I) und/oder (K-II), substituiert sein können.

Vorzugsweise kann vorgesehen sein, dass die Gruppen Ar¹, Ar², Ar³, Ar⁴, Ar⁵, Ar⁶, Ar⁶, Ar⁷, Ar⁸ und Ar⁹ in den Struktureinheiten (P-Vllla) und (P-VIIIb) nicht mit einer anionischen Koordinierungsgruppe substituiert sind, so dass diese Struktureinheiten keine anionische Koordinierungsgruppe umfassen.

Vorzugsweise kann ein polymerer Ligand mindestens eine Struktureinheit der folgenden Formel (L-P-I) umfassen die ausgewählt ist aus einer Struktureinheit der folgenden Formel (L-P-Vllla): 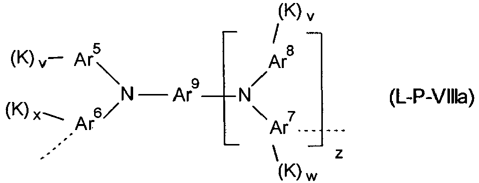 und/oder einer Struktureinheit der folgenden Formel (L-P-Vlllb): 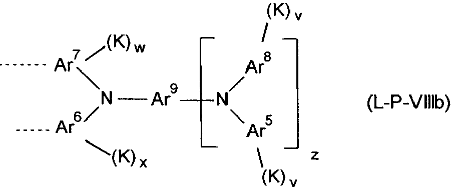
wobei z 1, 2 oder 3 ist, Ar⁵ bis Ar⁹ bei jedem Auftreten, jeweils gleich oder verschieden, ein mono- oder polycyclisches, aromatisches oder heteroaromatisches Ringsystem ist, das mit einem oder mehreren Resten R substituiert sein kann, wobei R die in Anspruch 2 dargelegte Bedeutung annehmen kann; K eine anionische Koordinierungsgruppe darstellt, vorzugsweise eine Gruppe gemäß Formel (K-I) und/oder (K-II);
v = 0, 1, 2, 3, 4, 5, 6 oder 7, bevorzugt 0, 1, 2, 3 oder 4, besonders bevorzugt 0, 1 oder 2;
w = 0, 1, 2, 3, 4, 5, 6 oder 7, bevorzugt 0, 1, 2, 3 oder 4, besonders bevorzugt 0, 1 oder 2; und
x = 0, 1, 2, 3, 4, 5, 6 oder 7, bevorzugt 0, 1, 2, 3 oder 4, besonders bevorzugt 0, 1 oder 2 ist,
wobei die Summe von v, w und x größer oder gleich 1 ist und die gestrichelten Linien Bindungen zu benachbarten Struktureinheiten im Polymer darstellen. Die Summe von v, w und x in Formeln (L-P-VIIIa) und/oder (L-P-Vlllb) kann vorzugsweise im Bereich von 1 bis 10, bevorzugt 1 bis 5 und besonders bevorzugt 1 bis 3 liegen.

Vorzugsweise kann mindestens einer der Reste einer der Reste Ar⁵ bis Ar⁹ in Formeln (P-VIIIa), (P-Vlllb), (L-P-Vllla) und/oder (L-P-VIIIb) mindestens einen Substituenten R mit mindestens 2 Kohlenstoffatomen umfassen, vorzugsweise mindestens 4 und besonders bevorzugt mindestens 6 Kohlenstoffatomen, wobei R die zuvor, insbesondere für Formel (I) genannte Bedeutung annehmen kann. Mit besonderem Vorteil weist dieser Substituent mit 2 Kohlenstoffatomen eine C-C-Doppelbindung zwischen diesen 2 Kohlenstoffatomen auf oder dieser Substituent mit 2 Kohlenstoffatomen ist Teil eines mono- oder polycyclisches, aromatisches oder heteroaromatisches Ringsystems mit 5 bis 60 aromatischen Ringatomen.

Vorzugsweise kann vorgesehen sein, dass mindestens einer der Rest Ar⁵ und/oder Ar⁸ gemäß Formeln (P-VIIIa), (P-VIIIb), (L-P-VIIIa) und/oder (L-P-VIIIb) in mindestens einer, vorzugsweise in genau einer der beiden ortho-Positionen, bezogen auf die Position des in Formel (P-VIIIa), (P-VIIIb), (L-P-VIIIa) und/oder (L-P-VIIIb) dargestellten Stickstoffatoms, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die zuvor, insbesondere für Formel (I) dargelegte Bedeutung annehmen kann, wobei der Rest Ar⁴ mit einer oder mehreren anionischen Koordinierungsgruppen, vorzugsweise mindestens einer Gruppe gemäß Formel (K-I) und/oder (K-II), substituiert sein kann.

Ferner kann vorgesehen sein, dass die Summe der Ringatome des Rests Ar⁴ zusammen mit den Ringatomen der an diesen Rest gebundenen Gruppe Ar⁵ oder Ar⁸ gemäß Formeln (P-VIIIa), (P-VIIIb), (L-P-VIIIa) und/oder (L-P-Vlllb) mindestens 12 beträgt. Vorzugsweise bildet der Rest Ar⁴ zusammen mit den Ringatomen der an diesen Rest gebundenen Gruppe Ar⁵ oder Ar⁸ gemäß Formeln (P-VIIIa), (P-VIIIb), (L-P-VIIIa) und/oder (L-P-Vlllb) kein kondensiertes Ringsystem. Weiterhin sind als Rest Ar⁴ Gruppen bevorzugt, die einen geringen Kondensationsgrad aufweisen, so dass monocyclische, aromatische oder heteroaromatische Ringsysteme bevorzugt sind oder polycyclische, aromatische oder heteroaromatische Ringsysteme, deren aromatische oder heteroaromatische Ringe über Gruppen verbunden sind, die eine Konjugation der Ringe minimieren oder aufheben.

Ar⁴ kann dabei entweder direkt, das heißt über eine Einfachbindung, mit mindestens einer der Rest Ar⁵ und/oder Ar⁸ gemäß Formeln (P-VIIIa), (P-VIIIb), (L-P-VIIIa) und/oder (L-P-VIIIb) verknüpft sein oder aber über eine Verknüpfungsgruppe X. Vorzugsweise kann eine aromatische Gruppe des Rests Ar⁴ direkt mit einer aromatischen Gruppe der Reste Ar⁵ und/oder Ar⁸ verbunden sein.

Die Struktureinheit der Formel (P-Vllla) kann somit vorzugsweise die Struktur der folgenden Formeln (P-VIIIa-1a), (P-VIIIa-1b), (P-VIIIa-1c) und (P-VIIIa-1d) aufweisen: 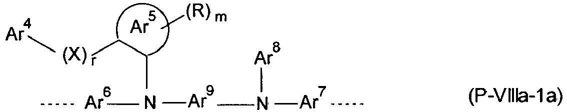 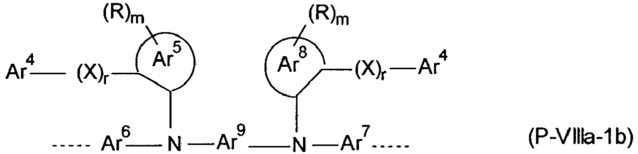 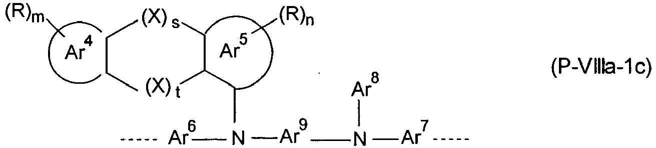 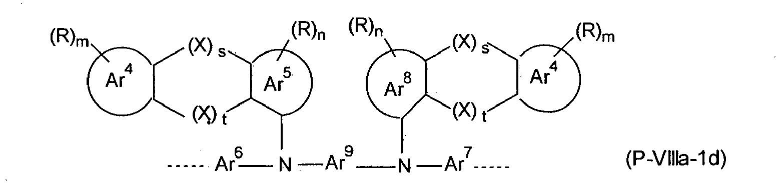 wobei Ar⁴, Ar⁵, Ar⁶, Ar⁷, Ar⁸, Ar⁹, X, m, n, r, s, t, R und die gestrichelten Linien die zuvor, insbesondere für die Formeln (P-I), (P-Ia), (P-Ib) und (P-VIIIa) angegebenen Bedeutungen annehmen können, wobei mindestens eine der Gruppen Ar⁴, Ar⁵, Ar⁶, Ar⁷, Ar⁸, Ar⁹ und/oder X mit mindestens einer anionischen Koordinierungsgruppe substituiert sein kann, vorzugsweise mindestens einer Gruppe gemäß Formel (K-I) und/oder (K-II).

Weiterhin kann die Struktureinheit der Formel (P-VIIIa) und/oder (P-VIIIb) eine Struktur der folgenden Formeln (P-VIIIb-a), (P-VIIIb-b), (P-VIIIb-c) und/oder (P-Vlllb-d) aufweisen 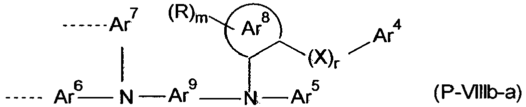 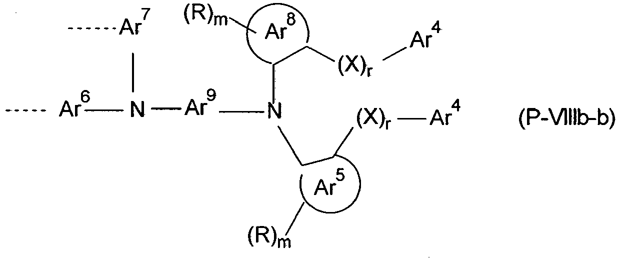 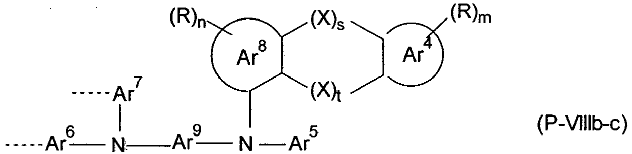 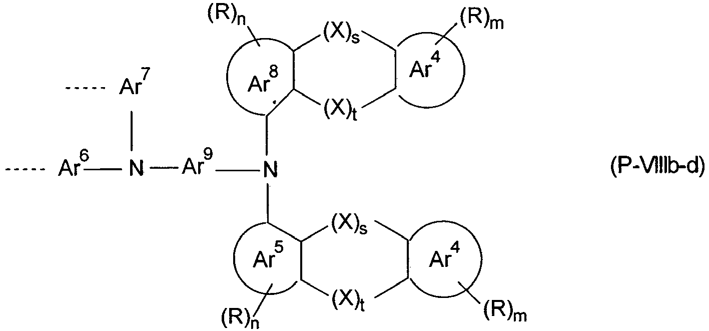 wobei Ar⁴, Ar⁵, Ar⁶, Ar⁷, Ar⁸, Ar⁹, X, m, n, s, t und R die zuvor, insbesondere für die Formeln (P-I), (P-Ia), (P-Ib), (P-VIIIa) und (P-VIIIb) angegebenen Bedeutungen annehmen können, wobei mindestens einer der Gruppen Ar⁴, Ar⁵, Ar⁶, Ar⁷, Ar⁸, Ar⁹ und/oder X mit mindestens einer anionischen Koordinierungsgruppe substituiert sein kann, vorzugsweise mindestens einer Gruppe gemäß Formel (K-I) und/oder (K-II).

In einer bevorzugten Ausführungsform ist die mindestens eine Struktureinheit der Formel (P-VIIIa) ausgewählt ist aus Struktureinheiten der folgenden Formeln (P-IX), (P-X), (P-XI), (P-XII), (P-XIII), (P-XIV), (P-XV) und (P-XVI): 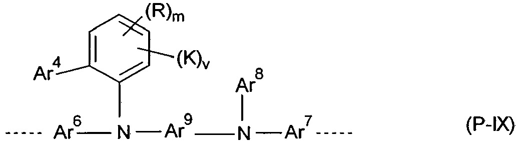 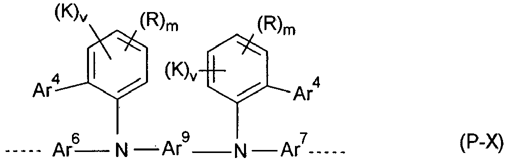 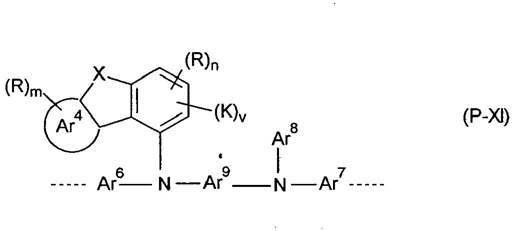 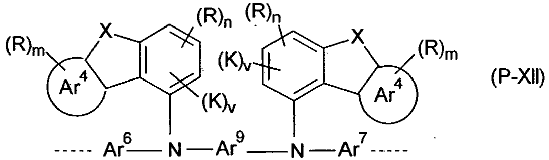 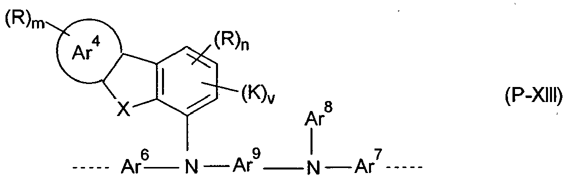 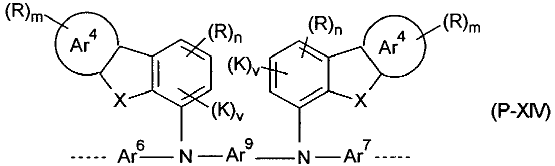 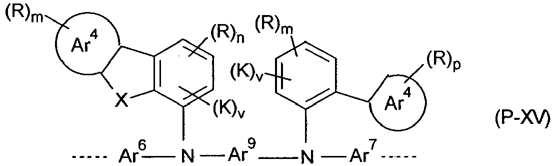 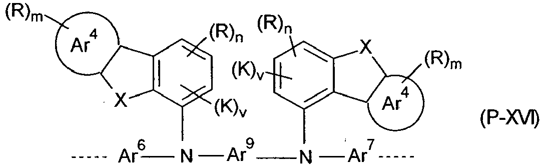 Ar⁴, Ar⁵, Ar⁶, Ar⁷, Ar⁸, Ar⁹, X, v, m, n, p, R und die gestrichelten Linien die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In einer besonders bevorzugten Ausführungsform sind die Struktureinheiten der Formeln (P-IX) und (P-X) ausgewählt aus den Struktureinheiten der folgenden Formeln (P-IXa) und (P-Xa): 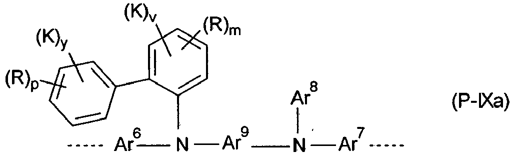 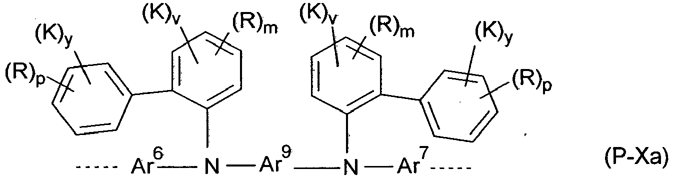 wobei Ar⁶, Ar⁷, Ar⁸, Ar⁹, R, m, p, v, y und die gestrichelten Linien die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In einer weiteren besonders bevorzugten Ausführungsform sind die Struktureinheiten der Formeln (P-XI) und (P-XII) ausgewählt aus den Struktureinheiten der folgenden Formeln (P-Xla) und (P-XIIa): 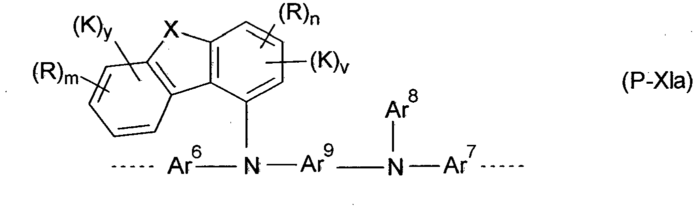 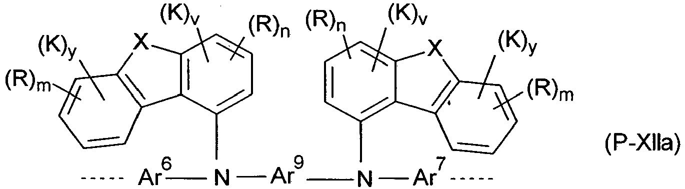 wobei Ar⁶, Ar⁷, Ar⁸, Ar⁹, R, m, n, v, y und X die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In noch einer weiteren besonders bevorzugten Ausführungsform sind die Struktureinheiten der Formeln (P-XIII) und (P-XIV) ausgewählt aus den Struktureinheiten der folgenden Formeln (P-XIIIa) und (P-XIVa): 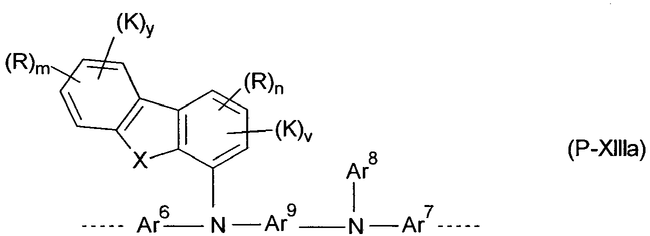 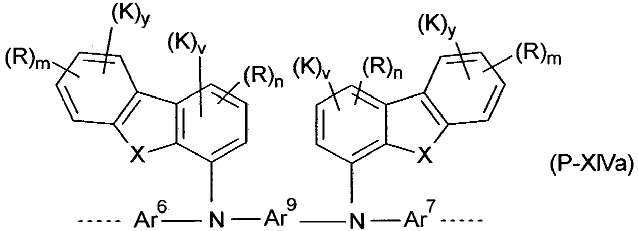 wobei Ar⁶, Ar⁷, Ar⁸, Ar⁹, R, m, n, v, y und X die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In einer ganz besonders bevorzugten Ausführungsform sind die Struktureinheiten der Formeln (P-IXa) und (P-Xa) ausgewählt aus den Struktureinheiten der folgenden Formeln (P-IXb) und (P-Xb): 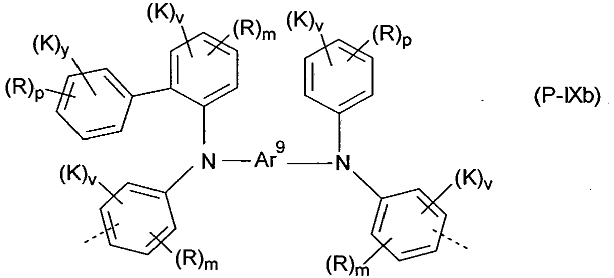 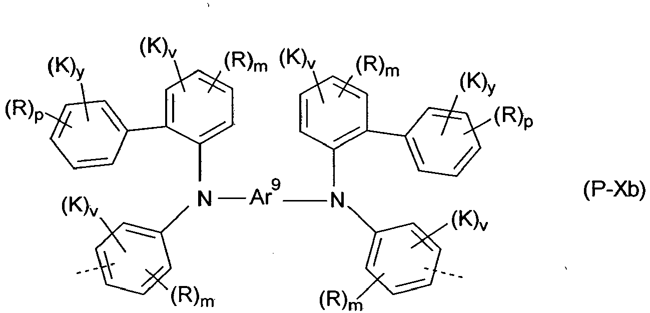 wobei Ar⁹, R, m p, v und y die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In einer weiteren ganz besonders bevorzugten Ausführungsform sind die Struktureinheiten der Formeln (P-XIa) und (P-XIIa) ausgewählt aus den Struktureinheiten der folgenden Formeln (P-XIb) und (P-XIIb): 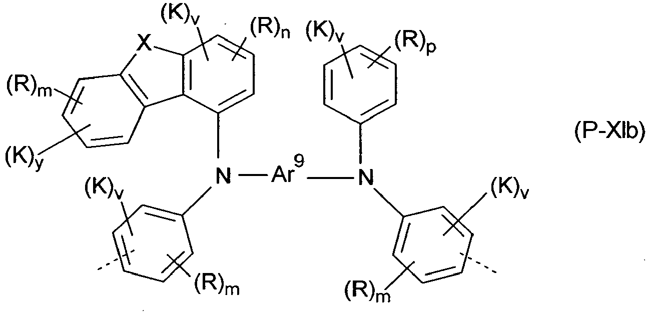 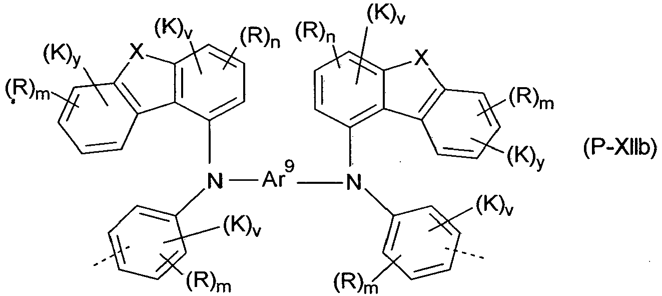 wobei Ar⁹, R, X, m, n, p, v und y die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In noch einer weiteren ganz besonders bevorzugten Ausführungsform sind die Struktureinheiten der Formeln (P-XIIIa) und (P-XIVa) ausgewählt aus den Struktureinheiten der folgenden Formeln (P-XIIIb) und (P-XIVb): 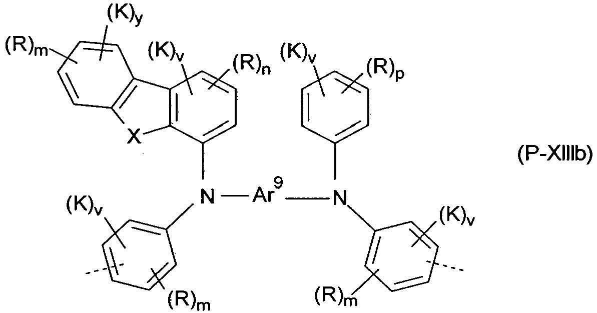 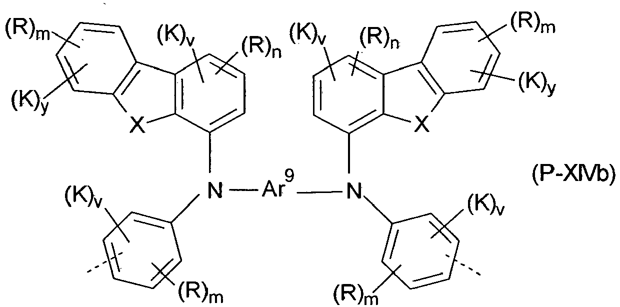 wobei R, X, m, n, p, v und y die zuvor, insbesondere für die Formeln (P-I), (P-Ia), (P-Ib), (P-VIIIa), (L-P-VIIIa), (P-VIIIb) und (L-P-VIIIb) angegebenen Bedeutungen annehmen können.

In den Formeln (P-IXa) bis (P-XIVa) und (P-IXb) bis (P-XIVb), stellen die gestrichelten Linien die Bindungen zu den benachbarten Struktureinheiten im Polymer dar. Sie können dabei unabhängig voneinander, gleich oder verschieden, in ortho-, meta- oder para-Position angeordnet sein, vorzugsweise gleich in ortho-, meta- oder para-Position, besonders bevorzugt in meta- oder para-Position und ganz besonders bevorzugt in para-Position.

Weiterhin kann vorgesehen sein, dass mindestens eine der Struktureinheiten der Formeln (I), (la), (Ib), (II), (III), (IV), (V), (VI), (VII), (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV), (P-XVI) und/oder einer bevorzugten Ausgestaltung dieser Struktureinheiten mindestens eine vernetzbare Gruppe Q aufweist.

"Vernetzbare Gruppe Q" im Sinne der vorliegenden Erfindung bedeutet eine funktionelle Gruppe, die in der Lage ist, eine Reaktion einzugehen und so eine unlösliche Verbindung zu bilden. Hierbei unterscheidet sich eine vernetzbare Gruppe Q von einer anionischen Koordinierungsgruppe, die im erfindungsgemäß einsetzbaren Liganden enthalten ist. Die Reaktion kann dabei mit einer weiteren, gleichen Gruppe Q, einer weiteren, verschiedenen Gruppe Q oder einem beliebigen anderen Teil derselben oder einer anderen Polymerkette erfolgen. Bei der vernetzbaren Gruppe handelt es sich somit um eine reaktive Gruppe. Dabei erhält man als Ergebnis der Reaktion der vernetzbaren Gruppe eine entsprechend vernetzte Verbindung. Die chemische Reaktion kann auch in der Schicht durchgeführt werden, wobei eine unlösliche Schicht entsteht. Die Vernetzung kann gewöhnlich durch Wärme oder durch UV-, Mikrowellen-, Röntgen- oder Elektronenstrahlung unterstützt werden, gegebenenfalls in Gegenwart eines Initiators. "Unlöslich" im Sinne der vorliegenden Erfindung bedeutet vorzugsweise, dass das erfindungsgemäße Polymer nach der Vernetzungsreaktion, also nach der Reaktion der vernetzbaren Gruppen, bei Raumtemperatur in einem organischen Lösungsmittel eine Löslichkeit aufweist, die mindestens einen Faktor 3, vorzugsweise mindestens einen Faktor 10, geringer ist als die des entsprechenden, nicht-vernetzten, erfindungsgemäßen Polymers in demselben organischen Lösungsmittel.

Mindestens eine vernetzbare Gruppe heißt in der vorliegenden Anmeldung, dass eine Struktureinheit eine oder mehrere vernetzbare Gruppen aufweist. Vorzugsweise weist eine Struktureinheit genau eine vernetzbare Gruppe auf.

Weist die Struktureinheit der Formel (I) eine vernetzbare Gruppe auf, so kann diese an Ar¹, Ar² oder Ar³ gebunden sein. Vorzugsweise ist die vernetzbare Gruppe an dem monovalent gebundenen, mono- oder polycyclischen, aromatischen oder heteroaromatischen Ringsystem Ar³ gebunden.

Weist die Struktureinheit der Formel (P-Vllla) oder (P-Vlllb) eine vernetzbare Gruppe auf, so kann diese an Ar⁵, Ar⁶, Ar⁷, Ar⁸ oder Ar⁹ gebunden sein. Vorzugsweise ist die vernetzbare Gruppe an eine der monovalent gebundenen, mono- oder polycyclischen, aromatischen oder heteroaromatischen Ringsysteme gebunden, d.h. an Ar⁵ oder Ar⁸.

Bevorzugte vernetzbare Gruppen Q sind unter anderem in der Druckschrift DE 10 2009 010 714.2 dargelegt.

Vorzugsweise kann der Einsatz von spezifischen vernetzbaren Gruppen Q vermindert oder, vorzugsweise vollständig verzichtet werden, da in bevorzugten Ausführungsformen eine Vernetzung einer aus den erfindungsgemäßen Metallkomplexen erhältlichen Schicht über die Metallkomplexe erfolgt.

Ferner kann vorgesehen sein, dass mindestens ein Teil der Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) im Polymer mindestens eine anionische Koordinierungsgruppe mit mindestens einem Sauerstoff- und/oder Stickstoffatom umfasst.

Der Anteil an Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) mit mindestens einer anionischen Koordinierungsgruppe kann bevorzugt im Bereich von 0 bis 50 Mol-%, vorzugsweise im Bereich von 1 bis 40 Mol-%, insbesondere bevorzugt 3 bis 30 Mol-% und besonders bevorzugt 5 bis 20 Mol-% liegen, bezogen auf die Gesamtzahl der Struktureinheiten des Polymers.

Weiterhin kann vorgesehen sein, dass mindestens ein Teil der Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) im Polymer keine anionische Koordinierungsgruppe mit mindestens einem Sauerstoff- und/oder Stickstoffatom umfasst.

Der Anteil an Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI), die keine anionische Koordinierungsgruppe mit mindestens einem Sauerstoff- und/oder Stickstoffatom umfassen, kann bevorzugt im Bereich von 50 bis 100 Mol-%, vorzugsweise im Bereich von 60 bis 99 Mol-%, insbesondere bevorzugt 70 bis 97 Mol-% und besonders bevorzugt 80 bis 95 Mol-% liegen, bezogen auf die Gesamtzahl der Struktureinheiten des Polymers

In einer ersten bevorzugten Ausführungsform enthält das erfindungsgemäße Polymer nur Struktureinheiten der Formeln (P-I), (P-Ia), (P-Ib), (P-II), (P-III), (P-IV), (P-V), (P-VI), (P-VII), (P-Vllla), (P-VIIIb), (P-IX), (P-X), (P-XI), (P-XII), (P-XIII), (P-XIV), (P-XV), (P-XVI) und/oder einer bevorzugten Ausgestaltung dieser Struktureinheiten, d.h. deren Anteil im Polymer beträgt 100 mol%. Besonders bevorzugt umfasst das erfindungsgemäße Polymer nur genau eine Art von Struktureinheiten der Formeln (P-I), (P-Ia), (P-Ib), (P-II), (P-III), (P-IV), (P-V), (P-VI), (P-VII), (P-Vllla), (P-VIIIb), (P-IX), (P-X), (P-XI), (P-XII), (P-XIII), (P-XIV), (P-XV), (P-XVI) und/oder einer bevorzugten Ausgestaltung dieser Struktureinheiten. Es handelt sich in diesem Fall bei dem erfindungsgemäßen Polymer um ein Homopolymer.

In einer zweiten bevorzugten Ausführungsform liegt der Anteil an Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV), (P-XVI) und/oder einer bevorzugten Ausgestaltung dieser Struktureinheiten im Polymer im Bereich von 50 bis 95 mol%, besonders bevorzugt im Bereich von 60 bis 95 mol%, bezogen auf 100 mol% aller copolymerisierbaren Monomere, die im Polymer als Struktureinheiten enthalten sind, d.h., dass das erfindungsgemäße Polymer neben einer oder mehrerer Struktureinheiten der Formeln (P-I), (P-Ia), (P-Ib), (P-II), (P-III), (P-IV), (P-V), (P-VI), (P-VII), (P-VIIIa), (P-Vlllb), (P-IX), (P-X), (P-XI), (P-XII), (P-XIII), (P-XIV), (P-XV), (P-XVI) und/oder einer bevorzugten Ausgestaltung dieser Struktureinheiten noch weitere, von den Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV), (P-XVI) und/oder einer bevorzugten Ausgestaltung dieser Struktureinheiten verschiedene Struktureinheiten aufweist.

In einer dritten bevorzugten Ausführungsform liegt der Anteil an Struktureinheiten der Formel (P-I), (P-Ia), (P-Ib), (P-II), (P-III), (P-IV), (P-V), (P-VI), (P-VII), (P-VIIIa), (P-Vlllb), (P-IX), (P-X), (P-XI), (P-XII), (P-XIII), (P-XIV), (P-XV) und/oder (P-XVI) im Polymer im Bereich von 5 bis 50 mol%, besonders bevorzugt im Bereich von 25 bis 50 mol%, bezogen auf 100 mol% aller copolymerisierbaren Monomere, die im Polymer als Struktureinheiten enthalten sind, d.h., dass das erfindungsgemäße Polymer neben einer oder mehrerer Struktureinheiten der Formel (P-I), (P-Ia), (P-Ib), (P-II), (P-III), (P-IV), (P-V), (P-VI), (P-VII), (P-Vllla), (P-VIIIb), (P-IX), (P-X), (P-XI), (P-XII), (P-XIII), (P-XIV), (P-XV) und/oder (P-XVI) noch weitere, von den Struktureinheiten der Formeln (P-I), (P-Ia), (P-Ib), (P-II), (P-III), (P-IV), (P-V), (P-VI), (P-VII), (P-VIIIa), (P-Vlllb), (P-IX), (P-X), (P-XI), (P-XII), (P-XIII), (P-XIV), (P-XV) und/oder (P-XVI) verschiedene Struktureinheiten aufweist.

Diese, von den Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) verschiedene Struktureinheiten, sind unter anderem solche, wie sie in der WO 02/077060 A1 und in der WO 2005/014689 A2 offenbart und umfangreich aufgelistet sind. Diese werden via Zitat als Bestandteil der vorliegenden Erfindung betrachtet.

Vorzugsweise kann vorgesehen sein, dass das Polymer neben Struktureinheiten der Formeln (L-P-I), (L-P-Ia), (L-P-Ib), (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) mindestens eine weitere Struktureinheit der folgenden Formel (P-XVII) enthält, die von den Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) verschieden ist:

-----Ar¹¹----- (P-XVII)

wobei Ar¹¹ ein mono- oder polycyclisches, aromatisches oder heteroaromatisches Ringsystem ist, das mit einem oder mehreren Resten R und/oder K substituiert sein kann, wobei R die zuvor, insbesondere für Formel (I) angegebenen Bedeutungen annehmen kann und K eine anionische Koordinierungsgruppe darstellt, vorzugsweise eine Gruppe gemäß Formel (K-I) und/oder (K-II), und
die gestrichelten Linien Bindungen zu benachbarten Struktureinheiten im Polymer darstellen.

Gemäß einer bevorzugten Ausgestaltung kann das Polymer Struktureinheiten gemäß Formel (P-XVII) umfassen, die nicht mit einer anionischen Koordinierungsgruppe substituiert sind. Hierbei kann vorgesehen sein, dass der Anteil an Struktureinheiten Formel (P-XVII), die keine anionische Koordinierungsgruppe mit mindestens einem Sauerstoff- und/oder Stickstoffatom umfassen, im Bereich von 50 bis 100, vorzugsweise im Bereich von 60 bis 99 Mol-%, insbesondere bevorzugt 70 bis 97 Mol-% und besonders bevorzugt 80 bis 95 Mol-% liegt, bezogen auf die Gesamtzahl der Struktureinheiten des Polymers.

Ferner kann vorgesehen sein, dass das Polymer neben Struktureinheiten der Formeln (P-I), (P-Ia), (P-Ib), (L-P-I), (L-P-Ia), (L-P-Ib), (P-II), (P-III), (P-IV), (P-V), (P-VI), (P-VII), (P-VIIIa), (P-VIIIb), (L-P-VIIIa), (L-P-VIIIb), (P-IX), (P-X), (P-XI), (P-XII), (P-XIII), (P-XIV), (P-XV) und/oder (P-XVI) mindestens eine weitere Struktureinheit der folgenden Formel (L-P-XVII) enthält, die von den Struktureinheiten der Formeln (P-I), (P-Ia), (P-Ib), (L-P-I), (L-P-Ia), (L-P-Ib), (P-II), (P-III), (P-IV), (P-V), (P-VI), (P-VII), (P-VIIIa), (P-VIIIb), (L-P-VIIIa), (L-P-VIIIb), (P-IX), (P-X), (P-XI), (P-XII), (P-XIII), (P-XIV), (P-XV) und/oder (P-XVI) verschieden ist: 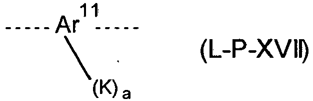
wobei Ar¹¹ ein mono- oder polycyclisches, aromatisches oder heteroaromatisches Ringsystem ist, das mit einem oder mehreren Resten R substituiert sein kann, wobei R die zuvor, insbesondere für Formel (I) angegebenen Bedeutungen annehmen kann, und K eine anionische Koordinierungsgruppe darstellt, vorzugsweise eine Gruppe gemäß Formel (K-I) und/oder (K-II), a = 1, 2, 3, 4, 5, 6, 7 oder 8, vorzugsweise 1 2, 3 oder 4 ist, und
die gestrichelten Linien Bindungen zu benachbarten Struktureinheiten im Polymer darstellen.

Vorzugsweise kann der Anteil an Struktureinheiten der Formel (P-XVII) im Polymer mit mindestens einer anionischen Koordinierungsgruppe im Bereich von 0 bis 50 Mol-%, bevorzugt im Bereich von 1 bis 40 Mol-%, insbesondere bevorzugt 3 bis 30 Mol-% und besonders bevorzugt 5 bis 20 Mol-% liegen, bezogen auf die Gesamtzahl der Struktureinheiten des Polymers.

Gemäß einer Ausführungsform der vorliegenden Erfindung kann vorgesehen sein, dass keiner der Struktureinheiten der Formeln (P-I), (P-la), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) eines Polymers eine anionische Koordinierungsgruppe umfasst, sondern lediglich Struktureinheiten, die beispielsweise durch Formel (P-XVII), insbesondere (L-P-XVII) darstellbar sind.

Ferner kann vorgesehen sein, dass lediglich Struktureinheiten der Formeln (P-I), (P-Ia), (P-Ib), (P-II), (P-III), (P-IV), (P-V), (P-VI), (P-VII), (P-VIIIa), (P-Vlllb), (P-IX), (P-X), (P-XI), (P-XII), (P-XIII), (P-XIV), (P-XV) und/oder (P-XVI) eines Polymers anionische Koordinierungsgruppen umfasst, und Struktureinheiten des Polymers, die beispielsweise durch Formel (P-XVII) darstellbar sind, keine anionische Koordinierungsgruppen umfasst.

Weiterhin kann vorgesehen sein, dass ein Copolymer sowohl Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) mit anionischen Koordinierungsgruppen umfasst als auch Struktureinheiten mit anionischen Koordinierungsgruppen, die nicht den Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) entsprechen und beispielsweise durch Formel (P-XVII), insbesondere (L-P-XVII) darstellbar sind.

Ferner kann vorgesehen sein, dass der Anteil an Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV), (P-XVI) und/oder (P-XVII) mit mindestens einer anionischen Koordinierungsgruppe im Bereich von 1 bis 50 Mol-%, vorzugsweise im Bereich von 2 bis 40 Mol-%, insbesondere bevorzug 3 bis 30 Mol-% und besonders bevorzugt 5 bis 20 Mol-% liegt, bezogen auf die Gesamtzahl der Struktureinheiten des Polymers.

Bevorzugte mono- oder polycyclische, aromatische oder heteroaromatische Gruppen Ar¹ und Ar² in Formeln (I), (L-I); Ar³ in Formeln (I), (P-I); Ar⁴ in Formeln (la), (Ib), (II), (III), (IV), (V), (VI), (VII), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV), (P-XVI); Ar⁵ und Ar⁸ in Formeln (P-VIIIa) und/oder (P-VIIIb), sowie deren bevorzugten Ausführungsformen sind die folgenden:

| | | |
|---|---|---|
| 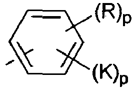 | 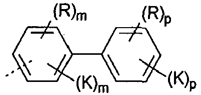 | 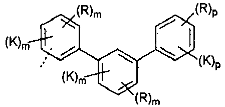 |
| E1 | E2 | E3 |
| 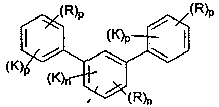 | 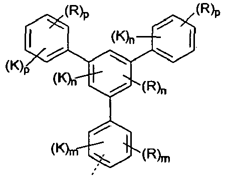 | 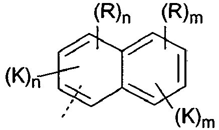 |
| E4 | E5 | E6 |
| 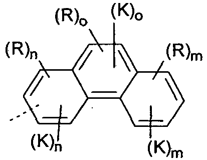 | 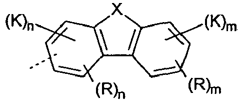 | 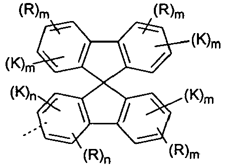 |
| E7 | E8 | E9 |
| 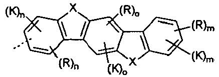 | 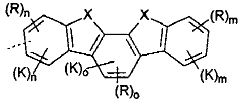 | 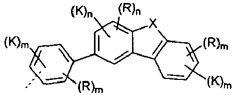 |
| E10 | E11 | E12 |

Die Reste R in den Formeln E1 bis E12 können dabei die gleiche Bedeutung annehmen, wie die Reste R in den Formel (I). K stellt eine anionische Koordinierungsgruppe dar, vorzugsweise eine Gruppe gemäß Formel (K-I) und/oder (K-II). X kann eine Gruppe CR₂, NR, SiR₂, NR, CK₂, NK, SiK₂, CRK, SiRK, O, S, C=O oder (P=O)R, vorzugsweise CR₂, SiR₂, NR, CK₂, NK, SiK₂, CRK, SiRK, O oder S bedeuten, wobei K eine anionische Koordinierungsgruppe darstellt, vorzugsweise eine Gruppe gemäß Formel (K-I) und/oder (K-II), wobei auch hier R die gleiche Bedeutung annehmen kann, wie die Reste R in Bezug auf die Formel (I). Die gestrichelte Linie stellt die Bindungsstelle an die benachbarte Gruppe dar.
Die verwendeten Indices haben die folgende Bedeutung:
m = 0, 1, 2, 3 oder 4;
n = 0, 1, 2 oder 3;
o = 0, 1 oder 2; und
p = 0, 1, 2, 3, 4 oder 5.

Bevorzugte mono- oder polycyclische, aromatische oder heteroaromatische Gruppen Ar¹ und/oder Ar² die zuvor, insbesondere in Formeln (P-I) und/oder (L-P-I) dargestellt sind; Ar⁶, Ar⁷ und/oder Ar⁹ die zuvor, insbesondere in Formeln (P-Vllla), (P-Vlllb), (L-P-Vllla) und/oder (L-P-VIIIb) dargestellt sind; und/oder Ar¹¹ die zuvor, insbesondere in Formel (P-XVII) und/oder (L-PXVII) dargestellt sind; sind folgenden:

| | | |
|---|---|---|
| 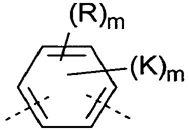 | 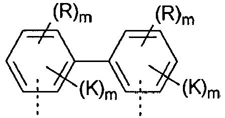 | 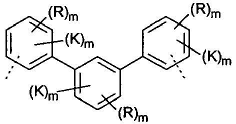 |
| M1 | M2 | M3 |
| 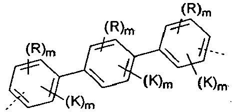 | 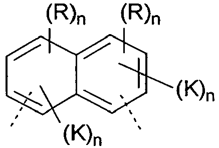 | 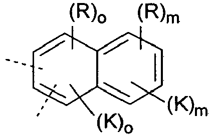 |
| M4 | M5 | M6 |
| 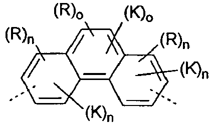 | 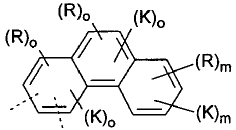 | 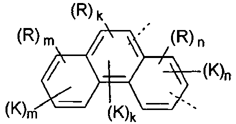 |
| M7 | M8 | M9 |
| 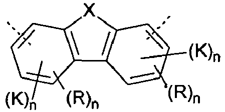 | 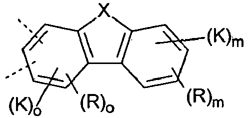 | 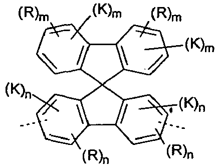 |
| M10 | M11 | M12 |
| 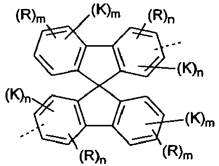 | 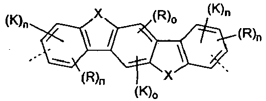 | 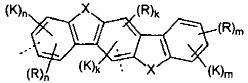 |
| M13 | M14 | M15 |
| 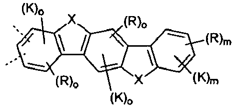 | 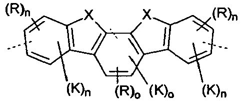 | 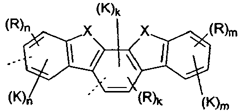 |
| M16 | M17 | M18 |
| 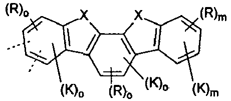 | 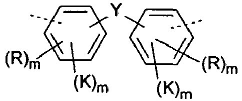 | |
| M19 | M20 | |
| 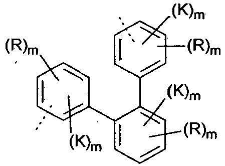 | 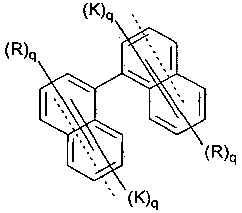 | 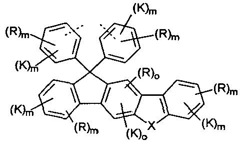 |
| M21 | M22 | M23 |

Die Reste R in den Formeln M1 bis M23 können dabei die gleiche Bedeutung annehmen, wie die Reste R in den Formel (I). K stellt eine anionische Koordinierungsgruppe dar, vorzugsweise eine Gruppe gemäß Formel (K-I) und/oder (K-II). X eine Gruppe CR₂, NR, SiR₂, NR, CK₂, NK, SiK₂, CRK, SiRK, O, S, C=O oder (P=O)R, vorzugsweise CR₂, SiR₂, NR, CK₂, NK, SiK₂, CRK, SiRK, O oder S bedeuten kann, wobei K eine anionische Koordinierungsgruppe darstellt, vorzugsweise eine Gruppe gemäß Formel (K-I) und/oder (K-II), wobei auch hier R die gleiche Bedeutung annehmen kann, wie die Reste R in Bezug auf die Formel (I). Die gestrichelte Linie stellt die Bindungsstelle an die benachbarte Gruppe dar.

Y stellt eine Gruppe CR₂, SiR₂, NR, CK₂, NK, SiK₂, CRK, SiRK, O, S, eine geradkettige oder verzweigte Alkylgruppe mit 1 bis 20 C-Atomen oder eine Alkenyl- oder Alkinylgruppe mit 2 bis 20 C-Atomen dar, die jeweils mit einem oder mehreren Resten R¹ substituiert sein kann, und wobei eine oder mehrere nicht benachbarte CH₂-Gruppen, CH-Gruppen bzw. C-Atome der Alkyl-, Alkenyl- oder Alkinylgruppen durch Si(R¹)₂, C=O, C=S, C=NR¹, P(=O)R¹, SO, SO₂, NR¹, O, S, CONR¹ oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ersetzt sein können; wobei auch hier die Reste R und R¹ die gleichen Bedeutungen annehmen können, wie die Reste R und R¹ in Formel (I) und K eine anionische Koordinierungsgruppe sein kann, vorzugsweise eine Gruppe gemäß Formel (K-I) und/oder (K-II).
Die gestrichelte Linie stellt die Bindungsstelle an die benachbarte Gruppe dar.

Die verwendeten Indices haben die folgende Bedeutung:
k = 0 oder 1;
m = 0, 1, 2, 3 oder 4;
n = 0, 1, 2 oder 3;
o = 0, 1 oder 2; und
q = 0, 1, 2, 3, 4, 5 oder 6.

Besonders bevorzugte mono- oder polycyclische, aromatische oder heteroaromatische Gruppen Ar¹ und Ar² in Formeln (I), (L-I); Ar³ in Formeln (I), (P-I); Ar⁴ in Formeln (la), (Ib), (II), (III), (IV), (V), (VI), (VII), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV), (P-XVI); Ar⁵ und Ar⁸ in Formeln (P-VIIIa) und/oder (P-VIIIb), sowie deren bevorzugten Ausführungsformen sind die folgenden:

| | | |
|---|---|---|
| 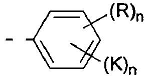 | | |
| E1a | | |
| 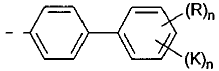 | 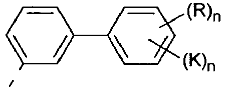 | 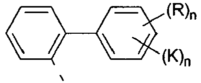 |
| E2a | E2b | E2c |
| 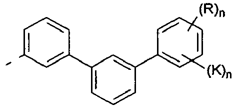 | 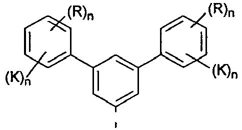 | 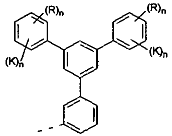 |
| E3a | E4a | E5a |
| 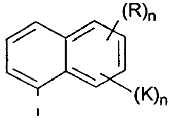 | 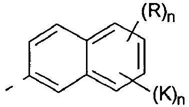 | 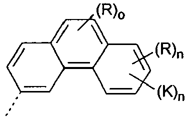 |
| E6a | E6b | E7a |
| 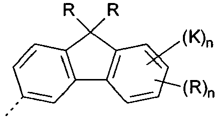 | 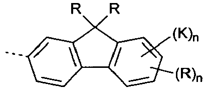 | 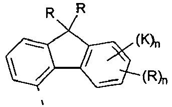 |
| E8a | E8b | E8c |
| 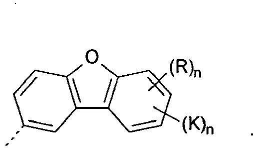 | 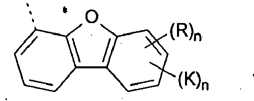 | 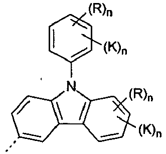 |
| E8d | E8e | E8f |
| 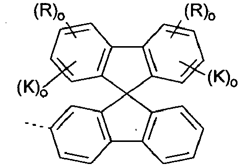 | 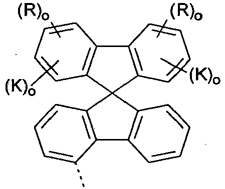 | |
| E9a | E9b | |
| 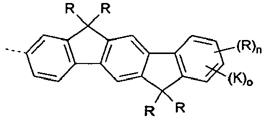 | 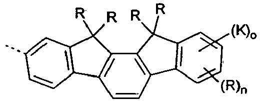 | 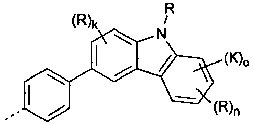 |
| E10a | E11a | E12a |

Die Reste R in den Formeln E1a bis E12a können dabei die gleiche Bedeutung annehmen, wie die Reste R in Formel (I). K stellt eine anionische Koordinierungsgruppe dar, vorzugsweise eine Gruppe gemäß Formel (K-I) und/oder (K-II). X kann eine Gruppe CR₂, NR, SiR₂, NR, CK₂, NK, SiK₂, CRK, SiRK, O, S, C=O oder (P=O)R, vorzugsweise CR₂, SiR₂, NR, CK₂, NK, SiK₂, CRK, SiRK, O oder S bedeuten, wobei K eine anionische Koordinierungsgruppe darstellt, vorzugsweise eine Gruppe gemäß Formel (K-I) und/oder (K-II), wobei auch hier R die gleiche Bedeutung annehmen kann, wie die Reste R in Bezug auf die Formel (I). Die gestrichelte Linie stellt die Bindungsstelle an die benachbarte Gruppe dar.

Die verwendeten Indices haben die folgende Bedeutung:
o = 0 oder 1; und
n = 0, 1, 2 oder 3.

Die Reste R in den Formeln E1a bis E12a, können bei jedem Auftreten, gleich oder verschieden, vorzugsweise H oder eine geradkettige oder verzweigte Alkylgruppe mit 1 bis 12 C-Atomen, vorzugsweise 1 bis 10 C-Atomen darstellen. Besonders bevorzugt sind die Reste R in den Formeln E1a bis E12a Methyl, n-Butyl, sec-Butyl, tert-Butyl, n-Hexyl und n-Octyl.

Besonders bevorzugte mono- oder polycyclische, aromatische oder heteroaromatische Gruppen Ar¹ und/oder Ar² die zuvor, insbesondere in Formeln (P-I) und/oder (L-P-I) dargestellt sind; Ar⁶, Ar⁷ und/oder Ar⁹ die zuvor, insbesondere in Formeln (P-VIIIa), (P-VIIIb), (L-P-VIIIa) und/oder (L-P-VIIIb) dargestellt sind; und/oder Ar¹¹ die zuvor, insbesondere in Formel (P-XVII) und/oder (L-PXVII) dargestellt sind; sind folgenden:

| | | |
|---|---|---|
| 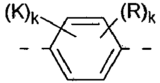 | 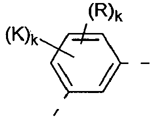 | 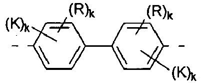 |
| M1a | M1b | M2a |
| 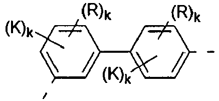 | 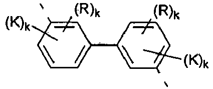 | 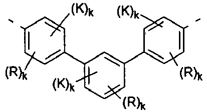 |
| M2b | M2c | M3a |
| 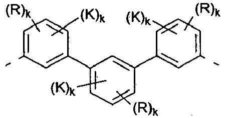 | | |
| M3b | | |
| 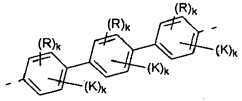 | 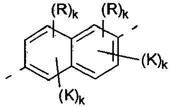 | 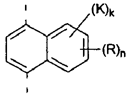 |
| M4a | M5a | M6a |
| 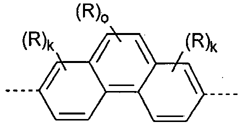 | 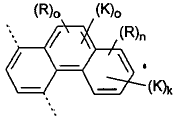 | 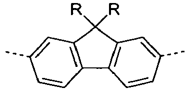 |
| M7a | M8a | M10a |
| 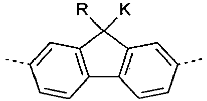 | 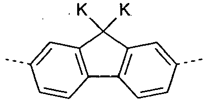 | 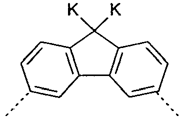 |
| M10b | M10c | M10d |
| 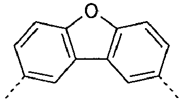 | 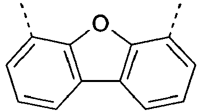 | 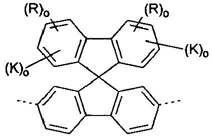 |
| M10e | M10f | M12a |
| 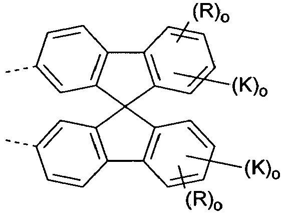 | 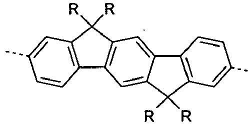 | 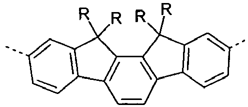 |
| M13a | M14a | M17a |
| 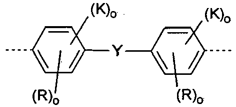 | 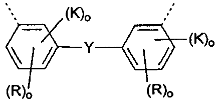 | 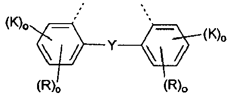 |
| M20a | M20b | M20c |
| 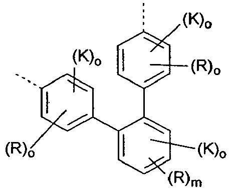 | 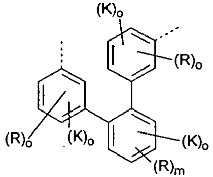 | 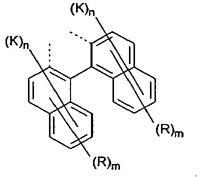 |
| M21a | M21b | M22a |
| 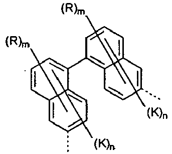 | 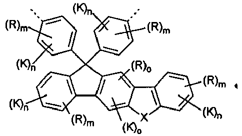 | 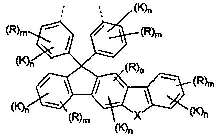 |
| M22b | M23a | M23b |

Die Reste R in den Formeln M1a bis M23b können dabei die gleiche Bedeutung annehmen, wie die Reste R in Formel (I). K stellt eine anionische Koordinierungsgruppe dar, vorzugsweise eine Gruppe gemäß Formel (K-I) und/oder (K-II). X kann eine Gruppe CR₂, NR, SiR₂, NR, CK₂, NK, SiK₂, CRK, SiRK, O, S, C=O oder P=O, vorzugsweise CR₂, SiR₂, NR, CK₂, NK, SiK₂, CRK, SiRK, O oder S bedeuten, wobei K eine anionische Koordinierungsgruppe darstellt, vorzugsweise eine Gruppe gemäß Formel (K-I) und/oder (K-II), wobei auch hier R die gleiche Bedeutung annehmen kann, wie die Reste R in Bezug auf die Formel (I).

Y stellt eine Gruppe CR₂, SiR₂, NR, CK₂, NK, SiK₂, CRK, SiRK, O, S, eine geradkettige oder verzweigte Alkylgruppe mit 1 bis 20 C-Atomen oder eine Alkenyl- oder Alkinylgruppe mit 2 bis 20 C-Atomen dar, die jeweils mit einem oder mehreren Resten R¹ substituiert sein kann, und wobei eine oder mehrere nicht benachbarte CH₂-Gruppen, CH-Gruppen bzw. C-Atome der Alkyl-, Alkenyl- oder Alkinylgruppen durch Si(R¹)₂, C=O, C=S, C=NR¹, P(=O)R¹, SO, SO₂, NR¹, O, S, CONR¹ oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ersetzt sein können; wobei auch hier die Reste R und R¹ die gleichen Bedeutungen annehmen können, wie die Reste R und R¹ in Formel (I) und K eine anionische Koordinierungsgruppe sein kann, vorzugsweise eine Gruppe gemäß Formel (K-I) und/oder (K-II).
Die gestrichelte Linie stellt die Bindungsstelle an die benachbarte Gruppe dar.

Die verwendeten Indices haben die folgende Bedeutung:
k = 0 oder 1;
o = 0, 1 oder 2;
n = 0, 1, 2 oder 3; und
m = 0, 1, 2, 3 oder 4.

Eine Auswahl bevorzugter Strukturelemente der Formel (I) und/oder Struktureinheiten der Formel (P-I) ist in der folgenden Tabelle 1 aufgeführt.

**Tabelle 1**

| Formel (I) | Ar¹ | Ar² | Ar³ |
|---|---|---|---|
| I1 | M1 | M1 | E1 |
| I2 | M2 | M2 | E1 |
| I3 | M10 | M10 | E1 |
| I4 | M12 | M12 | E1 |
| I5 | M14 | M14 | E1 |
| I6 | M19 | M19 | E1 |
| I7 | M1 | M1 | E2 |
| I8 | M1 | M2 | E2 |
| I9 | M7 | M7 | E2 |
| I10 | M12 | M12 | E2 |
| I11 | M13 | M13 | E2 |
| I12 | M1 | M1 | E3 |
| I13 | M13 | M13 | E3 |
| I14 | M1 | M1 | E4 |
| I15 | M2 | M2 | E4 |
| I16 | M14 | M14 | E4 |
| I17 | M3 | M3 | E5 |
| I18 | M12 | M12 | E5 |
| I19 | M6 | M6 | E6 |
| I20 | M10 | M10 | E6 |
| I21 | M16 | M16 | E6 |
| I22 | M2 | M2 | E7 |
| I23 | M15 | M15 | E7 |
| I24 | M1 | M1 | E8 |
| I25 | M2 | M2 | E8 |
| I26 | M4 | M4 | E8 |
| I27 | M5 | M5 | E8 |
| I28 | M10 | M10 | E8 |
| I29 | M12 | M12 | E8 |
| I30 | M14 | M14 | E8 |
| I31 | M1 | M1 | E9 |
| I32 | M8 | M8 | E9 |
| I33 | M13 | M13 | E9 |
| I34 | M10 | M10 | E10 |
| I35 | M9 | M9 | E11 |
| I36 | M17 | M17 | E11 |
| I37 | M7 | M7 | E12 |
| I38 | M18 | M18 | E12 |
| I39 | M23 | M23 | E1 |
| I40 | M1 | M21 | E2 |
| I41 | M20 | M20 | E8 |
| I42 | M22 | M22 | E9 |

Besonders bevorzugt als Strukturelemente der Formel (I) und/oder Struktureinheiten der Formel (P-I) sind Struktureinheiten in denen Ar³ ausgewählt ist aus den Gruppen der Formeln E1a bis E12a und Ar¹ sowie Ar² ausgewählt sind aus den Gruppen der Formeln M1a bis M17a, wobei es besonders bevorzugt ist, wenn Ar¹ und Ar² gleich sind.

Eine Auswahl besonders bevorzugter Strukturelemente der Formel (I) und/oder Struktureinheiten der Formel (P-I) ist in der folgenden Tabelle 2 aufgeführt.

**Tabelle 2**

| Formel (I) | Ar¹ | Ar² | Ar³ |
|---|---|---|---|
| I1a | M1a | M1a | E1a |
| I2a | M2a | M2a | E1a |
| I2b | M2c | M2c | E1a |
| I3a | M10a | M10a | E1a |
| I4a | M12a | M12a | E1a |
| I5a | M14a | M14a | E1a |
| I7a | M1b | M1b | E2a |
| I7b | M1a | M1a | E2c |
| I8a | M1a | M2c | E2c |
| I9a | M7a | M7a | E2b |
| I10a | M12a | M12a | E2a |
| I11a | M13a | M13a | E2a |
| I12a | M1b | M1b | E3a |
| I13a | M13a | M13a | E3a |
| I14a | M1a | M1a | E4a |
| I15a | M2a | M2a | E4a |
| I15b | M2b | M2b | E4a |
| I16a | M14a | M14a | E4a |
| I17a | M3a | M3a | E5a |
| I18a | M12a | M12a | E5a |
| I19a | M6a | M6a | E6a |
| I20a | M10b | M10b | E6b |
| I22a | M2a | M2a | E7a |
| I24a | M1a | M1a | E8a |
| I24b | M1b | M1b | E8b |
| I24c | M1a | M1a | E8e |
| I24d | M1b | M1b | E8f |
| I25a | M2c | M2c | E8a |
| I25b | M2b | M2b | E8b |
| I25c | M2c | M2c | E8f |
| I26a | M4a | M4a | E8c |
| I27a | M5a | M5a | E8d |
| I28a | M10a | M10a | E8c |
| I29a | M12a | M12a | E8b |
| I30a | M14a | M14a | E8e |
| I31a | M1a | M1a | E9b |
| I32a | M8a | M8a | E9a |
| I33a | M13a | M13a | E9a |
| I34a | M10c | M10c | E10a |
| I36a | M17a | M17a | E11a |
| I37a | M7a | M7a | E12a |
| I39a | M23a | M23a | E1a |
| I39b | M23b | M23b | E1a |
| I40a | M1a | M21a | E2c |
| I40b | M1b | M21a | E2a |
| I41a | M20a | M20a | E8b |
| I41b | M20b | M20b | E8c |

Besonders bevorzugt als Struktureinheiten der Formel (P-VIIIa) sind Struktureinheiten in denen Ar⁵ und Ar⁸, unabhängig voneinander, gleich oder verschieden, ausgewählt sind aus den Gruppen der Formeln E1 bis E12 und Ar⁵, Ar⁷ sowie Ar⁹, unabhängig voneinander, gleich oder verschieden, ausgewählt sind aus den Gruppen der Formeln M1 bis M19, wobei es besonders bevorzugt ist, wenn Ar⁵ und Ar⁸ bzw. Ar⁶ und Ar⁷ gleich sind.

Besonders bevorzugt als Struktureinheiten der Formel (P-VIIIb) sind Struktureinheiten in denen Ar⁵ und Ar⁸, unabhängig voneinander, gleich oder verschieden, ausgewählt sind aus den Gruppen der Formeln E1 bis E12 und Ar⁵, Ar⁷ sowie Ar⁹, unabhängig voneinander, gleich oder verschieden, ausgewählt sind aus den Gruppen der Formeln M1 bis M19, wobei es besonders bevorzugt ist, wenn Ar⁵ und Ar⁸ bzw. Ar⁶ und Ar⁷ gleich sind.

Eine Auswahl bevorzugter Struktureinheiten der Formeln (P-Vllla) und(P-Vlllb) ist in der folgenden Tabelle 3 aufgeführt.

**Tabelle 3**

| Formel (P-VIIIa) | Ar⁵ | Ar⁶ | Ar⁷ | Ar⁸ | Ar⁹ |
|---|---|---|---|---|---|
| Formel (P-VIIIb) | Ar⁵ | Ar⁶ | Ar⁷ | Ar⁸ | Ar⁹ |
| P-VIII1 | E1 | M1 | M1 | E1 | M1 |
| P-VIII2 | E1 | M1 | M1 | E1 | M2 |
| P-VIII3 | E1 | M1 | M1 | E1 | M10 |
| P-VIII4 | E1 | M1 | M1 | E1 | M13 |
| P-VIII5 | E1 | M1 | M1 | E1 | M14 |
| P-VIII6 | E1 | M14 | M14 | E1 | M12 |
| P-VIII7 | E2 | M1 | M1 | E2 | M2 |
| P-VIII8 | E2 | M2 | M2 | E2 | M12 |
| P-VIII9 | E3 | M7 | M7 | E3 | M1 |
| P-VIII10 | E3 | M10 | M10 | E3 | M16 |
| P-VIII11 | E4 | M1 | M1 | E4 | M7 |
| P-VIII12 | E4 | M1 | M1 | E4 | M12 |
| P-VIII13 | E4 | M2 | M2 | E4 | M14 |
| P-VIII14 | E4 | M10 | M10 | E4 | M13 |
| P-VIII15 | E4 | M1 | M1 | E8 | M7 |
| P-VIII16 | E5 | M2 | M13 | E5 | M13 |
| P-VIII17 | E6 | M3 | M3 | E6 | M6 |
| P-VIII18 | E6 | M17 | M17 | E6 | M10 |
| P-VIII19 | E7 | M5 | M5 | E7 | M4 |
| P-VIII20 | E8 | M1 | M1 | E8 | M1 |
| P-VIII21 | E8 | M1 | M1 | E8 | M2 |
| P-VIII22 | E8 | M1 | M1 | E8 | M12 |
| P-VIII23 | E8 | M2 | M2 | E8 | M10 |
| P-VIII24 | E8 | M6 | M6 | E8 | M8 |
| P-VIII25 | E8 | M10 | M10 | E8 | M7 |
| P-VIII26 | E8 | M13 | M13 | E8 | M2 |
| P-VIII27 | E8 | M14 | M14 | E8 | M12 |
| P-VIII28 | E9 | M1 | M1 | E9 | M2 |
| P-VIII29 | E9 | M9 | M9 | E9 | M11 |
| P-VIII30 | E9 | M19 | M19 | E9 | M18 |
| P-VIII31 | E10 | M1 | M1 | E10 | M4 |
| P-VIII32 | E11 | M2 | M2 | E11 | M10 |
| P-VIII33 | E11 | M13 | M13 | E11 | M15 |
| P-VIII34 | E12 | M7 | M7 | E12 | M14 |
| VIII35 | E2 | M1 | M1 | E2 | M14 |
| VIII36 | E2 | M1 | M1 | E2 | M12 |
| VIII37 | E8 | M1 | M1 | E8 | M20 |
| VIII38 | E9 | M1 | M1 | E9 | M23 |

Besonders bevorzugt als Struktureinheiten der Formel (P-VIIIa) sind Struktureinheiten in denen Ar⁵ und Ar⁸, unabhängig voneinander, gleich oder verschieden, ausgewählt sind aus den Gruppen der Formeln E1a bis E12a und Ar⁵, Ar⁷ sowie Ar⁹, unabhängig voneinander, gleich oder verschieden, ausgewählt sind aus den Gruppen der Formeln M1a bis M17a, wobei es besonders bevorzugt ist, wenn Ar⁵ und Ar⁸ bzw. Ar⁶ und Ar⁷ gleich sind.

Besonders bevorzugt als Struktureinheiten der Formel (P-Vlllb) sind Struktureinheiten in denen Ar⁵ und Ar⁸, unabhängig voneinander, gleich oder verschieden, ausgewählt sind aus den Gruppen der Formeln E1a bis E12a und Ar⁵, Ar⁷ sowie Ar⁹, unabhängig voneinander, gleich oder verschieden, ausgewählt sind aus den Gruppen der Formeln M1a bis M17a, wobei es besonders bevorzugt ist, wenn Ar⁵ und Ar⁸ bzw. Ar⁶ und Ar⁷ gleich sind.

Eine Auswahl besonders bevorzugter Struktureinheiten der Formel (P-Vllla) bzw. (P-VIIIb) ist in der folgenden Tabelle 4 aufgeführt.

**Tabelle 4**

| Formel (P-VIIIa) | Ar⁵ | Ar⁶ | Ar⁷ | Ar⁸ | Ar⁹ |
|---|---|---|---|---|---|
| Formel (P-VIIIb) | Ar⁵ | Ar⁶ | Ar⁷ | Ar⁸ | Ar⁹ |
| P-VIII1a | E1a | M1a | M1a | E1a | M1a |
| P-VIII1b | E1a | M1b | M1b | E1a | M1b |
| P-VIII2a | E1a | M1a | M1a | E1a | M2a |
| P-VIII3a | E1a | M1a | M1a | E1a | M10a |
| P-VIII4a | E1a | M1a | M1a | E1a | M13a |
| P-VIII4b | E1a | M1b | M1b | E1a | M13a |
| P-VIII5a | E1a | M1a | M1a | E1a | M14a |
| P-VIII6a | E1a | M14a | M14a | E1a | M12a |
| P-VIII7a | E2a | M1a | M1a | E2a | M2a |
| P-VIII7b | E2c | M1a | M1a | E2c | M2a |
| P-VIII8a | E2b | M2b | M2b | E2b | M12a |
| P-VIII9a | E3a | M7a | M7a | E3a | M1b |
| P-VIII11a | E4a | M1b | M1b | E4a | M7a |
| P-VIII12a | E4a | M1b | M1b | E4a | M12a |
| P-VIII13a | E4a | M2b | M2b | E4a | M14a |
| P-VIII14a | E4a | M10a | M10a | E4a | M13a |
| P-VIII15a | E4a | M1b | M1b | E8a | M7a |
| P-VIII16a | E5a | M2c | M13a | E5a | M13a |
| P-VIII17a | E6a | M3a | M3a | E6a | M6a |
| P-VIII18a | E6b | M17a | M17a | E6b | M10b |
| P-VIII19a | E7a | M5a | M5a | E7a | M4a |
| P-VIII20a | E8f | M1a | M1a | E8f | M1a |
| P-VIII21a | E8b | M1a | M1a | E8b | M2a |
| P-VIII21b | E8e | M1a | M1a | E8e | M2a |
| P-VIII22a | E8b | M1b | M1b | E8b | M12a |
| P-VIII23a | E8d | M2b | M2b | E8d | M10c |
| P-VIII24a | E8f | M6a | M6a | E8f | M8a |
| P-VIII25a | E8a | M10a | M10a | E8a | M7a |
| P-VIII26a | E8c | M13a | M13a | E8c | M2c |
| P-VIII27a | E8b | M14a | M14a | E8b | M12a |
| P-VIII28a | E9a | M1a | M1a | E9a | M2a |
| P-VIII28b | E9b | M1a | M1a | E9b | M2a |
| P-VIII31a | E10a | M1b | M1b | E10a | M4a |
| P-VIII32a | E11a | M2c | M2c | E11a | M10c |
| P-VIII34a | E12a | M7a | M7a | E12a | M14a |
| P-VIII35a | E2a | M1a | M1a | E2a | M14a |
| P-VIII35b | E2c | M1a | M1a | E2c | M14a |
| P-VIII36a | E2c | M1a | M1a | E2c | M12a |
| P-VIII37a | E8b | M1a | M1a | E8b | M20a |
| P-VIII37b | E8e | M1a | M1a | E8e | M20b |
| P-VIII38a | E9a | M1b | M1b | E9a | M23a |
| P-VIII38b | E9b | M1b | M1b | E9b | M23b |

Der Anteil an Struktureinheiten der Formeln (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) im Polymer liegt bevorzugt im Bereich von 1 bis 100 mol%, vorzugsweise im Bereich von 25 bis 100 mol%, besonders bevorzugt im Bereich von 50 bis 95 mol%, bezogen auf 100 mol% aller copolymerisierten Monomere, die im Polymer als Struktureinheiten enthalten sind.

Bevorzugt als Struktureinheiten der folgenden Formel (P-XVII) sind Struktureinheiten in denen Ar¹¹ ausgewählt ist aus den Gruppen der Formeln M1 bis M23, wie in der folgenden Tabelle 5 aufgeführt.

**Tabelle 5**

| Formel (P-XVII) | Ar¹¹ |
|---|---|
| P-XVII1 | M1 |
| P-XVII2 | M2 |
| P-XVII3 | M3 |
| P-XVII4 | M4 |
| P-XVII5 | M5 |
| P-XVII6 | M6 |
| P-XVII7 | M7 |
| P-XVII8 | M8 |
| P-XVII9 | M9 |
| P-XVII10 | M10 |
| P-XVII11 | M1 1 |
| P-XVII12 | M12 |
| P-XVII13 | M13 |
| P-XVII14 | M14 |
| P-XVII15 | M15 |
| P-XVII16 | M16 |
| P-XVII17 | M17 |
| P-XVII18 | M18 |
| P-XVII19 | M19 |
| P-XVII20 | M20 |
| P-XVII21 | M21 |
| P-XVII22 | M22 |
| P-XVII23 | M23 |

Besonders bevorzugt als Struktureinheiten der Formel (P-XVII) sind Struktureinheiten in denen Ar¹¹ ausgewählt ist aus den Gruppen der Formeln M1a bis M23a, wie in der folgenden Tabelle 6 aufgeführt.

**Tabelle 6**

| Formel (P-XVII) | Ar¹¹ |
|---|---|
| P-XVII1a | M1a |
| P-XVII1b | M1b |
| P-XVII2a | M2a |
| P-XVII2b | M2b |
| P-XVII2c | M2c |
| P-XVII3a | M3a |
| P-XVII4a | M4a |
| P-XVII5a | M5a |
| P-XVII6a | M6a |
| P-XVII7a | M7a |
| P-XVII8a | M8a |
| P-XVII10a | M10a |
| P-XVII10b | M10b |
| P-XVII10c | M10c |
| P-XVII12a | M12a |
| P-XVII13a | M13a |
| P-XVII14a | M14a |
| P-XVII17a | M17a |
| P-XVII20a | M20a |
| P-XVII20b | M20b |
| P-XVII20c | M20c |
| P-XVII21a | M21a |
| P-XVII21b | M21b |
| P-XVII22a | M22a |
| P-XVII22b | M22b |
| P-XVII23a | M23a |
| P-XVII23b | M23b |

Die weiteren Struktureinheiten können beispielsweise aus den folgenden Klassen stammen:

| | |
|---|---|
| Gruppe 1: | Einheiten, welche die Lochinjektions- und/oder Lochtransporteigenschaften der Polymere beeinflussen; |
| Gruppe 2: | Einheiten, welche die Elektroneninjektions- und/oder Elektronentransporteigenschaften der Polymere beeinflussen; |
| Gruppe 3: | Einheiten, die Kombinationen von Einzeleinheiten der Gruppe 1 und Gruppe 2 aufweisen; |
| Gruppe 4: | Einheiten, welche die Emissionscharakteristik insoweit verändern, dass Elektrophosphoreszenz statt Elektrofluoreszenz erhalten werden kann; |
| Gruppe 5: | Einheiten, welche den Übergang vom Singulett- zum Triplettzustand verbessern; |
| Gruppe 6: | Einheiten, welche die Emissionsfarbe der resultierenden Polymere beeinflussen; |
| Gruppe 7: | Einheiten, welche typischerweise als Polymergrundgerüst (Backbone) verwendet werden; |
| Gruppe 8: | Einheiten, welche die Filmmorphologie und/oder die rheologischen Eigenschaften der resultierenden Polymere beeinflussen. |

Bevorzugte erfindungsgemäße Polymere sind solche, bei denen mindestens eine Struktureinheit Ladungstransporteigenschaften aufweist, d.h. die Einheiten aus der Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen.
Bevorzugte Struktureinheiten aus der Gruppe 1 sind die Struktureinheiten der folgenden Formeln (1a) bis (1q):

| | | |
|---|---|---|
| 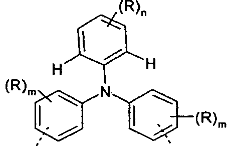 | 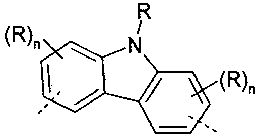 | |
| (1a) | (1b) | |
| 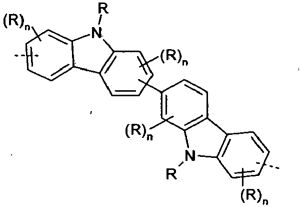 | 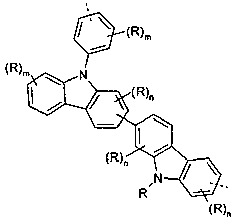 | 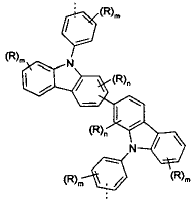 |
| (1c) | (1d) | (1e) |
| 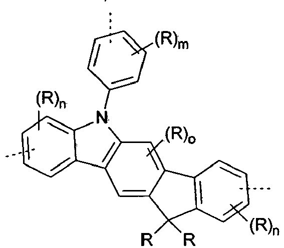 | 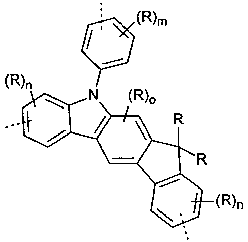 | |
| (1f) | (1g) | |
| 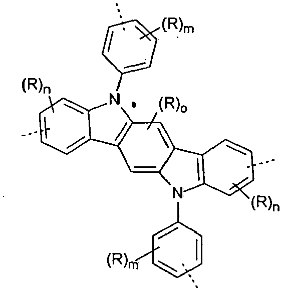 | 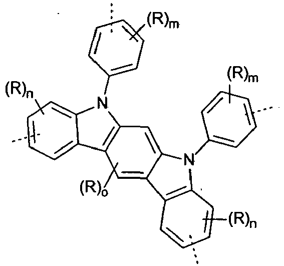 | |
| (1h) | (1i) | |
| 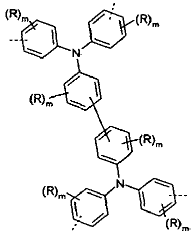 | 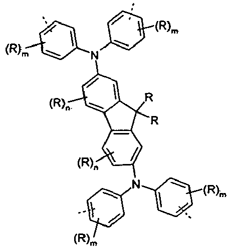 | 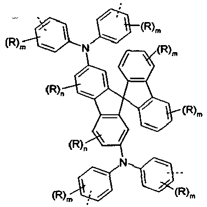 |
| (1j) | (1k) | (1m) |
| 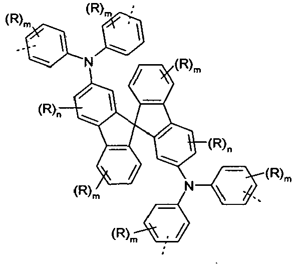 | 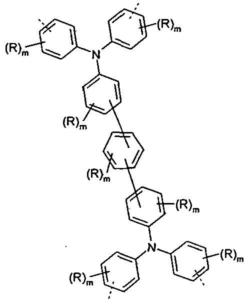 | 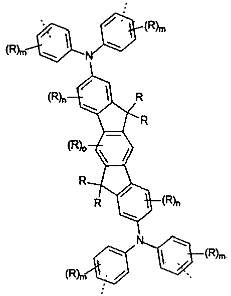 |
| (1n) | (1p) | (1q) |

wobei R, m, n und o die oben angegebenen Bedeutungen annehmen können.

In den Formeln (1a) bis (1q) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf. Sofern in den Formeln drei gestrichelte Linien vorhanden sind, weist die Struktureinheit ein, zwei oder drei, vorzugsweise zwei, Bindungen zu benachbarten Struktureinheiten auf.

Sofern in den Formeln vier gestrichelte Linien vorhanden sind, weist die Struktureinheit ein, zwei, drei oder vier, vorzugsweise zwei, Bindungen zu benachbarten Struktureinheiten auf. Sie können dabei unabhängig voneinander, gleich oder verschieden, in ortho-, meta- oder para-Position angeordnet sein.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o. g. Bedingung erfüllen. Besonders bevorzugt sind hier entsprechende Struktureinheiten, welche Elemente der Gruppen 8 bis 10 (Ru, Os, Rh, Ir, Pd, Pt) enthalten. Als Struktureinheiten für die erfindungsgemäß einsetzbaren Polymere kommen hier z.B. verschiedene Komplexe in Frage, wie sie z.B. in der WO 02/068435 A1, der WO 02/081488 A1, der EP 1239526 A2 und der WO 2004/026886 A2 beschrieben werden. Entsprechende Monomere werden in der WO 02/068435 A1 und in der WO 2005/042548 A1 beschrieben.

Struktureinheiten der Gruppe 5 sind solche, welche den Übergang vom Singulett- zum Triplettzustand verbessern und welche, unterstützend zu den Strukturelementen der Gruppe 4 eingesetzt, die Phosphoreszenz-Eigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Struktureinheiten der Gruppe 6 sind neben den oben genannten solche, die mindestens noch eine weitere aromatische oder eine andere konjugierte Struktur aufweisen, welche nicht unter die o. g. Gruppen fallen, d. h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylarylenderivate, die jeweils mit einem oder mehreren Resten R substituiert sein können. Besonders bevorzugt ist dabei der Einbau von 1,4- oder 9,10-Anthrylen-, 1,6-, 2,7- oder 4,9-Pyrenylen-, 3,9- oder 3,10-Perylenylen-, 4,4'-Tolanylen-, 4,4'-Stilbenylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis- und trans-Indenofluorenderivate aber auch 1,2-, 1,3- oder 1,4-Phenylen-, 1,2-, 1,3- oder 1,4-Naphthylen-, 2,2'-, 3,3'- oder 4,4'-Biphenylylen-, 2,2"-, 3,3"- oder 4,4"-Terphenylylen, 2,2'-, 3,3'- oder 4,4'-Bi-1,1'-naphthylylen- oder 2,2'''-, 3,3'''- oder 4,4'''-Quarterphenylylenderivate.

Bevorzugte Struktureinheiten aus der Gruppe 7 sind die Struktureinheiten der folgenden Formeln (7a) bis (7o):

| | | |
|---|---|---|
| 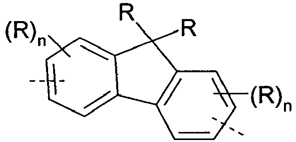 | 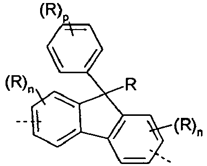 | 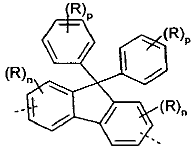 |
| (7a) | (7b) | (7c) |
| 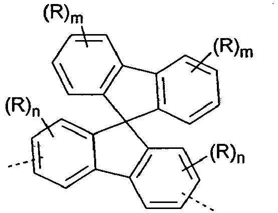 | 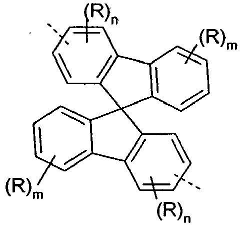 | |
| (7d) | (7e) | |
| 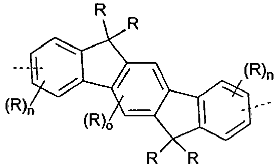 | 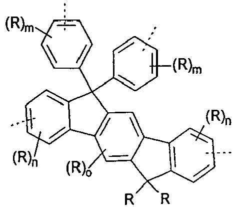 | 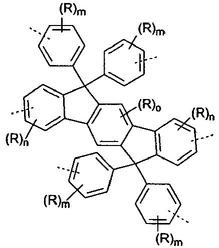 |
| (7f) | (7g) | (7h) |
| 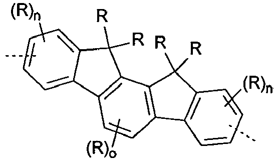 | 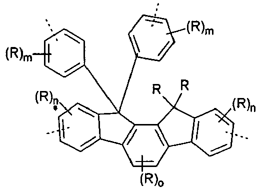 | |
| (7i) | (7j) | |
| 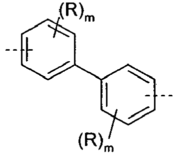 | 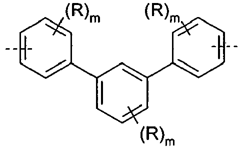 | |
| (7k) | (7m) | |
| 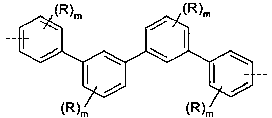 | 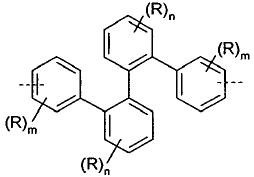 | |
| (7n) | (7o) | |

wobei R, m, n, o und p die oben angegebenen Bedeutungen annehmen können.

In den Formeln (7a) bis (7o) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf. Sofern in den Formeln vier oder mehr gestrichelte Linien vorhanden sind (Formeln (7g), (7h) und (7j)), weisen die Struktureinheiten ein, zwei, drei oder vier, vorzugsweise zwei, Bindungen zu benachbarten Struktureinheiten auf. Sie können dabei unabhängig voneinander, gleich oder verschieden, in ortho-, meta- oder para-Position angeordnet sein.

Struktureinheiten der Gruppe 8 sind solche, die die Filmmorphologie und/oder die rheologischen Eigenschaften der Polymere beeinflussen, wie z.B. Siloxane, Alkylketten oder fluorierte Gruppen, aber auch besonders steife oder flexible Einheiten, flüssigkristallbildende Einheiten oder vernetzbare Gruppen.

Bevorzugt sind erfindungsgemäße Polymere, die gleichzeitig neben Struktureinheiten der Formel (I), (Ia), (Ib), (II), (III), (IV), (V), (VI), (VII), (VIIIa), (VIIIb), (IX), (X), (XI), (XII), (XIII), (XIV), (XV) und/oder (XVI) zusätzlich noch ein oder mehrere Einheiten ausgewählt aus den Gruppen 1 bis 8 enthalten. Es kann ebenfalls bevorzugt sein, wenn gleichzeitig mehr als eine weitere Struktureinheit aus einer Gruppe vorliegt.

Bevorzugt sind dabei erfindungsgemäße Polymere, die neben mindestens einer Struktureinheit der Formel (I), (la), (Ib), (II), (III), (IV), (V), (VI), (VII), (VIIIa), (VIIIb), (IX), (X), (XI), (XII), (XIII), (XIV), (XV) und/oder (XVI) noch Einheiten aus der Gruppe 7 enthalten.

Ebenfalls bevorzugt ist es, wenn die erfindungsgemäß einsetzbaren Polymere Einheiten enthalten, die den Ladungstransport oder die Ladungsinjektion verbessern, also Einheiten aus der Gruppe 1 und/oder 2.

Besonders bevorzugt ist es weiterhin, wenn die erfindungsgemäß einsetzbaren Polymere Struktureinheiten aus der Gruppe 7 und Einheiten aus der Gruppe 1 und/oder 2 enthalten.

Die erfindungsgemäß einsetzbaren Polymere sind entweder Homopolymere aus Struktureinheiten der Formel (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) oder Copolymere. Die erfindungsgemäß einsetzbaren Polymere können linear oder verzweigt sein, vorzugsweise linear. Erfindungsgemäße Copolymere können dabei neben einer oder mehreren Struktureinheiten der Formel ((P-I), (P-Ia), (P-Ib), (P-II), (P-III), (P-IV), (P-V), (P-VI), (P-VII), (P-VIIIa), (P-Vlllb), (P-IX), (P-X), (P-XI), (P-XII), (P-XIII), (P-XIV), (P-XV) und/oder (P-XVI) potentiell eine oder mehrere weitere Strukturen aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Besonders bevorzugt weisen die erfindungsgemäßen Copolymere statistische oder alternierende Strukturen auf. Besonders bevorzugt sind die Copolymere statistische oder alternierende Copolymere. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Ebenso sei an dieser Stelle nochmals hervorgehoben, dass das Polymer auch dendritische Strukturen haben kann.

Die erfindungsgemäß einsetzbaren Polymere enthaltend Struktureinheiten der Formel (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) werden in der Regel durch Polymerisation von einer oder mehreren Monomersorten hergestellt, von denen mindestens ein Monomer im Polymer zu Struktureinheiten der Formel (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation;
(B) YAMAMOTO-Polymerisation;
(C) STILLE-Polymerisation;
(D) HECK-Polymerisation;
(E) NEGISHI-Polymerisation;
(F) SONOGASHIRA-Polymerisation;
(G) HIYAMA-Polymerisation; und
(H) HARTWIG-BUCHWALD-Polymerisation.
Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Zur Synthese der erfindungsgemäß einsetzbaren Polymere können die entsprechenden Monomere der Formel (MI) eingesetzt werden, 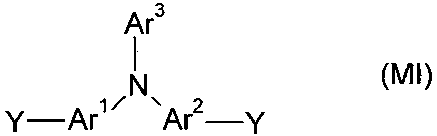 wobei Ar¹, Ar² und Ar³ die in Bezug auf die Struktureinheit der Formel (I) angegebenen Bedeutungen annehmen kann.

Die Monomere der Formel (MI), die in den erfindungsgemäßen Polymeren zu Struktureinheiten der Formel (P-I) führen, sind Verbindungen, die entsprechend substituiert sind und an zwei Positionen geeignete Funktionalitäten aufweisen, die es erlauben, diese Monomereinheit in das Polymer einzubauen. Diese Monomere der Formel (MI) sind somit ebenfalls Gegenstand der vorliegenden Erfindung. Die Gruppe Y stellt, gleich oder verschieden, eine für eine Polymerisationsreaktion geeignete Abgangsgruppe dar, so dass der Einbau der Monomerbausteine in polymere Verbindungen ermöglicht wird. Vorzugsweise stellt Y eine chemische Funktionalität dar, welche gleich oder verschieden ausgewählt ist aus der Klasse der Halogene, O-Tosylate, O-Triflate, O-Sulfonate, Borsäureester, teilfluorierten Silylgruppen, Diazoniumgruppen und zinnorganischen Verbindungen.

Entsprechende Monomere zur Herstellung von Struktureinheiten der Formeln (P-VIIIa) und/oder (P-VIIIb) ergeben sich entsprechend durch Ersatz der gestrichelten Linien durch Abgangsgruppen Y, wie für Formel (MI) definiert.

Die erfindungsgemäß als Liganden einzusetzenden Polymere können hierbei aus Monomeren aufgebaut sein, die die zuvor dargelegten anionischen Koordinierungsgruppen umfassen. Weiterhin können die Endgruppen der Polymere anionische Koordinierungsgruppen aufweisen.

Das Grundgerüst der Monomerverbindungen lässt sich nach Standardmethoden funktionalisieren, beispielsweise durch Friedel-Crafts-Alkylierung oder -Acylierung. Weiterhin lässt sich das Grundgerüst nach Standardmethoden der organischen Chemie halogenieren. Die halogenierten Verbindungen lassen sich in zusätzlichen Funktionalisierungsschritten wahlweise weiter umsetzen. Beispielsweise können die halogenierten Verbindungen entweder direkt oder nach Überführung in ein Boronsäurederivat oder zinnorganisches Derivat als Ausgangsstoffe für die Umsetzung zu Polymeren, Oligomeren oder Dendrimeren eingesetzt werden.

Die genannten Methoden stellen lediglich eine Auswahl aus den dem Fachmann bekannten Reaktionen dar, welche dieser, ohne erfinderisch tätig zu werden, zur Synthese der erfindungsgemäßen Verbindungen einsetzen kann.

Die erfindungsgemäß einsetzbaren Polymere können als Reinsubstanz, aber auch als Mischung zusammen mit weiteren beliebigen polymeren, oligomeren, dendritischen oder niedermolekularen Substanzen verwendet werden. Als niedermolekulare Substanz versteht man in der vorliegenden Erfindung Verbindungen mit einem Molekulargewicht im Bereich von 100 bis 3000 g/mol, vorzugsweise 200 bis 2000 g/mol. Diese weiteren Substanzen können z.B. die elektronischen Eigenschaften verbessern oder selbst emittieren. Als Mischung wird vor- und nachstehend eine Mischung enthaltend mindestens eine polymere Komponente bezeichnet. Auf diese Art können eine oder mehrere Polymerschichten bestehend aus einer Mischung (Blend) aus einem oder mehreren erfindungsgemäßen Polymeren mit einer Struktureinheit der Formel (P-I), (P-Ia), (P-Ib), (P-II), (P-III), (P-IV), (P-V), (P-VI), (P-VII), (P-VIIIa), (P-VIIIb), (P-IX), (P-X), (P-XI), (P-XII), (P-XIII), (P-XIV), (P-XV) und/oder (P-XVI) und optional einem oder mehreren weiteren Polymeren mit einer oder mehreren niedermolekularen Substanzen hergestellt werden.

Unter dem Begriff "Hauptgruppen-Metallkomplex der Gruppen 13 bis 15" werden die Metalle der 13. bis 15. Gruppe It. IUPAC, d.h Aluminium, Gallium, Indium, Silizium, Germanium, Zinn, Blei, Thallium, Arsen, Antimon, Bismut oder Mischungen daraus verstanden. Bevorzugt sind die Metalle der Gruppe 14 und 15, d.h. Silizium, Germanium, Zinn, Blei, Arsen, Antimon, Bismut, besonders bevorzugt Zinn und/oder Bismut, speziell bevorzugt Bismut.

In der vorliegenden Erfindung ist das Metallatom Bismut.

Gemäß einer bevorzugten Ausführungsform ist der Metallkomplex ein mono- oder bi- oder polynuklearer Metallkomplex. Insbesondere kann der Metallkomplex im Festkörper als polynuklearer Metallkomplex vorliegen.

Gemäß einer bevorzugten Ausführungsform ist mindestens einer der Liganden L zwischen zwei Metallen verbrückend angeordnet.

Gemäß einer bevorzugten Ausführungsform kann der Metallkomplex die Summenformel M₂L₄, (mit M = Metall und L = Ligand) besitzen, wobei sowohl die Metalle wie die einzelnen Liganden unabhängig voneinander gemäß der obigen Definition ausgewählt sein können.

Ferner kann vorgesehen sein, dass der Metallkomplex die Struktur die Struktur MLm, aufweist, wobei M = Metallatom, L = Ligand und m = 1 bis 10 und für den Fall, dass m > 1 ist, alle L unabhängig voneinander sind. Diese Metallkomplexe sind insbesondere bei Bismut bevorzugt; in diesem Fall ist m bevorzugt m = 2, 4, und 3 oder 5 für Bismut, je nach Oxidationsstufe.

Gemäß einer alternativen Ausführungsform der Erfindung ist besitzt der Metallkomplex die Struktur ML₂L'ₙ, mit M = Metall, L = Ligand, wie oben definiert und L' = ein zu L nicht 15 identischer Ligand ausgewählt aus der Gruppe Aryl, Heteroaryl, Halogenaryl und Halogenheteroaryl, wobei n von 0 bis 3 betragen kann und für den Fall, dass n > 1 ist, jedes L' unabhängig von den anderen ausgewählt ist. Diese Metallkomplexe sind insbesondere bei Bismut bevorzugt; in diesem 20 Fall ist n = 1 oder 3 für Bismut, je nach Oxidationsstufe sowie n = 0 bevorzugt.

Der Hauptgruppenmetallkomplex enthält Bismut. Hierbei sind besonders bevorzugt Bismut- Hauptgruppenmetallkomplexe: Der Oxidationsstufen II, welcher ohne durch die Theorie gebunden als Funktion der gewählten Liganden eine paddle-wheel-Struktur aufweisen können.

Der Oxidationsstufe III (MLₙ = 3), welche ohne durch die Theorie gebunden zu sein, keine paddle-wheel-Struktur aufweisen. Diese Verbindungen liegen in der Regel Festkörper mono- bis poly-nuklear vor.

Der Oxidationsstufe V, in welcher in einer besonderen Ausführungsform der Hauptgruppenmetallkomplex Bismut der Oxidationsstufe V den in WO 2013/182389 A2 näher beschriebenen Aufbau aufweisen kann.

Die zuvor dargelegten Strukturen und Formeln des Metallkomplexes beziehen sich teilweise auf einen nicht-vernetzten Komplex, d. h. einen Komplex, bei dem der Ligand nur mit einem Metallatom verbunden ist. Vorzugsweise kann der Metallkomplex vernetzt vorliegen. In diesen Ausführungsformen können die zuvor für einen nicht-vernetzten Komplex dargelegten Strukturen als Partialstruktur aufgefasst werden.

Der Anteil an Metall in einem erfindungsgemäßen Komplex der vorliegenden Erfindung kann in einem weiten Bereich liegen. Mit Vorteil kann das Gewichtsverhältnis von Ligand zu Metall im Bereich von 10000:1 bis 10:1, vorzugsweise 4000:1 bis 20:1, besonders bevorzugt im Bereich von 2000:1 bis 30:1, speziell bevorzugt im Bereich von 1500:1 bis 50:1 liegen. Eine Verwendung von einem größeren oder einem geringeren Anteil an Metall ist möglich, jedoch nimmt in diesem Fall die Leistungsfähigkeit der Zusammensetzung, der hieraus erhältlichen funktionalen Schichten oder der diese Schichten enthaltenden optoelektronischen Bauteile unerwartet ab.

Ein weiterer Gegenstand der vorliegenden Erfindung ist ein Verfahren zur Herstellung eines Metallkomplexes, welches dadurch gekennzeichnet ist, dass ein Ligand mit einer Triarylamingruppe in Berührung mit einer Metallverbindung gebracht wird, die Bismut umfasst.

Die Art, wie der Metallverbindung mit dem Liganden in Berührung gebracht wird ist hierbei unkritisch. Beispielsweise kann eine Lösung eines Liganden mit einer Lösung einer Metallverbindung gemischt werden. Weiterhin kann ein fester Ligand mit einer Lösung einer Metallverbindung kontaktiert werden. Ferner kann eine feste Metallverbindung in eine Lösung umfassend mindestens einen Liganden eingebracht werden. Ferner kann eine gasförmige Metallverbindung mit einem gasförmigen Liganden in Berührung gebracht werden. Vorzugsweise wird eine Lösung eines Liganden und einer Metallverbindung hergestellt. Hinsichtlich der Metallverbindung bestehen keine besondere Beschränkungen, wobei vorzugsweise Arylmetallverbindungen eingesetzt werden können, beispielsweise der Formel M(Ar)₃, wobei Ar ein aromatischer Rest ist, vorzugsweise Benzol oder Toluol. Die Reaktion kann bevorzugt bei Temperaturen oberhalb von 60 °C, bevorzugt oberhalb von 80 °C erfolgen, wobei aus der Metallverbindung freigesetzte Rest, beispielsweise der Formel Ar aus der Reaktionsmischung abgetrennt werden können.

Sehr schematisch kann eine beispielhafte Umsetzung durch folgende Reaktionsgleichung dargestellt werden: 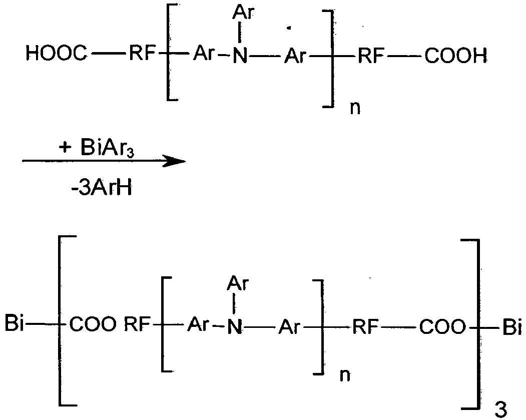 n = 1, 2, 3, 4, ....

Das zuvor dargelegte Schema ist relativ grob, da die drei Liganden eines Bi-Atoms im Allgemeinen nicht mit einem identischen zweiten Bi-Atom gleichzeitig in Wechselwirkung treten. Vielmehr tritt eine Vernetzung ein. Der Triarylligand kann mehr als zwei Koordinationsgruppen aufweisen, so dass der Vernetzungsgrad entsprechend eingestellt werden kann.

Die Umsetzung kann über die Temperatur gesteuert werden, so dass Lösungen, die gegebenenfalls relativ viskos sein können, aufbewahrt werden können. Eine Umsetzung, die zu einer Vernetzung und somit zu einer starken Verminderung der Löslichkeit führt, kann bei erhöhter Temperatur durchgeführt werden.

Aus dem zuvor dargelegten Reaktionsschema kann ersehen werden, dass der freie Ligand in saurer Form, beispielsweise als Carbonsäure, eingesetzt werden kann, die durch die Reaktion in die anionische Form übergeht.

Durch die Verwendung eines Metallatoms der Gruppen 13 bis 15 wird vorzugsweise eine p-Dotierung erzielt.

Gegenstand der Erfindung sind weiterhin Lösungen und Formulierungen umfassend mindestens einen erfindungsgemäßen Metallkomplex. Wie solche Lösungen hergestellt werden können, ist zuvor und nachfolgend dargelegt.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Geeignete und bevorzugte Lösungsmittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-tetramethylbenzol, 1-Methylnaphtalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzyl ether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösungsmittel. Bevorzugte Lösungsmittel sind insbesondere Ether und/oder Ester.

Die vorliegende Erfindung umfasst auch sogenannte Hybridvorrichtungen, in der eine oder mehrere Schichten, die aus Lösung prozessiert werden, und Schichten, die durch Aufdampfen von niedermolekularen Substanzen hergestellt werden, vorkommen können.

Die erfindungsgemäßen Metallkomplexe können in elektronischen oder optoelektronischen Vorrichtungen bzw. zu deren Herstellung verwendet werden.

Ein weiterer Gegenstand der vorliegenden Erfindung ist somit die Verwendung des erfindungsgemäßen Metallkomplexes in elektronischen oder optoelektronischen Vorrichtungen, vorzugsweise in organischen Elektrolumineszenzvorrichtungen (OLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen Elektrolumineszenzvorrichtungen (OLED).

Im Fall der zuvor genannten Hybridvorrichtung spricht man in Verbindung mit organischen Elektrolumineszenzvorrichtungen von kombinierten PLED/SMOLED (Polymeric Light Emitting Diode/Small Molecule Organic Light Emitting Diode) Systemen.

Wie OLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen Zusammensetzungen ganz besonders als Elektrolumineszenzmaterialien in derart hergestellten OLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung der erfindungsgemäßen Metallkomplexe in OLEDs, insbesondere als Elektrolumineszenzmaterial.

Gegenstand der vorliegenden Erfindung sind ferner elektronische oder optoelektronische Bauteile, vorzugsweise organische Elektrolumineszenzvorrichtungen (OLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen und organische Photorezeptoren (OPCs), besonders bevorzugt organische Elektrolumineszenzvorrichtungen, mit einer oder mehreren aktiven Schichten, wobei mindestens eine dieser aktiven Schichten ein oder mehrere erfindungsgemäße Metallkomplexe enthält. Die aktive Schicht kann beispielsweise eine lichtemittierende Schicht, eine Ladungstransportschicht und/oder eine Ladungsinjektionsschicht sein.

Besonders bevorzugt kann die aktive Schicht eine Zusammensetzung der vorliegenden Erfindung mit einem vernetzten Metallkomplex umfassen.

Die Vernetzung kann insbesondere durch eine verminderte Löslichkeit nachgewiesen werden. Hierzu kann ein Lösungsmittel, vorzugsweise Toluol auf eine Schicht, beispielsweise durch Spincoating aufgetragen werden. Nach Entfernen des Lösungsmittels können die Schichtdicken vor und nach der Behandlung verglichen werden. Bei einer Verringerung von mehr als 5% der Schichtdicke ist eine Löslichkeit gegeben. Der Nachweis wird vorzugsweise bei 30 °C durchgeführt, wobei das Lösungsmittel vorzugsweise für 2 Stunden einwirken kann.

Im vorliegenden Anmeldungstext und auch in den im Weiteren folgenden Beispielen wird hauptsächlich auf die Verwendung der erfindungsgemäßen Zusammensetzungen in Bezug auf OLEDs und entsprechende Displays abgezielt. Trotz dieser Beschränkung der Beschreibung ist es für den Fachmann ohne weiteres erfinderisches Zutun möglich, die erfindungsgemäßen Zusammensetzungen als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiele:

Alle Synthesen werden in einer Argon-Atmosphäre und in trockenen Lösungsmitteln durchgeführt, soweit nichts anderes beschrieben wird.

### Teil A: Herstellung der Monomere

### A.1 Herstellung von Am1

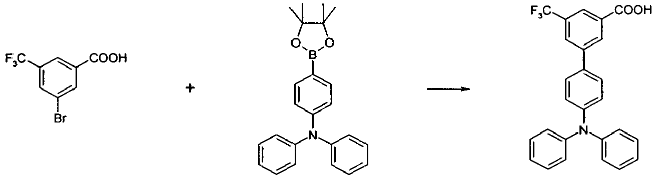

3-Brom-5-(trifluormethyl)benzoesäure [328-67-6] (8.79 g, 40 mmol), 4-(Diphenylamin)phenylboronsäurepinacolester [267221-88-5] (17.85 g, 48 mmol), Cäsiumcarbonat (32.64 g, 100 mmol) und [1,1'-Bis-(diphenylphosphino)ferrocen]palladiumdichlorid [72287-26-4] (234 mg, 3.2 mmol) werden in einer Mischung aus 120 ml Dioxan und 30 ml Ethanol für 8 h zum Rückfluß erhitzt. Nach Abkühlen wird über Celite filtriert, und die Lösungsmittel werden am Rotationsverdampfer entfernt. Der Rückstand wird mit einer Mischung von Essigester und 1N wäßriger Salzsäure (1:1 v/v) aufgenommen. Die Phasen werden getrennt; die organische wird dreimal mit gesättigter Natriumchlorid-Lösung gewaschen, über Magnesiumsulfat getrocknet und am Rotationsverdampfer vom Lösungsmittel befreit. Der Rückstand wird säulenchromatographisch gereinigt (reversed phase, Laufmittelgemisch Dichlormethan:Methanol: Essigsäure (90:8:2 v/v). Nach Trocknen im Vakuum verbleiben (14.0 g, 81% der Theorie) des Produkts als farbloses Pulver mit einer Reinheit von etwa 99.5% nach ¹H-NMR.

In analoger Weise können die folgenden Verbindungen hergestellt werden:

| Beispiel | Bromid | Produkt | Ausbeute |
|---|---|---|---|
| Am2 | 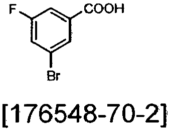 | 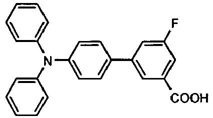 | 87% |
| Am3 | 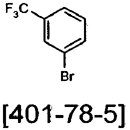 | 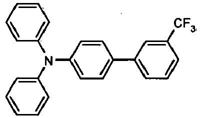 | 72% |
| Am4 | 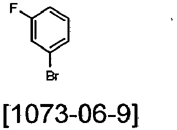 | 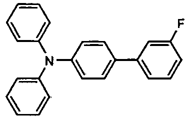 | 77% |

### A.2 Herstellung von Br1

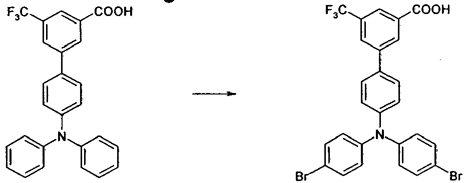

4'-(Diphenylamin)-5-(trifluormethyl)biphenyl-3-carbonsäure (12.7 g, 29 mmol) werden in 150 ml Tetrahydrofuran vorgelegt und unter Eiskühlung portionsweise mit *N*-Bromsuccinimid (10.5 g, 59 mmol) versetzt. Die Kühlung wird entfernt und die Mischung für 18 h gerührt. Das Lösungsmittel wird am Rotationsverdampfer entfernt. Der Rückstand wird säulenchromatographisch (reversed phase, Laufmittel Dichlormethan:Methanol:Essigsäure (90:8:2 v/v). Nach Trocknen im Vakuum verbleiben 15.3 g (26 mmol, 89% der Theorie) des Produkts als farbloses Pulver mit einer Reinheit von 99.8% nach HPLC.

In analoger Weise können die folgenden Verbindungen hergestellt werden:

| Beispiel | Amin | Produkt | Ausbeute |
|---|---|---|---|
| Br2 | 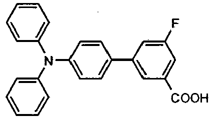 | 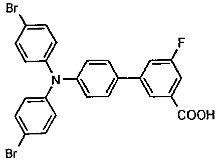 | 86% |
| | 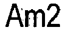 | | |
| Br3 | 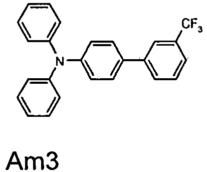 | 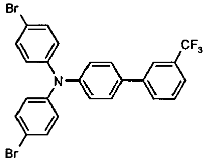 | 82% |
| Br4 | 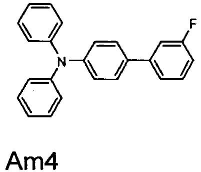 | 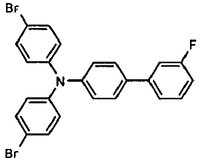 | 82% |

### Teil B: Herstellung der Polymere

Herstellung des erfindungsgemäßen Polymere P1 unter Verwendung der im Teil A hergestellten Monomere.

Das erfindungsgemäße Polymer P1 wird durch SUZUKI-Kupplung gemäß dem in WO 2003/048225 beschriebenen Verfahren aus den nachstehend gezeigten, Struktureinheiten hergestellt. Nach der Polymerisation wird der pH Wert der Reaktionslösung auf pH 2-3 eingestellt, bevor die in WO 03/048225 beschriebenen Aufreinigungsverfahren durchgeführt werden. Das auf diese Weise hergestellte Polymer P1 enthält die Struktureinheiten nach Abspaltung der Abgangsgruppen in den angegebenen prozentualen Anteilen (Prozentangaben = mol%).

### P1 (Mₙ = 58000) :

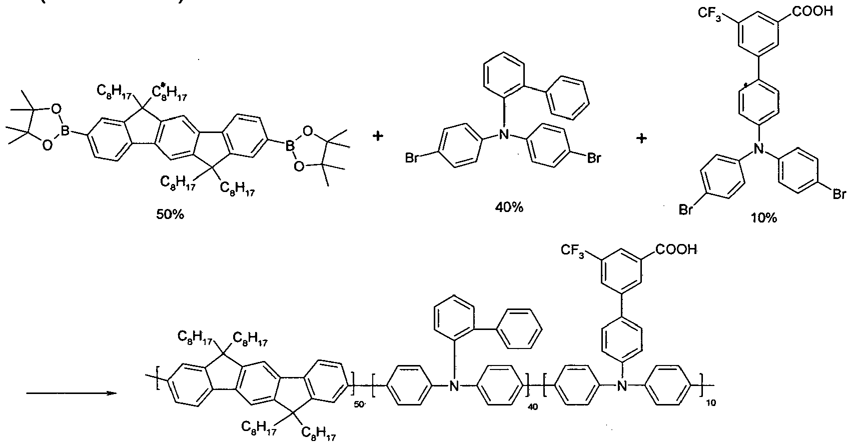

Weitere Beispiele werden analog zu P1 hergestellt:

| Polymer | Struktur | Synthese gemäß |
|---|---|---|
| P2 | 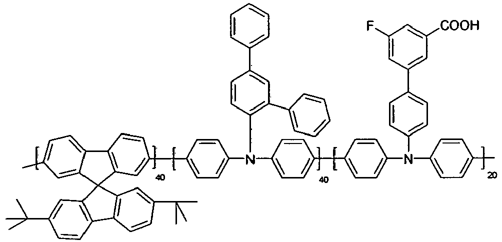 | WO 2003/048225 |
| P3 | 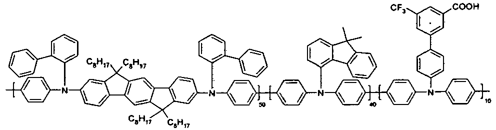 | WO 2003/048225 |
| P4 | 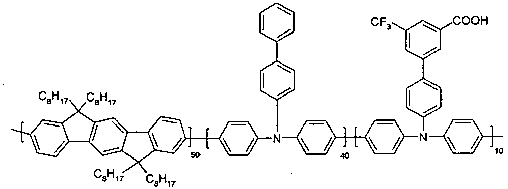 | WO 2003/048225 |
| P5 | 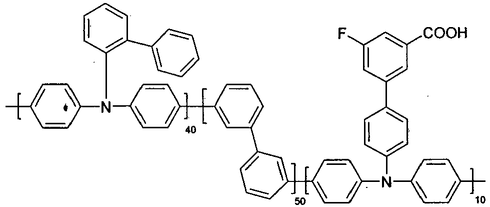 | WO 2003/048225 |

Vergleichspolymere V1-5 werden analog gemäß WO 2003/048225 hergestellt.

| Polymer | Struktur | Synthese gemäß |
|---|---|---|
| V1 | 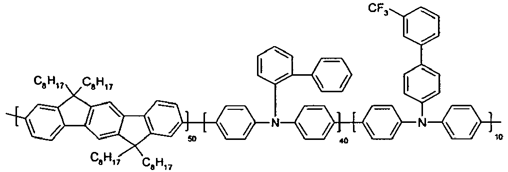 | WO 2003/048225 |
| V2 | 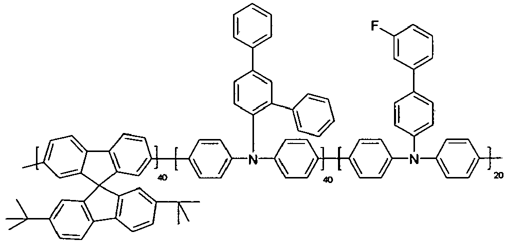 | WO 2003/048225 |
| V3 | 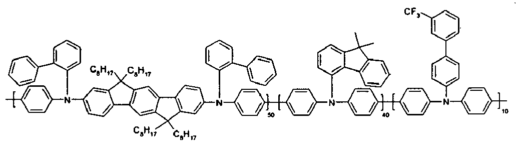 | WO 2003/048225 |
| V4 | 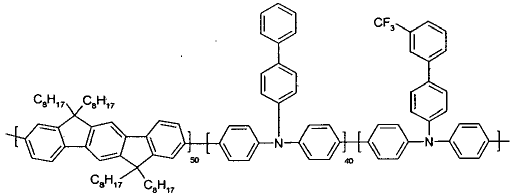 | WO 2003/048225 |
| V5 | 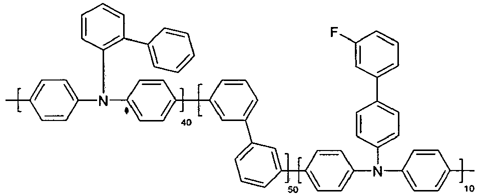 | WO 2003/048225 |

### Teil C: Device-Beispiele

Die erfindungsgemäßen Mischungen aus Polymer und Bismuth-Verbindung können aus Lösung verarbeitet werden und führen nach Ausheizen zu unlöslichen Schichten mit hervorragenden Lochinjektions- und Lochtransporteigenschaften. Sie eignen sich deshalb hervorragend als Lochinjektionsschichten in OLEDs.

Tabelle C1 zeigt die verwendete Bismuth-Verbindung, welche bei der Firma Betapharma (Shanghai) Co., Ltd. erworben wurde.

**Tabelle C1: Verwendete Bismuth-Verbindung**

| |
|---|
| 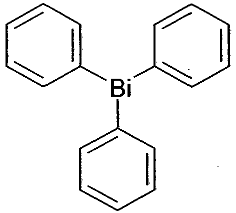 |
| Bi1 |

Das Massenverhältnis zwischen Polymer und Bismuth-Verbindung wird so gewählt, dass auf drei COOH-Gruppen des Polymers ca. 1.1 Bismuth-Atome kommen. Die Massenverhältnisse zwischen den Vergleichspolymeren V1 bis V5 und der Bismuth-Verbindung sind aus Gründen guter Vergleichbarkeit wie die Verhältnisse der entsprechenden erfindungsgemäßen Mischungen gewählt.

Ob die erfindungsgemäßen Mischungen nach Vernetzung eine vollständig unlösliche Schicht ergeben, wird analog zu WO 2010/097155 getestet.

In Tabelle D1 ist die verbliebene Schichtdicke der ursprünglich 20 nm nach dem in WO 2010/097155 beschriebenen Waschvorgang aufgeführt. Verringert sich die Schichtdicke nicht, so ist die Mischung aus Polymer und Bismuth-Verbindung unlöslich und somit die Vernetzung ausreichend.

**Tabelle C2:**

| Kontrolle der Restschichtdicke von ursprünglich 20 nm nach Waschtest | | | | |
|---|---|---|---|---|
| Polymer | Bismuth-Verbindung | MassenVerhältnis Polymer: Bi1 | Ausheizen: 60 min @ | Restschichtdicke nach Waschtest [nm] Vernetzung bei 220°C |
| P1 | Bi1 | 97:3 | 180°C | 20 |
| V1 | Bi1 | 97:3 | 180°C | 3.5 |
| P2 | Bi1 | 92:8 | 180°C | 20 |
| V2 | Bi1 | 92:8 | 180°C | 8 |
| P3 | Bi1 | 98:2 | 180°C | 20 |
| V3 | Bi1 | 98:2 | 180°C | 6.5 |
| P4 | Bi1 | 97:3 | 180°C | 20 |
| V4 | Bi1 | 97:3 | 180°C | 4 |
| P5 | Bi1 | 93:7 | 180°C | 20 |
| V5 | Bi1 | 93:7 | 180°C | 7.5 |

Wie Tabelle C2 zu entnehmen ist, vernetzen die erfindungsgemäßen Mischungen mit den erfindungsgemäßen Polymeren P1, P2, P3, P4 und P5 vollständig bei 180°C, wärend von den Schichten aus Mischungen mit Vergleichspolymeren (V1 bis V5) ein Großteil der Schicht abgewaschen wurde.

Die Herstellung lösungsbasierter OLEDs ist in der Literatur bereits vielfach beschrieben, z.B. in der WO 2004/037887 und der WO 2010/097155. Das Verfahren wird auf die im Folgenden beschriebenen Gegebenheiten (Schichtdickenvariation, Materialien) angepasst.
Die erfindungsgemäßen Mischungen aus den erfindungsgemäßen Polymeren und Bismuth-Verbindung werden in zwei verschiedenen Schichtabfolgen verwendet:
Aufbau A ist wie folgt:
   - Substrat,
   - ITO (50 nm),
   - Lochinjektionsschicht (HIL) (100 nm),
   - Kathode.
Aufbau B ist wie folgt:
   - Substrat,
   - ITO (50 nm),
   - HIL (20 nm),
   - Lochtransportschicht (HTL) (40 nm),
   - Emissionsschicht (EML) (30 nm),
   - Elektronentransportschicht (ETL) (20 nm),
   - Kathode.

Als Substrat dienen Glasplättchen, die mit strukturiertem ITO (Indium-ZinnOxid) der Dicke 50 nm beschichtet sind. Auf diese beschichteten Glasplättchen werden die verschiedenen Schichten analog Aufbau A oder B aufgebracht.

Als Lochinjektionsschicht werden die erfindungsgemäßen Mischungen aus Polymer und Bismuth-Verbindung sowie Vergleichsmischungen verwendet, jeweils in Toluol gelöst. Der typische Feststoffgehalt solcher Lösungen liegt bei ca. 5-20 g/l, wenn Schichtdicken zwischen 20 nm und 100nm mittels Spincoating erzielt werden sollen. Die Schichten werden in einer Inertgasatmosphäre, im vorliegenden Fall Argon, aufgeschleudert und 60 Minuten bei 180°C ausgeheizt.

In Aufbau B wird die Lochtransportschicht durch thermische Verdampfung in einer Vakuumkammer gebildet
Die im vorliegenden Fall verwendeten Materialien sind in Tabelle C3 gezeigt.

**Tabelle C3:**

| Strukturformeln der aus Vakuum prozessierten lochtransportierenden Materialien | |
|---|---|
| 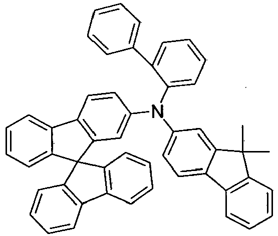 | |
| HT1 | |

Die Emissionsschicht setzt sich immer aus mindestens einem Matrixmaterial (Hostmaterial, Wirtsmaterial) und einem emittierenden Dotierstoff (Dotand, Emitter) zusammen. In Aufbau B wird die Emissionsschicht durch thermische Verdampfung in einer Vakuumkammer gebildet. Dabei kann die Schicht aus mehr als einem Material bestehen, die einander durch Co-Verdampfung in einem bestimmten Volumenanteil beigemischt werden.
Eine Angabe wie M1:Dotand (95:5) bedeutet hierbei, dass die Materialien M1 und Dotand in einem Volumenanteil von 95%:5% in der Schicht vorliegen.

Die im vorliegenden Fall verwendeten Materialien sind in Tabelle C4 gezeigt.

**Tabelle C4:**

| Strukturformeln der in der Emissionsschicht verwendeten Materialien | |
|---|---|
| 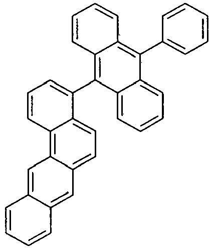 | 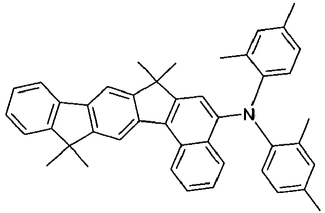 |
| M1 | SEB |

Die Materialien für die Lochblockierschicht und Elektronentransportschicht werden ebenfalls in einer Vakuumkammer thermisch aufgedampft und sind in Tabelle C5 gezeigt. Die Lochblockierschicht besteht aus ETM1. Die Elektronentransportschicht besteht aus den zwei Materialien ETM1 und ETM2, die einander durch Co-Verdampfung in einem Volumenanteil von jeweils 50% beigemischt werden.

**Tabelle C5:**

| Verwendete HBL- und ETL-Materialien | |
|---|---|
| 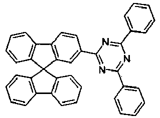 | 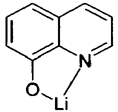 |
| ETM1 | ETM2 |

Die Kathode wird durch die thermische Verdampfung einer 100nm dicken Aluminiumschicht gebildet.

Der genaue Aufbau der OLEDs ist Tabelle C6 zu entnehmen. In der Spalte HIL wird das verwendete Polymer aufgeführt, sowie die Temperatur, bei der die Schicht ausgeheizt und ggf. vernetzt wird.

**Tabelle C6:**

| Aufbau der OLEDs | | | | | | |
|---|---|---|---|---|---|---|
| Beispiel | Aufbau | HIL | | | | EML |
| | | Polymer | Bismuth-Verbindung | Massenverhältnis Polymer: Bi1 | T[°C] | Zusammensetzung |
| C01 | A | P1 | Bi1 | 97:3 | 180°C | - |
| C02 | A | V1 | Bi1 | 97:3 | 180°C | - |
| C03 | A | P2 | Bi1 | 92:8 | 180°C | - |
| C04 | A | V2 | Bi1 | 92:8 | 180°C | - |
| C05 | A | P3 | Bi1 | 98:2 | 180°C | - |
| C06 | A | V3 | Bi1 | 98:2 | 180°C | - |
| C07 | A | P4 | Bi1 | 97:3 | 180°C | - |
| C08 | A | V4 | Bi1 | 97:3 | 180°C | - |
| C09 | A | P5 | Bi1 | 93:7 | 180°C | - |
| C10 | A | V5 | Bi1 | 93:7 | 180°C | - |
| C11 | B | P1 | Bi1 | 97:3 | 180°C | M1:SEB (95:5) |
| C12 | B | V1 | Bi1 | 97:3 | 180°C | M1:SEB (95:5) |

Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie im Fall von Aufbau B die (Betriebs-)Lebensdauer bestimmt. Aus den IUL-Kennlinien werden Kennzahlen bestimmt wie die Betriebsspannung (in V) und die externe Quanteneffizienz (in %) bei einer bestimmten Helligkeit. LD80 @ 1000cd/m² ist die Lebensdauer, bis die OLED bei einer Starthelligkeit von 1000 cd/m² auf 80 % der Anfangsintensität, also auf 800 cd/m², abgefallen ist.

Die Eigenschaften der verschiedenen OLEDs sind in den Tabellen C7 a und b zusammengefasst.

Tabellen C7 a-b:
Eigenschaften der OLEDs

**Tabelle C7 a**

| Beispiel | Spannung bei 1 mA/cm² |
|---|---|
| | [V] |
| C01 | 0.4 |
| C02 | 6 |
| C03 | 0.5 |
| C04 | 4 |
| C05 | 0.2 |
| C06 | 3.5 |
| C07 | 0.3 |
| C08 | 4.5 |
| C09 | 0.4 |
| C10 | 5.5 |

**Tabelle C7 b**

| Beispiel | Effizienz bei 1000 cd/m² | Spannung bei 1000 cd/m² | LD80 bei 1000 cd/m² |
|---|---|---|---|
| | % EQE | [V] | [h] |
| C11 | 7.8 | 4.6 | 257 |
| C12 | 4 | 6.2 | 35 |

Tabelle C7 a zeigt, dass die Spannungen von Bauteilen aus erfindungsgemäßen Mischungen (Polymere P1 bis P5) signifikant niedriger sind als deren unvernetzbaren und undotierbaren Pendants (Polymere V1 bis V5). Die erfindungsgemäßen Mischungen sind somit als Lochinjektionsmaterialien geeignet, welche die Betriebsspannung der OLED herabsetzen.
Tabelle C7 b zeigt, dass die Verwendung der erfindungsgemäßen Mischungen zu einer verbesserten Bauteilperformance führt.

## Patentansprüche

1. Metallkomplex mit Bismut als Metallatom und mindestens einem Liganden, wobei der Ligand mindestens eine anionische Koordinierungsgruppe mit mindestens einem Sauerstoff- und/oder Stickstoffatom umfasst, über die das Metallatom koordiniert ist, und der Ligand mindestens eine Triarylamingruppe umfasst.

2. Metallkomplex gemäß Anspruch 1, **dadurch gekennzeichnet, dass** mindestens eine Triarylamingruppe ein Strukturelement der folgenden Formel (I) umfasst: 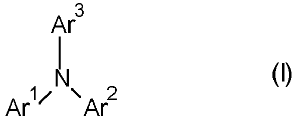 , wobei
Ar¹, Ar² und Ar³ bei jedem Auftreten, jeweils gleich oder verschieden, ein mono- oder polycyclisches, aromatisches oder heteroaromatisches Ringsystem ist, das mit einem oder mehreren Resten R substituiert sein kann;
R bei jedem Auftreten gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, C=S, C=NR¹, P(=O)R¹, SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ist; wobei zwei oder mehrere Reste R auch miteinander ein mono- oder polycyclisches, aliphatisches, aromatisches und/oder benzoannelliertes Ringsystem bilden können;
R¹ bei jedem Auftreten gleich oder verschieden H, D, F oder ein aliphatischer, aromatischer und/oder heteroaromatischer Kohlenwasserstoffrest mit 1 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches oder aromatisches Ringsystem bilden können;
wobei mindestens einer der Reste Ar¹, Ar² und Ar³ kovalent mit mindestens einer anionischen Koordinierungsgruppe verbunden ist.

3. Metallkomplex gemäß Anspruch 1 oder 2, **dadurch gekennzeichnet, dass**
mindestens eine anionische Koordinierungsgruppe des Liganden eine Struktur gemäß Formel (K-I) umfasst: 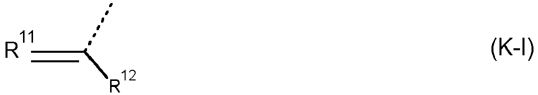 , worin R¹¹ und R¹² unabhängig voneinander Sauerstoff, Schwefel, Selen, NH oder NR¹³ sein können, wobei R¹³ ausgewählt ist aus der Gruppe enthaltend Alkyl oder Aryl und mit anderen Gruppen des Liganden verbunden sein kann und die gestrichelte Linie die Bindung der anionischen Koordinierungsgruppe an den Liganden darstellt.

4. Metallkomplex nach einem oder mehreren der vorhergehenden Ansprüche, **dadurch gekennzeichnet, dass** der Ligand mindestens zwei räumlich entfernte anionische Koordinierungsgruppen umfasst, über die zwei Metallatome komplexiert werden können.

5. Metallkomplex nach einem oder mehreren der vorhergehenden Ansprüche, **dadurch gekennzeichnet, dass** mindestens eine anionische Koordinierungsgruppe des Liganden durch eine Struktur gemäß Formel (K-II) darstellbar ist: 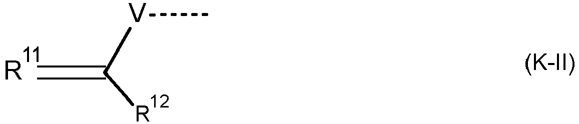 , worin R¹¹ und R¹² unabhängig voneinander Sauerstoff, Schwefel, Selen, NH oder NR¹³ sein können, wobei R¹³ ausgewählt ist aus der Gruppe enthaltend Alkyl oder Aryl und mit anderen Gruppen des Liganden verbunden sein kann, V eine Bindung oder eine verbindende Gruppe ist, ausgewählt aus einem aromatischen oder heteroaromatischen Ringsystem mit 5 bis 40 aromatischen Ringatomen, das jeweils durch einen oder mehrere Reste R substituiert sein kann, einer Alkylengruppe mit 1 bis 40 C-Atomen, die jeweils mit einem oder mehreren Resten R substituiert sein kann, wobei eine oder mehrere nicht benachbarte CH₂-Gruppen durch RC=CR, C≡C, Si(R)₂, C=O, C=S, C=NR, P(=O)R, SO, SO₂, NR, O, S oder CONR ersetzt sein können und wobei ein oder mehrere H-Atome durch D, F, Cl, Br, I oder CN ersetzt sein können, wobei der Rest R die für Formel (I), insbesondere in Anspruch 2 genannte Bedeutung aufweist, und die gestrichelte Linie die Bindung der anionischen Koordinierungsgruppe an die Triarylamingruppe darstellt.

6. Metallkomplex nach Anspruch 5, **dadurch gekennzeichnet, dass** der Rest V eine Bindung oder eine verbindende Gruppe ist, ausgewählt aus einer Arylengruppe mit 6 bis 24 C-Atomen oder einer Heteroarylengruppe mit 3 bis 24 C-Atomen, welche jeweils durch einen oder mehrere Reste R¹ substituiert sein kann, einer Alkylengruppe mit 1, 2, 3, 4, 5, 6, 7, 8, 9, 10, 11 oder 12 C-Atomen, welche mit einem oder mehreren Resten R¹ substituiert sein kann, wobei der Rest R¹ die für Formel (I), insbesondere in Anspruch 2 genannte Bedeutung aufweist.

7. Metallkomplex nach einem oder mehreren der vorhergehenden Ansprüche, **dadurch gekennzeichnet, dass** der Ligand eine Verbindung ist, umfassend Strukturen der folgenden Formel (L-I): 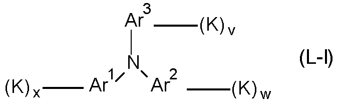 , wobei
Ar¹, Ar² und Ar³ bei jedem Auftreten, jeweils gleich oder verschieden, die zuvor, insbesondere in Anspruch 2 dargelegte Bedeutung aufweist, K eine anionische Koordinierungsgruppe darstellt, vorzugsweise eine Gruppe gemäß Formel (K-I) und/oder (K-II),
v = 0, 1, 2, 3, 4, 5, 6 oder 7,
w = 0, 1, 2, 3, 4, 5, 6 oder 7, und
x = 0, 1, 2, 3, 4, 5, 6 oder 7 ist,
wobei die Summe von v, w und x größer oder gleich 1, vorzugsweise größer oder gleich 2 ist.

8. Metallkomplex nach einem oder mehreren der vorhergehenden Ansprüche, **dadurch gekennzeichnet, dass** der Ligand ein Molekulargewicht von kleiner oder gleich 10000 g/mol, bevorzugt kleiner oder gleich 5000 g/mol, besonders bevorzugt kleiner oder gleich 4000 g/mol, insbesondere bevorzugt kleiner oder gleich 3000 g/mol, speziell bevorzugt kleiner oder gleich 2000 g/mol und ganz besonders bevorzugt kleiner oder gleich 1000 g/mol aufweist.

9. Metallkomplex nach einem oder mehreren der vorhergehenden Ansprüche, **dadurch gekennzeichnet, dass** der Ligand ein Polymer ist, umfassend mindestens eine Struktureinheit der folgenden Formel (P-I): 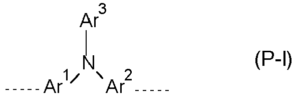 , wobei
Ar¹, Ar² und Ar³ bei jedem Auftreten, jeweils gleich oder verschieden, die zuvor, insbesondere in Anspruch 2 dargelegte Bedeutung aufweist und
die gestrichelten Linien Bindungen zu benachbarten Struktureinheiten im Polymer darstellen, wobei die Gruppen Ar¹, Ar² und Ar³ in der Struktureinheit (P-I) mit mindestens einer anionischen Koordinierungsgruppe, vorzugsweise einer Gruppe gemäß Formel (K-I) und/oder (K-II), substituiert sein können.

10. Metallkomplex nach einem oder mehreren der vorhergehenden Ansprüche, **dadurch gekennzeichnet, dass** der Ligand ein Polymer ist, umfassend mindestens eine Struktureinheit der folgenden Formel (L-P-I): 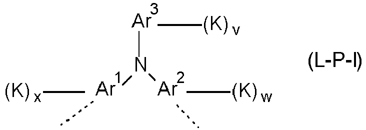 , wobei
Ar¹, Ar² und Ar³ bei jedem Auftreten, jeweils gleich oder verschieden, die zuvor, insbesondere in Anspruch 2 dargelegte Bedeutung aufweist, K eine anionische Koordinierungsgruppe darstellt, vorzugsweise eine Gruppe gemäß Formel (K-I) und/oder (K-II),
v = 0, 1, 2, 3, 4, 5, 6 oder 7,
w = 0, 1, 2, 3, 4, 5, 6 oder 7, und
x = 0, 1, 2, 3, 4, 5, 6 oder 7 ist,
wobei die Summe von v, w und x größer oder gleich 1, vorzugsweise größer oder gleich 2 ist und
die gestrichelten Linien Bindungen zu benachbarten Struktureinheiten im Polymer darstellen.

11. Metallkomplex nach einem oder mehreren der vorhergehenden Ansprüche 2 bis 14, **dadurch gekennzeichnet, dass** der Rest Ar³ gemäß Formel (I), (L-I), (P-I) und/oder (L-P-I) in mindestens einer, vorzugsweise in genau einer der beiden ortho-Positionen, bezogen auf die Position des in Formel (I), (L-I), (P-I) und/oder (L-P-I) dargestellten Stickstoffatoms, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die in Anspruch 2 dargelegte Bedeutung annehmen kann, wobei der Rest Ar⁴ mit einer oder mehreren anionischen Koordinierungsgruppen, vorzugsweise einer Gruppe gemäß Formel (K-I) und/oder (K-II), substituiert sein kann.

12. Metallkomplex nach Anspruch 11, dass die Triarylamingruppe mindestens ein Strukturelement der Formel (I) umfasst, das ausgewählt ist aus einem Strukturelement der folgenden Formel (Ia) oder das Polymer mindestens eine Struktureinheit der Formel (P-I) umfasst, die ausgewählt ist aus einer Struktureinheit der folgenden Formel (P-Ia), vorzugsweise ausgewählt ist aus einer Struktureinheit der folgenden Formel (L-P-Ia): 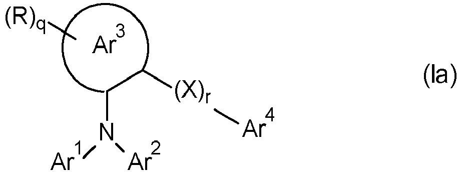 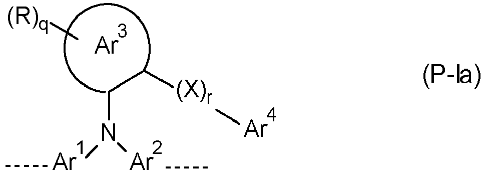 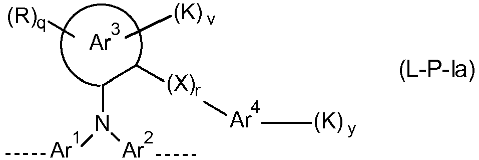
wobei Ar¹, Ar², Ar³, Ar⁴ und R die zuvor, insbesondere in Anspruch 2 oder Anspruch 11 angegebenen Bedeutungen annehmen können, K eine anionische Koordinierungsgruppe darstellt, vorzugsweise eine Gruppe gemäß Formel (K-I) und/oder (K-II), die gestrichelten Linien Bindungen zu benachbarten Struktureinheiten im Polymer darstellen, q = 0, 1, 2, 3, 4, 5 oder 6 ist,
X = CR₂, NR, SiR₂, NR, CK₂, NK, SiK₂, CRK, SiRK, O, S, C=O oder (P=O)R, vorzugsweise CR₂, SiR₂, NR, CK₂, NK, SiK₂, CRK, SiRK, O oder S ist, wobei R die zuvor, insbesondere in Anspruch 2 dargelegte Bedeutung annehmen kann und K eine anionische Koordinierungsgruppe darstellt, vorzugsweise eine Gruppe gemäß Formel (K-I) und/oder (K-II), und
r = 0 oder 1 ist,
v = 0, 1, 2, oder 3 ist,
y = 0, 1, 2, oder 3 ist,
wobei die Summe von v und y größer oder gleich 1 ist.

13. Metallkomplex nach mindestens einem der Ansprüche 11 oder 12, **dadurch gekennzeichnet, dass** die Triarylamingruppe mindestens ein Strukturelement der Formel (I) umfasst, das ausgewählt ist aus einer Struktureinheit der folgenden Formel (Ib) oder das Polymer mindestens eine Struktureinheit der Formel (P-I) umfasst, die ausgewählt ist aus einer Struktureinheit der folgenden Formel (P-Ib), vorzugsweise ausgewählt ist aus einer Struktureinheit der folgenden Formel (L-P-Ib): 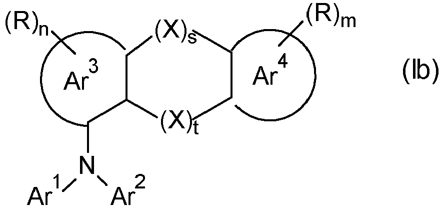 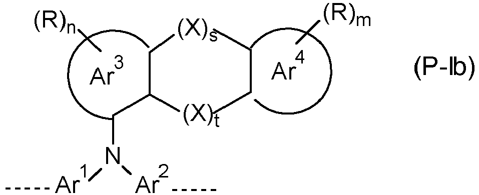 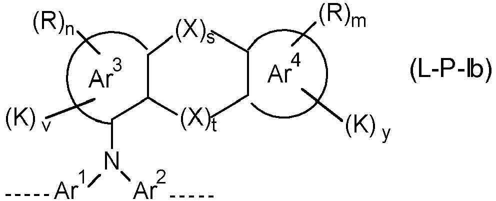
wobei Ar¹, Ar², Ar³, Ar⁴, R, und X die zuvor, insbesondere in den Ansprüchen 2, 11 und 12 angegebenen Bedeutungen annehmen können, K eine anionische Koordinierungsgruppe darstellt, vorzugsweise eine Gruppe gemäß Formel (K-I) und/oder (K-II), die gestrichelten Linien Bindungen zu benachbarten Struktureinheiten im Polymer darstellen,
m = 0, 1, 2, 3 oder 4 ist,
n = 0, 1, 2 oder 3 ist;
s und t jeweils 0 oder 1 sind, wobei die Summe (s + t) = 1 oder 2 ist;
v = 0, 1, 2, oder 3,
y = 0, 1, 2, oder 3,
wobei die Summe von v und y größer oder gleich 1 ist.

14. Metallkomplex nach einem oder mehreren der Ansprüche 11 bis 13, **dadurch gekennzeichnet, dass** das Polymer mindestens eine Struktureinheit der Formel (P-I) umfasst, die ausgewählt ist aus einer Struktureinheit der folgenden Formel (P-VIIIa): 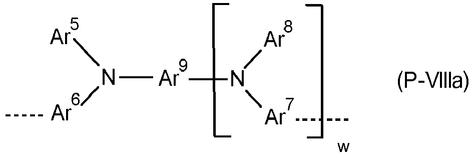 und/oder einer Struktureinheit der folgenden Formel (P-VIIIb): 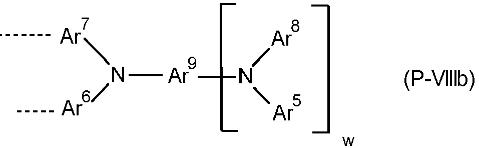
wobei z 1, 2 oder 3 ist, Ar⁵ bis Ar⁹ bei jedem Auftreten, jeweils gleich oder verschieden, ein mono- oder polycyclisches, aromatisches oder heteroaromatisches Ringsystem ist, das mit einem oder mehreren Resten R substituiert sein kann, wobei R die zuvor, insbesondere in Anspruch 2 dargelegte Bedeutung annehmen kann;
die gestrichelten Linien Bindungen zu benachbarten Struktureinheiten im Polymer darstellen;
wobei die Gruppen Ar¹, Ar², Ar³, Ar⁴, Ar⁵, Ar⁶, Ar⁶, Ar⁷, Ar⁸ und Ar⁹ in den Struktureinheiten (P-VIIIa) und/oder (P-VIIIb) mit einer oder mehreren anionischen Koordinierungsgruppen, vorzugsweise mindestens einer Gruppe gemäß Formel (K-I) und/oder (K-II), substituiert sein können.

15. Metallkomplex nach einem oder mehreren der Ansprüche 9 bis 14, **dadurch gekennzeichnet, dass** das Polymer neben Struktureinheiten der Formeln (P-I), (P-Ia), (P-Ib), (L-P-I), (L-P-Ia), (L-P-Ib), (P-VIIIa) und/oder (P-VIIIb) mindestens eine weitere Struktureinheit der folgenden Formel (P-XVII) enthält, die von den Struktureinheiten der Formeln (P-I), (P-Ia), (P-Ib), (L-P-I), (L-P-Ia), (L-P-Ib), (P-VIIIa) und/oder (P-VIIIb) verschieden ist:
-----Ar¹¹----- (P-XVII)
wobei Ar¹¹ ein mono- oder polycyclisches, aromatisches oder heteroaromatisches Ringsystem ist, das mit einem oder mehreren Resten R und/oder K substituiert sein kann, wobei R die zuvor, insbesondere in Anspruch 2 angegebenen Bedeutungen annehmen kann und K eine anionische Koordinierungsgruppe darstellt, vorzugsweise eine Gruppe gemäß Formel (K-I) und/oder (K-II), und
die gestrichelten Linien Bindungen zu benachbarten Struktureinheiten im Polymer darstellen.

16. Verfahren zur Herstellung eines Metallkomplexes nach einem oder mehreren der Ansprüche 1 bis 15, **dadurch gekennzeichnet, dass** ein Ligand mit einer Triarylamingruppe in Berührung mit einer Metallverbindung gebracht wird, die ein Bismut-Atom umfasst.

17. Lösungen oder Formulierungen umfassend mindestens einen Metallkomplex nach einem oder mehreren der Ansprüche 1 bis 15 in einem oder mehreren Lösungsmitteln.

18. Verwendung eines Metallkomplexes nach einem oder mehreren der Ansprüche 1 bis 15 in elektronischen oder optoelektronischen Vorrichtungen, vorzugsweise in organischen Elektrolumineszenzvorrichtungen (OLED), organischen lichtemittierenden elektrochemischen Zellen (OLEC), organischen Feld-Effekt-Transistoren (OFET), organischen integrierten Schaltungen (O-IC), organischen Dünnfilmtransistoren (TFT), organischen Solarzellen (O-SC), organischen Laserdioden (O-Laser), organischen photovoltaischen (OPV) Elementen oder Vorrichtungen oder organischen Photorezeptoren (OPC), besonders bevorzugt in organischen Elektrolumineszenzvorrichtungen (OLED).

19. Elektronische oder optoelektronische Bauteile, vorzugsweise organische Elektrolumineszenzvorrichtungen (OLED), organische lichtemittierende elektrochemische Zellen (OLEC), organische Feld-Effekt-Transistoren (OFET), organische integrierte Schaltungen (O-IC), organische Dünnfilmtransistoren (TFT), organische Solarzellen (O-SC), organische Laserdioden (O-Laser), organische photovoltaische (OPV) Elemente oder Vorrichtungen und organische Photorezeptoren (OPC), besonders bevorzugt organische Elektrolumineszenzvorrichtungen, mit einer oder mehreren aktiven Schichten, wobei mindestens eine dieser aktiven Schichten eine oder mehrere Metallkomplexe nach einem oder mehreren der Ansprüche 1 bis 15 oder erhältlich nach einem Verfahren 16 enthält.

## Claims

1. Metal complex having bismuth as metal atom and at least one ligand, where the ligand comprises at least one anionic coordination group having at least one oxygen and/or nitrogen atom through which the metal atom is coordinated, and the ligand comprises at least one triarylamine group.

2. Metal complex according to Claim 1, **characterized in that** at least one triarylamine group comprises a structural element of the following formula (I) : 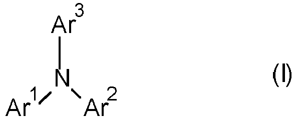 where
Ar¹, Ar² and Ar³ are the same or different at each instance and are a mono- or polycyclic, aromatic or heteroaromatic ring system which may be substituted by one or more R radicals;
R is the same or different at each instance and is H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 40 carbon atoms or an alkenyl or alkynyl group having 2 to 40 carbon atoms or a branched or cyclic alkyl, alkoxy or thioalkoxy group having 3 to 40 carbon atoms, each of which may be substituted by one or more R¹ radicals, where one or more nonadjacent CH₂ groups may be replaced by R¹C=CR¹, C≡C, Si(R¹)₂, C=O, C=S, C=NR¹, P(=O)R¹, SO, SO₂, NR¹, O, S or CONR¹ and where one or more hydrogen atoms may be replaced by D, F, Cl, Br, I or CN, or an aromatic or heteroaromatic ring system which has 5 to 60 aromatic ring atoms and may be substituted in each case by one or more R¹ radicals, or an aryloxy or heteroaryloxy group which has 5 to 60 aromatic ring atoms and may be substituted by one or more R¹ radicals, or an aralkyl or heteroaralkyl group which has 5 to 60 aromatic ring atoms and may be substituted by one or more R¹ radicals, or a diarylamino group, diheteroarylamino group or arylheteroarylamino group which has 10 to 40 aromatic ring atoms and may be substituted by one or more R¹ radicals; where two or more R radicals together may also form a mono- or polycyclic, aliphatic, aromatic and/or benzofused ring system;
R¹ is the same or different at each instance and is H, D, F or an aliphatic, aromatic and/or heteroaromatic hydrocarbyl radical having 1 to 20 carbon atoms, in which one or more hydrogen atoms may also be replaced by F; where two or more R¹ substituents together may also form a mono- or polycyclic, aliphatic or aromatic ring system; where at least one of the Ar¹, Ar² and Ar³ radicals is bonded covalently to at least one anionic coordination group.

3. Metal complex according to Claim 1 or 2, **characterized in that**
at least one anionic coordination group in the ligand comprises a structure of formula (K-I): 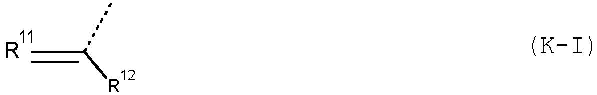 in which R¹¹ and R¹² may each independently be oxygen, sulphur, selenium, NH or NR¹³ where R¹³ is selected from the group comprising alkyl and aryl and may be bonded to other groups in the ligand, and the dotted line represents the bond of the anionic coordination group to the ligand.

4. Metal complex according to one or more of the preceding claims, **characterized in that** the ligand comprises at least two spatially far-removed anionic coordination groups via which two metal atoms can be complexed.

5. Metal complex according to one or more of the preceding claims, **characterized in that**
at least one anionic coordination group in the ligand can be represented by a structure of formula (K-II) : 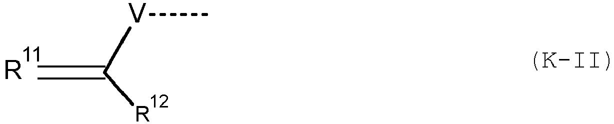 in which R¹¹ and R¹² may each independently be oxygen, sulphur, selenium, NH or NR¹³ where R¹³ is selected from the group comprising alkyl and aryl and may be bonded to other groups in the ligand, V is a bond or a bonding group selected from an aromatic or heteroaromatic ring system which has 5 to 40 aromatic ring atoms and may be substituted in each case by one or more R radicals, an alkylene group which has 1 to 40 carbon atoms and may be substituted in each case by one or more R radicals, where one or more nonadjacent CH₂ groups may be replaced by RC=CR, C≡C, Si(R)₂, C=O, C=S, C=NR, P(=O)R, SO, SO₂, NR, O, S or CONR and where one or more hydrogen atoms may be replaced by D, F, Cl, Br, I or CN, where the R radical is as defined for formula (I), especially in Claim 2, and the dotted line represents the bond of the anionic coordination group to the triarylamine group.

6. Metal complex according to Claim 5, **characterized in that** the V radical is a bond or a bonding group selected from an arylene group having 6 to 24 carbon atoms and a heteroarylene group having 3 to 24 carbon atoms, each of which may be substituted by one or more R¹ radicals, an alkylene group which has 1, 2, 3, 4, 5, 6, 7, 8, 9, 10, 11 or 12 carbon atoms and may be substituted by one or more R¹ radicals, where the R¹ radical is as defined for formula (I), especially in Claim 2.

7. Metal complex according to one or more of the preceding claims, **characterized in that** the ligand is a compound comprising structures of the following formula (L-I): 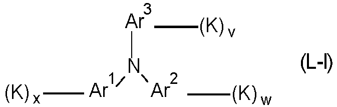 where
Ar¹, Ar² and Ar³ are each the same or different at each instance and are as defined above, especially in Claim 2, K represents an anionic coordination group, preferably a group of formula (K-I) and/or (K-II),
v = 0, 1, 2, 3, 4, 5, 6 or 7,
w = 0, 1, 2, 3, 4, 5, 6 or 7, and
x = 0, 1, 2, 3, 4, 5, 6 or 7,
where the sum of v, w and x is not less than 1, preferably not less than 2.

8. Metal complex according to one or more of the preceding claims, **characterized in that** the ligand has a molecular weight of not more than 10 000 g/mol, more preferably not more than 5000 g/mol, particularly preferably not more than 4000 g/mol, especially preferably not more than 3000 g/mol, specifically preferably not more than 2000 g/mol and most preferably not more than 1000 g/mol.

9. Metal complex according to one or more of the preceding claims, **characterized in that** the ligand is a polymer comprising at least one structural unit of the following formula (P-I): 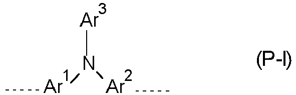 where
Ar¹, Ar² and Ar³ are each the same or different at each instance and are as defined above, especially in Claim 2, and
the dotted lines represent bonds to adjacent structural units in the polymer, where the Ar¹, Ar² and Ar³ groups in the structural unit (P-I) may be substituted by at least one anionic coordination group, preferably a group of formula (K-I) and/or (K-II).

10. Metal complex according to one or more of the preceding claims, **characterized in that** the ligand is a polymer comprising at least one structural unit of the following formula (L-P-I): 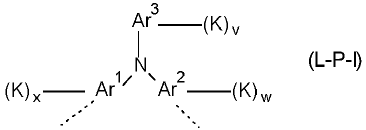 where
Ar¹, Ar² and Ar³ are each the same or different at each instance and are as defined above, especially in Claim 2, K represents an anionic coordination group, preferably a group of formula (K-I) and/or (K-II),
v = 0, 1, 2, 3, 4, 5, 6 or 7,
w = 0, 1, 2, 3, 4, 5, 6 or 7, and
x = 0, 1, 2, 3, 4, 5, 6 or 7,
where the sum of v, w and x is not less than 1, preferably not less than 2, and
the dotted lines represent bonds to adjacent structural units in the polymer.

11. Metal complex according to one or more of the preceding Claims 2 to 14, **characterized in that** the Ar³ radical in formula (I), (L-I), (P-I) and/or (L-P-I) is substituted by Ar⁴ in at least one ortho position, preferably in exactly one of the two ortho positions, based on the position of the nitrogen atom shown in formula (I), (L-I), (P-I) and/or (L-P-I), where Ar⁴ is a mono- or polycyclic, aromatic or heteroaromatic ring system which has 5 to 60 aromatic ring atoms and may be substituted by one or more R radicals, where R may assume the definition given in Claim 2, where the Ar⁴ radical may be substituted by one or more anionic coordination groups, preferably a group of formula (K-I) and/or (K-II).

12. Metal complex according to Claim 11, that the triarylamine group comprises at least one structural element of the formula (I) selected from a structural element of the following formula (Ia) or the polymer comprises at least one structural unit of the formula (PI) selected from a structural unit of the following formula (P-Ia), preferably selected from a structural unit of the following formula (L-P-Ia): 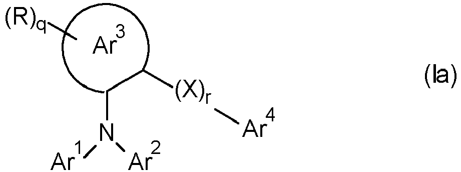 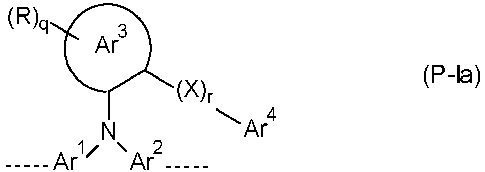 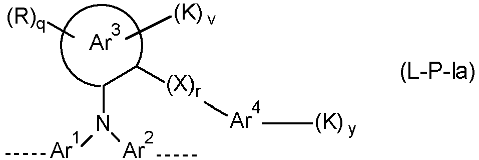
where Ar¹, Ar², Ar³, Ar⁴ and R may assume the definitions given above, especially in Claim 2 or Claim 11, K represents an anionic coordination group, preferably a group of formula (K-I) and/or (K-II), the dotted lines represent bonds to adjacent structural units in the polymer,
q = b0, 1, 2, 3, 4, 5 or 6,
X = CR₂, NR, SiR₂, NR, CK₂, NK, SiK₂, CRK, SiRK, O, S, C=O or (P=O)R, preferably CR₂, SiR₂, NR, CK₂, NK, SiK₂, CRK, SiRK, O or S, where R may assume the definition given above, especially in Claim 2, and K represents an anionic coordination group, preferably a group of formula (K-I) and/or (K-II), and
r = 0 or 1,
v = 0, 1, 2 or 3,
y = 0, 1, 2 or 3,
where the sum of v and y is not less than 1.

13. Metal complex according to at least one of Claims 11 and 12, **characterized in that** the triarylamine group comprises at least one structural element of the formula (I) selected from a structural unit of the following formula (Ib) or the polymer comprises at least one structural unit of the formula (P-I) selected from a structural unit of the following formula (P-Ib), preferably selected from a structural unit of the following formula (L-P-Ib): 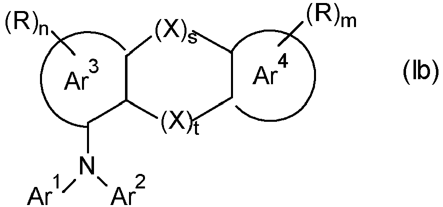 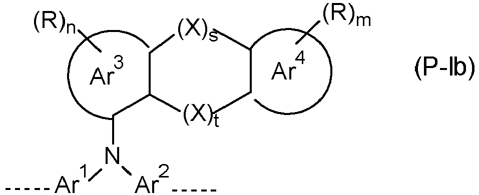 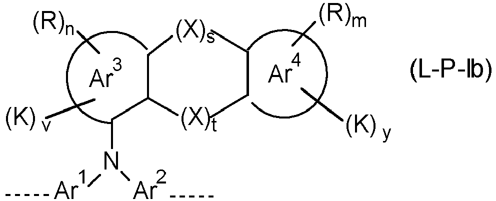
where Ar¹, Ar², Ar³, Ar⁴, R and X may assume the definitions given above, especially in Claims 2, 11 and 12, K represents an anionic coordination group, preferably a group of formula (K-I) and/or (K-II), the dotted lines represent bonds to adjacent structural units in the polymer,
m = 0, 1, 2, 3 or 4,
n = 0, 1, 2 or 3;
s and t are each 0 or 1, where the sum of (s + t) = 1 or 2;
v = 0, 1, 2 or 3,
y = 0, 1, 2 or 3,
where the sum of v and y is not less than 1.

14. Metal complex according to one or more of Claims 11 to 13, **characterized in that** the polymer comprises at least one structural unit of the formula (P-I) selected from a structural unit of the following formula (P-VIIIa) : 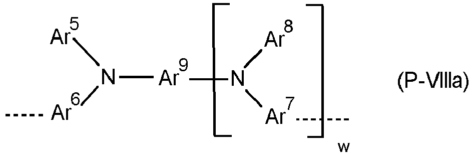 and/or a structural unit of the following formula (P-VIIIb) : 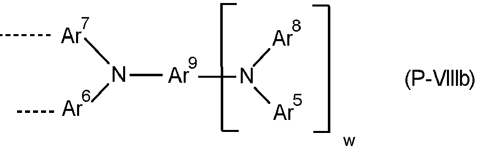
where z is 1, 2 or 3, Ar⁵ to Ar⁹ are each the same or different at each instance and are a mono- or polycyclic, aromatic or heteroaromatic ring system which may be substituted by one or more R radicals, where R may be as defined above, especially in Claim 2;
the dotted lines represent bonds to adjacent structural units in the polymer;
where the Ar¹, Ar², Ar³, Ar⁴, Ar⁵, Ar⁶, Ar⁶, Ar⁷, Ar⁸ and Ar⁹ groups in the structural units (P-VIIIa) and/or (P-VIIIb) may be substituted by one or more anionic coordination groups, preferably at least one group of formula (K-I) and/or (K-II).

15. Metal complex according to one or more of Claims 9 to 14, **characterized in that** the polymer, as well as structural units of the formulae (P-I), (P-Ia), (P-Ib), (L-P-I), (L-P-Ia), (L-P-Ib), (P-VIIIa) and/or (P-VIIIb), contains at least one further structural unit of the following formula (P-XVII) which is different from the structural units of the formulae (P-I), (P-Ia), (P-Ib), (L-P-I), (L-P-Ia), (L-P-Ib), (P-VIIIa) and/or (P-VIIIb) :
-----Ar¹¹----- (P-XVII)
where Ar¹¹ is a mono- or polycyclic, aromatic or heteroaromatic ring system which may be substituted by one or more R and/or K radicals, where R may assume the definitions given above, especially in Claim 2, and K represents an anionic coordination group, preferably a group of formula (K-I) and/or (K-II), and
the dotted lines represent bonds to adjacent structural units in the polymer.

16. Process for preparing a metal complex according to one or more of Claims 1 to 15, **characterized in that** a ligand having a triarylamine group is contacted with a metal compound comprising a bismuth atom.

17. Solutions or formulations comprising at least one metal complex according to one or more of Claims 1 to 15 in one or more solvents.

18. Use of a metal complex according to one or more of Claims 1 to 15 in electronic or optoelectronic devices, preferably in organic electroluminescent devices (OLEDs), organic light-emitting electrochemical cells (OLECs), organic field-effect transistors (OFETs), organic integrated circuits (O-ICs), organic thin-film transistors (TFTs), organic solar cells (O-SCs), organic laser diodes (O-laser), organic photovoltaic (OPV) elements or devices or organic photoreceptors (OPCs), more preferably in organic electroluminescent devices (OLEDs) .

19. Electronic or optoelectronic components, preferably organic electroluminescent devices (OLEDs), organic light-emitting electrochemical cells (OLECs), organic field-effect transistors (OFETs), organic integrated circuits (O-ICs), organic thin-film transistors (TFTs), organic solar cells (O-SCs), organic laser diodes (O-laser), organic photovoltaic (OPV) elements or devices and organic photoreceptors (OPCs), more preferably organic electroluminescent devices, having one or more active layers, wherein at least one of these active layers comprises one or more metal complexes according to one or more of Claims 1 to 15 or obtainable by a process 16.

## Revendications

1. Complexe métallique contenant du bismuth en tant qu'atome métallique et au moins un ligand, le ligand comprenant au moins un groupe de coordination anionique contenant au moins un atome d'oxygène et/ou d'azote, par lequel l'atome métallique est coordonné, et le ligand comprenant au moins un groupe triarylamine.

2. Complexe métallique selon la revendication 1, **caractérisé en ce qu'**au moins un groupe triarylamine comprend un élément structural de la formule (I) suivante : 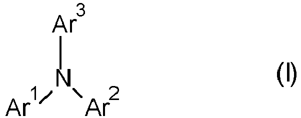 dans laquelle
Ar¹, Ar² et Ar³ représentent à chaque occurrence, à chaque fois de manière identique ou différente, un système cyclique mono- ou polycyclique, aromatique ou hétéroaromatique, qui peut être substitué avec un ou plusieurs radicaux R ;
les R représentant à chaque occurrence de manière identique ou différente H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, un groupe alkyle, alcoxy ou thioalcoxy linéaire de 1 à 40 atomes C ou un groupe alcényle ou alcynyle de 2 à 40 atomes C, ou un groupe alkyle, alcoxy oder thioalcoxy ramifié ou cyclique de 3 à 40 atomes C, qui peut à chaque fois être substitué avec un ou plusieurs radicaux R¹, un ou plusieurs groupes CH₂ non voisins pouvant être remplacés par R¹C=CR¹, C≡C, Si(R¹)2, C=O, C=S, C=NR¹, P(=O)R¹, SO, SO₂, NR¹, O, S ou CONR¹, et un ou plusieurs atomes H pouvant être remplacés par D, F, Cl, Br, I ou CN, ou un système cyclique aromatique ou hétéroaromatique de 5 à 60 atomes de cycle aromatique, qui peut à chaque fois être substitué par un ou plusieurs radicaux R¹, ou un groupe aryloxy ou hétéroaryloxy de 5 à 60 atomes de cycle aromatique, qui peut être substitué par un ou plusieurs radicaux R¹, ou un groupe aralkyle ou hétéroaralkyle de 5 à 60 atomes de cycle aromatique, qui peut être substitué par un ou plusieurs radicaux R¹, ou un groupe diarylamino, un groupe dihétéroarylamino ou un groupe arylhétéroarylamino de 10 à 40 atomes de cycle aromatique, qui peut être substitué par un ou plusieurs radicaux R¹ ; deux ou davantage de radicaux R pouvant également former les uns avec les autres un système cyclique mono- ou polycyclique, aliphatique, aromatique et/ou benzoannelé;
les R¹ représentant à chaque occurrence de manière identique ou différente H, D, F ou un radical hydrocarboné aliphatique, aromatique et/ou hétéroaromatique de 1 à 20 atomes C, dans lequel un ou plusieurs atomes H peuvent également être remplacés par F ; deux ou davantage de substituants R¹ pouvant également former les uns avec les autres un système cyclique mono- ou polycyclique, aliphatique ou aromatique ;
au moins un des radicaux Ar¹, Ar² et Ar³ étant relié par une liaison covalente avec au moins un groupe de coordination anionique.

3. Complexe métallique selon la revendication 1 ou 2, **caractérisé en ce qu'**au moins un groupe de coordination anionique du ligand comprend une structure selon la formule (K-I) : 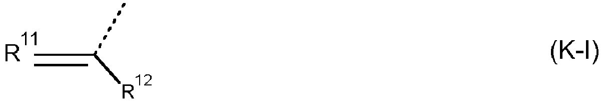 dans laquelle R¹¹ et R¹² peuvent représenter indépendamment l'un de l'autre oxygène, soufre, sélénium, NH ou NR¹³, R¹³ étant choisi dans le groupe contenant alkyle ou aryle, et pouvant être relié avec d'autres groupes du ligand, et la ligne en pointillés représente la liaison du groupe de coordination anionique au ligand.

4. Complexe métallique selon une ou plusieurs des revendications précédentes, **caractérisé en ce que** le ligand comprend au moins deux groupes de coordination anioniques éloignés dans l'espace, par lesquels les deux atomes métalliques peuvent être complexés.

5. Complexe métallique selon une ou plusieurs des revendications précédentes, **caractérisé en ce qu'**au moins un groupe de coordination anionique du ligand peut être représenté par une structure selon la formule (K-II) : 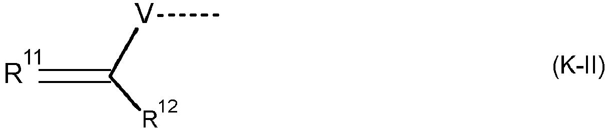 dans laquelle R¹¹ et R¹² peuvent représenter indépendamment l'un de l'autre oxygène, soufre, sélénium, NH ou NR¹³, R¹³ étant choisi dans le groupe contenant alkyle ou aryle, et pouvant être relié avec d'autres groupes du ligand, V représente une liaison ou un groupe de liaison, choisi parmi un système cyclique aromatique ou hétéroaromatique de 5 à 40 atomes de cycle aromatique, qui peut à chaque fois être substitué par un ou plusieurs radicaux R, un groupe alkylène de 1 à 40 atomes C, qui peut à chaque fois être substitué avec un ou plusieurs radicaux R, un ou plusieurs groupes CH₂ non voisins pouvant être remplacés par RC=CR, C≡C, Si(R)₂, C=O, C=S, C=NR, P(=O)R, SO, SO₂, NR, O, S ou CONR, et un ou plusieurs atomes H pouvant être remplacés par D, F, Cl, Br, I ou CN, le radical R ayant la signification indiquée pour la formule (I), notamment dans la revendication 2, et la ligne en pointillés représente la liaison du groupe de coordination anionique au groupe triarylamine.

6. Complexe métallique selon la revendication 5, **caractérisé en ce que** le radical V représente une liaison ou un groupe de liaison, choisi parmi un groupe arylène de 6 à 24 atomes C, ou un groupe hétéroarylène de 3 à 24 atomes C, qui peut à chaque fois être substitué par un ou plusieurs radicaux R¹, un groupe alkylène de 1, 2, 3, 4, 5, 6, 7, 8, 9, 10, 11 ou 12 atomes C, qui peut être substitué avec un ou plusieurs radicaux R¹, le radical R¹ ayant la signification indiquée pour la formule (I), notamment dans la revendication 2.

7. Complexe métallique selon une ou plusieurs des revendications précédentes, **caractérisé en ce que** le ligand est un composé comprenant des structures de la formule (L-I) suivante : 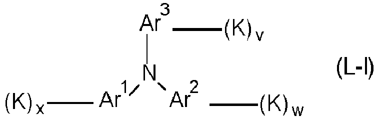 dans laquelle
Ar¹, Ar² et Ar³ ont à chaque occurrence, à chaque fois de manière identique ou différente, la signification indiquée précédemment, notamment dans la revendication 2, K représente un groupe de coordination anionique, de préférence un groupe selon la formule (K-I) et/ou (K-II),
v = 0, 1, 2, 3, 4, 5, 6 ou 7,
w = 0, 1, 2, 3, 4, 5, 6 ou 7, et
x = 0, 1, 2, 3, 4, 5, 6 ou 7,
la somme de v, w et x étant supérieure ou égale à 1, de préférence supérieure ou égale à 2.

8. Complexe métallique selon une ou plusieurs des revendications précédentes, **caractérisé en ce que** le ligand présente un poids moléculaire inférieur ou égal à 10 000 g/mol, de préférence inférieur ou égal à 5 000 g/mol, de manière particulièrement préférée inférieur ou égal à 4 000 g/mol, de manière notamment préférée inférieur ou égal à 3 000 g/mol, de manière spécialement préférée inférieur ou égal à 2 000 g/mol et de manière tout particulièrement préférée inférieur ou égal à 1 000 g/mol.

9. Complexe métallique selon une ou plusieurs des revendications précédentes, **caractérisé en ce que** le ligand est un polymère, comprenant au moins une unité structurale de la formule (P-I) suivante : 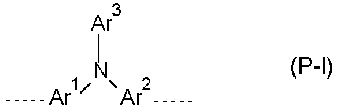 dans laquelle
Ar¹, Ar² et Ar³ ont à chaque occurrence, à chaque fois de manière identique ou différente, la signification indiquée précédemment, notamment dans la revendication 2, et
les lignes en pointillés représentent des liaisons avec des unités structurales voisines dans le polymère, les groupes Ar¹, Ar² et Ar³ dans l'unité structurale (P-I) pouvant être substitués avec au moins un groupe de coordination anionique, de préférence un groupe selon la formule (K-I) et/ou (K-II).

10. Complexe métallique selon une ou plusieurs des revendications précédentes, **caractérisé en ce que** le ligand est un polymère comprenant au moins une unité structurale de la formule (L-P-I) suivante : 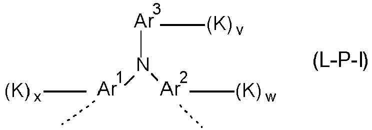
dans laquelle Ar¹, Ar² et Ar³ ont à chaque occurrence, à chaque fois de manière identique ou différente, la signification indiquée précédemment, notamment dans la revendication 2, K représente un groupe de coordination anionique, de préférence un groupe selon la formule (K-I) et/ou (K-II),
v = 0, 1, 2, 3, 4, 5, 6 ou 7,
w = 0, 1, 2, 3, 4, 5, 6 ou 7, et
x = 0, 1, 2, 3, 4, 5, 6 ou 7,
la somme de v, w et x étant supérieure ou égale à 1, de préférence supérieure ou égale à 2, et
les lignes en pointillés représentent des liaisons avec des unités structurales voisines dans le polymère.

11. Complexe métallique selon une ou plusieurs des revendications 2 à 14 précédentes, **caractérisé en ce que** le radical Ar³ selon la formule (I), (L-I), (P-I) et/ou (L-P-I) est substitué à au moins une, de préférence à exactement une des deux positions ortho, par rapport à la position de l'atome d'azote représenté dans la formule (I), (L-I), (P-I) et/ou (L-P-I), avec Ar⁴, Ar⁴ étant un système cyclique mono- ou polycyclique, aromatique ou hétéroaromatique, de 5 à 60 atomes de cycle aromatique, qui peut être substitué avec un ou plusieurs radicaux R, R pouvant avoir la signification indiquée dans la revendication 2, le radical Ar⁴ pouvant être substitué avec un ou plusieurs groupes de coordination anioniques, de préférence un groupe selon la formule (K-I) et/ou (K-II).

12. Complexe métallique selon la revendication 11, que le groupe triarylamine comprend au moins un élément structural de la formule (I), qui est choisi parmi un élément structural de la formule (Ia) suivante, ou le polymère comprend au moins une unité structurale de la formule (P-I), qui est choisie parmi une unité structurale de la formule (P-Ia) suivante, de préférence est choisie parmi une unité structurale de la formule (L-P-Ia) suivante : 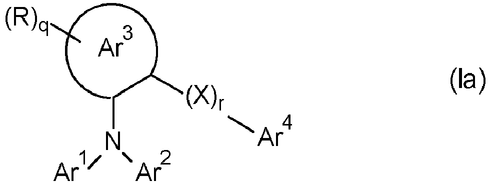 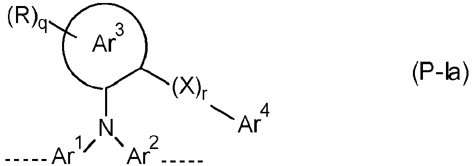 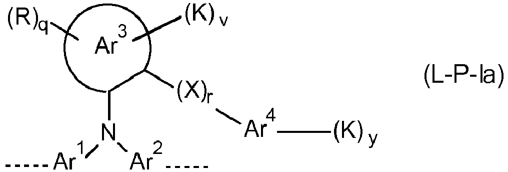
dans lesquelles Ar¹, Ar², Ar³, Ar⁴ et R peuvent avoir les significations indiquées précédemment, notamment dans la revendication 2 ou la revendication 11, K représente un groupe de coordination anionique, de préférence un groupe selon la formule (K-I) et/ou (K-II), les lignes en pointillés représentent des liaisons avec des unités structurales voisines dans le polymère,
q = 0, 1, 2, 3, 4, 5 ou 6,
X = CR₂, NR, SiR₂, NR, CK₂, NK, SiK₂, CRK, SiRK, O, S, C=O ou (P=O)R, de préférence CR₂, SiR₂, NR, CK₂, NK, SiK₂, CRK, SiRK, O ou S, R pouvant avoir la signification indiquée précédemment, notamment dans la revendication 2, et K représentant un groupe de coordination anionique, de préférence un groupe selon la formule (K-I) et/ou (K-II), et
r = 0 ou 1,
v = 0, 1, 2 ou 3,
y = 0, 1, 2 ou 3,
la somme de v et y étant supérieure ou égale à 1.

13. Complexe métallique selon au moins l'une quelconque des revendications 11 ou 12, **caractérisé en ce que** le groupe triarylamine comprend au moins un élément structural de la formule (I), qui est choisi parmi une unité structurale de la formule (Ib) suivante, ou le polymère comprend au moins une unité structurale de la formule (P-I), qui est choisie parmi une unité structurale de la formule (P-Ib) suivante, de préférence est choisie parmi une unité structurale de la formule (L-P-Ib) suivante : 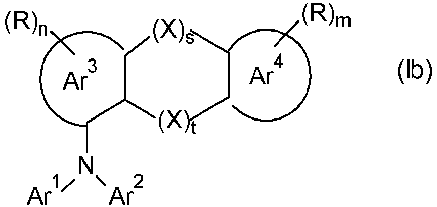 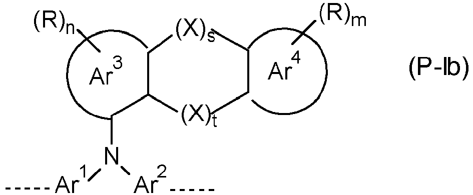 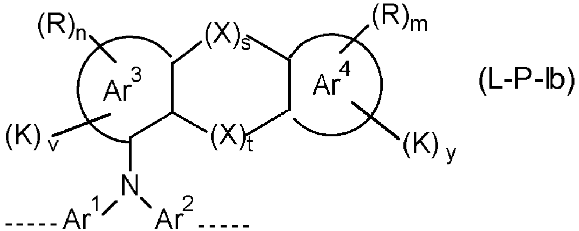
dans lesquelles Ar¹, Ar², Ar³, Ar⁴, R et X peuvent avoir les significations indiquées précédemment, notamment dans les revendications 2, 11 et 12, K représente un groupe de coordination anionique, de préférence un groupe selon la formule (K-I) et/ou (K-II), les lignes en pointillés représentent des liaisons avec des unités structurales voisines dans le polymère,
m = 0, 1, 2, 3 ou 4,
n = 0, 1, 2 ou 3,
s et t représentent chacun 0 ou 1, avec la somme (s+t) = 1 ou 2 ;
v = 0, 1, 2 ou 3,
y = 0, 1, 2 ou 3,
la somme de v et y étant supérieure ou égale à 1.

14. Complexe métallique selon une ou plusieurs des revendications 11 à 13, **caractérisé en ce que** le polymère comprend au moins une unité structurale de la formule (P-I), qui est choisie parmi une unité structurale de la formule (P-VIIIa) suivante : 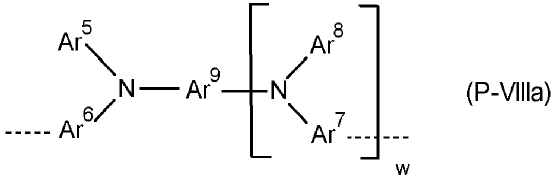 et/ou une unité structurale de la formule (P-VIIIb) suivante : 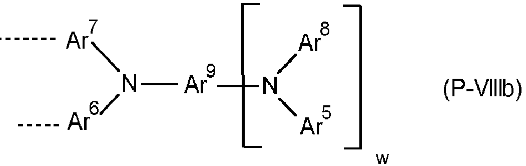
dans lesquelles z représente 1, 2 ou 3, Ar⁵ à Ar⁹ représentent à chaque occurrence, à chaque fois de manière identique ou différente, un système cyclique mono- ou polycyclique, aromatique ou hétéroaromatique, qui peut être substitué avec un ou plusieurs radicaux R, R pouvant avoir la signification indiquée précédemment, notamment dans la revendication 2 ;
les lignes en pointillés représentent des liaisons avec des unités structurales voisines dans le polymère ;
les groupes Ar¹, Ar², Ar³, Ar⁴, Ar⁵, Ar⁶, Ar⁶, Ar⁷, Ar⁸ et Ar⁹ dans les unités structurales (P-VIIIa) et/ou (P-VIIIb) pouvant être substitués avec un ou plusieurs groupes de coordination anioniques, de préférence au moins un groupe selon la formule (K-I) et/ou (K-II).

15. Complexe métallique selon une ou plusieurs des revendications 9 à 14, **caractérisé en ce que** le polymère contient en plus des unités structurales des formules (P-I), (P-Ia), (P-Ib), (L-P-I), (L-P-Ia), (L-P-Ib), (P-VIIIa) et/ou (P-VIIIb), au moins une unité structurale supplémentaire de la formule (P-XVII) suivante, qui est différente des unités structurales des formules (P-I), (P-Ia), (P-Ib), (L-P-I), (L-P-Ia) , (L-P-Ib), (P-VIIIa) et/ou (P-VIIIb) :
-----Ar¹¹----- (P-XVII)
dans laquelle Ar¹¹ est un système cyclique mono- ou polycyclique, aromatique ou hétéroaromatique, qui peut être substitué avec un ou plusieurs radicaux R et/ou K, R pouvant avoir les significations indiquées précédemment, notamment dans la revendication 2, et K représentant un groupe de coordination anionique, de préférence un groupe selon la formule (K-I) et/ou (K-II), et
les lignes en pointillés représentent des liaisons avec des unités structurales voisines dans le polymère.

16. Procédé de fabrication d'un complexe métallique selon une ou plusieurs des revendications 1 à 15, **caractérisé en ce qu'**un ligand contenant un groupe triarylamine est mis en contact avec un composé métallique qui comprend un atome de bismuth.

17. Solutions ou formulations comprenant au moins un complexe métallique selon une ou plusieurs des revendications 1 à 15 dans un ou plusieurs solvants.

18. Utilisation d'un complexe métallique selon une ou plusieurs des revendications 1 à 15 dans des dispositifs électroniques ou optoélectroniques, de préférence dans des dispositifs électroluminescents organiques (OLED), des cellules électrochimiques électroluminescentes organiques (OLEC), des transistors à effet de champ organiques (OFET), des circuits intégrés organiques (O-IC), des transistors à film mince organiques (TFT), des cellules solaires organiques (O-SC), des diodes lasers organiques (O-laser), des éléments ou des dispositifs photovoltaïques organiques (OPV), ou des photorécepteurs organiques (OPC), de manière particulièrement préférée dans des dispositifs électroluminescents organiques (OLED).

19. Composants électroniques ou optoélectroniques, de préférence dispositifs électroluminescents organiques (OLED), cellules électrochimiques électroluminescentes organiques (OLEC), transistors à effet de champ organiques (OFET), circuits intégrés organiques (O-IC), transistors à film mince organiques (TFT), cellules solaires organiques (O-SC), diodes lasers organiques (O-laser), éléments ou dispositifs photovoltaïques organiques (OPV), et photorécepteurs organiques (OPC), de manière particulièrement préférée dispositifs électroluminescents organiques, comprenant une ou plusieurs couches actives, au moins une de ces couches actives contenant un ou plusieurs complexes métalliques selon une ou plusieurs des revendications 1 à 15 ou pouvant être obtenus par un procédé.
